# EUROPEAN PATENT APPLICATION

(11) **EP 4 757 069 A1**
(43) Date of publication of application: **10.06.2026**
(21) Application number: 24877564.5
(22) Date of filing: 11.10.2024
(51) Int. Cl.: H01Q 1/24, H01Q 13/10, H01Q 5/307, H01Q 21/10, H05K 1/02, H04M 1/02

(54) **ELECTRONIC DEVICE INCLUDING ANTENNA**

(30) Priority: 12.10.2023 KR 20230135975; 23.01.2024 KR 20240010353
(71) Applicant: Samsung Electronics Co., Ltd., Suwon-si, Gyeonggi-do 16677 (KR)
(72) Inventor: JO, Jaehoon, Suwon-si, Gyeonggi-do 16677 (KR); NAM, Hojung, Suwon-si, Gyeonggi-do 16677 (KR); PARK, Sungkoo, Suwon-si, Gyeonggi-do 16677 (KR); LEE, Kyungjae, Suwon-si, Gyeonggi-do 16677 (KR); LEE, Kookjoo, Suwon-si, Gyeonggi-do 16677 (KR); HWANG, Soonho, Suwon-si, Gyeonggi-do 16677 (KR)
(74) Representative: Gulde & Partner
(86) International application number: PCT/KR2024/015429
(87) International publication number: WO 2025/080029

(57) **Abstract**

A foldable electronic device is provided according to various embodiments of the disclosure. The foldable electronic device includes a first housing including a first rear cover and a first bracket, a second housing including a second rear cover and a second bracket, a hinge module rotatably interconnecting the first housing and the second housing, a hinge cover coupled to the hinge module, and a wireless communication circuit. A first slot is formed in a conductive area of the first bracket. In a direction orthogonal to the first rear cover, at least a portion of the first slot overlaps the hinge cover in an unfolded state of the foldable electronic device. The wireless communication circuit is configured to transmit and/or receive a signal of a predetermined frequency band through the first slot formed in the conductive area of the first bracket.

## Description

### [Technical Field]

The disclosure relates to an electronic device including an antenna.

### [Background Art]

Electronic devices include multiple antennas to support various communication technologies.

The above-mentioned information may be provided as related art for the purpose of aiding the understanding of the disclosure. No claim or determination is made as to whether any of the foregoing may be applied as prior art with respect to the disclosure.

### [Disclosure of Invention]

### [Technical Problem]

As the range of available applications expands, the number of antennas included in electronic devices is increasing. While electronic devices are becoming slimmer, components for various functions are being added. Therefore, it is becoming difficult to implement an antenna in a limited space while reducing the electromagnetic effects with various elements within an electronic device and securing coverage (or communication range) and radiation performance for a desired frequency band. In the case of a transformable electronic device such as a foldable electronic device, antenna design may be limited due to its transformable nature.

Various embodiments of the disclosure provide an electronic device including an antenna for securing or improving coverage and/or antenna radiation performance while reducing limitations caused by the transformable nature of the electronic device. Various embodiments of the disclosure are provided to solve or at least alleviate the above-mentioned problems.

The technical problems to be addressed by the disclosure are not limited to those described above, and other technical problems, which are not described above, will be understood by a person ordinarily skilled in the related art to which the disclosure belongs.

### [Solution to Problem]

A foldable electronic device is provided according to an exemplary embodiment of the disclosure. The foldable electronic device includes a first housing, a second housing, a hinge module rotatably interconnecting the first housing and the second housing, a hinge cover coupled to the hinge module, and a wireless communication circuit. The first housing includes a first rear cover and a first bracket. The second housing includes a second rear cover and a second bracket. A first slot is formed in the conductive area of the first bracket. In a direction orthogonal to the first rear cover, at least a portion of the first slot overlaps the hinge cover in the unfolded state of the foldable electronic device. The wireless communication circuit is configured to transmit, receive or transmit and receive a signal of a predetermined frequency band through the first slot formed in the conductive area of the first bracket.

### [Advantageous Effects of Invention]

Provided is an electronic device including an antenna which may secure coverage and/or antenna radiation performance while reducing constraints on antenna design.

In addition, effects that may be obtained or predicted by various embodiments of the disclosure will be directly or implicitly disclosed in the detailed description of the embodiments of the disclosure.

### [Brief Description of Drawings]

The above and other aspects, features, and advantages of specific embodiments of the disclosure will become more apparent from the following detailed description taken in conjunction with the accompanying drawings.
FIG. 1 shows a block diagram of an electronic device according to various embodiments of the disclosure in a network environment.
FIG. 2 shows a view illustrating appearances of the foldable electronic device according to various embodiments of the disclosure in an unfolded state.
FIG. 3 shows a view illustrating appearances of the foldable electronic device according to various embodiments of the disclosure in a folded state.
FIG. 4 shows a cross-sectional view of the foldable electronic device according to various embodiments of the disclosure taken along line D-D' in FIG. 2.
FIG. 5 shows an exploded view of a portion of the foldable electronic device according to various embodiments of the disclosure in the unfolded state.
FIG. 6 shows a view illustrating a portion of the foldable electronic device according to various embodiments of the disclosure in the unfolded state.
FIG. 7 shows a view illustrating a portion of the foldable electronic device according to various embodiments of the disclosure in the unfolded state.
FIG. 8 shows a cross-sectional view of a portion of the foldable electronic device according to various embodiments of the disclosure in the unfolded state taken along line E-E' in FIG. 7.
FIG. 9 shows a cross-sectional view of a portion of the foldable electronic device according to various embodiments of the disclosure in the unfolded state taken along line F-F' in FIG. 7.
FIG. 10 shows a cross-sectional view of a portion of the foldable electronic device in the folded state in relation to FIG. 8 according to various embodiments of the disclosure.
FIG. 11 shows an exploded perspective view of a portion of a foldable electronic device according to various embodiments of the disclosure.
FIG. 12 shows a perspective view of a portion of the foldable electronic device according to various embodiments of the disclosure.
FIG. 13 shows a view illustrating a portion of a foldable electronic device according to various embodiments of the disclosure and a cross-section of the portion of the foldable electronic device taken along the line H-H'.
FIG. 14 show views each illustrating a conductive area including an opening according to various embodiments of the disclosure.
FIG. 15 shows diagrams each illustrating the electromagnetic influence of a surrounding conductive member on a slot radiator according to various embodiments of the disclosure.
FIG. 16 shows graphs each illustrating a frequency characteristic depending on a separation distance between a slot radiator and a surrounding conductive member according to various embodiments of the disclosure.
FIG. 17 shows a perspective view of a portion of the foldable electronic device according to various embodiments of the disclosure.
FIG. 18 shows graphs and radiation patterns each showing a frequency characteristic of a slot radiator when a foldable electronic device of a comparative example, in which a third matching electrical path, a third matching circuit, and a fourth electrical path in FIG. 17 are omitted, is in the unfolded state or the folded state.
FIG. 19 shows graphs each illustrating a frequency characteristic of a slot radiator according to the time constants of the third matching circuit of FIG. 17, according to various embodiments of the disclosure.
FIG. 20 shows a view illustrating a portion of a foldable electronic device according to various embodiments of the disclosure.
FIG. 21 shows a perspective view of a portion of the foldable electronic device according to various embodiments of the disclosure.
FIG. 22 shows a view of a portion of the foldable electronic device according to various embodiments of the disclosure.
FIG. 23 shows a cross-sectional view of a portion of a foldable electronic device according to various embodiments of the disclosure.
FIG. 24 shows a cross-sectional view of a portion of a foldable electronic device according to various embodiments of the disclosure.
FIG. 25 shows a cross-sectional view of a portion of a foldable electronic device according to various embodiments of the disclosure.
FIG. 26 shows a perspective view of a portion of a foldable electronic device according to various embodiments of the disclosure.
FIG. 27 shows a perspective view of a portion of a foldable electronic device according to various embodiments of the disclosure.
FIG. 28 shows a view illustrating a slot antenna according to various embodiments of the disclosure.
FIG. 29 shows graphs illustrating the reflection losses of the slot antenna of FIG. 28 when the switching circuit is controlled depending on whether the foldable electronic device according to various embodiments of the disclosure is in the unfolded state or the folded state.
FIG. 30 shows graphs illustrating gains of the slot antenna of FIG. 28 when the switching circuit is controlled depending on whether the foldable electronic device according to various embodiments of the disclosure is in the unfolded state or the folded state.
FIG. 31 shows views illustrating conductive areas according to various embodiments of the disclosure.
FIG. 32 shows views illustrating conductive areas according to various embodiments of the disclosure.
FIG. 33 shows an exploded perspective view of a portion of a foldable electronic device according to various embodiments of the disclosure.
FIG. 34 shows views illustrating the appearances of a slidable electronic device according to various embodiments of the disclosure in the closed state.
FIG. 35 shows views illustrating the appearances of the slidable electronic device according to various embodiments of the disclosure in the open state.
FIG. 36 shows an exploded perspective view of the slidable electronic device according to various embodiments of the disclosure.
FIG. 37 shows an exploded perspective view of the slidable electronic device according to various embodiments of the disclosure.
FIG. 38 shows a cross-sectional view of a portion of a slidable electronic device according to various embodiments of the disclosure taken along line K-K' in FIG. 34.
FIG. 39 shows a cross-sectional view of a portion of the slidable electronic device according to various embodiments of the disclosure taken along line L-L' in FIG. 35.

### [Mode for the Invention]

Hereinafter, various example embodiments of the disclosure disclosed herein will be described in greater detail with reference to the accompanying drawings.

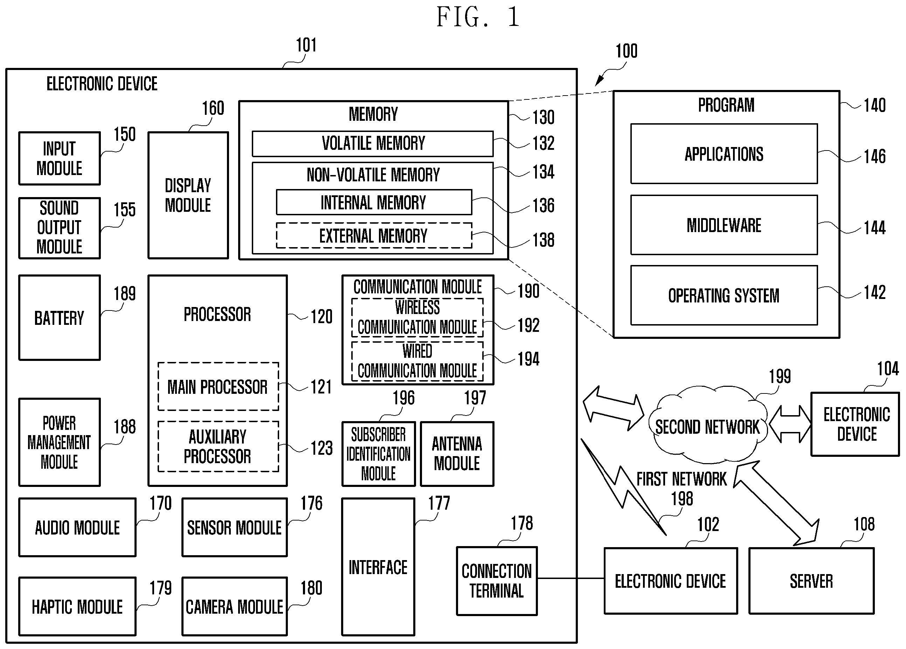

FIG. 1 is a block diagram of an electronic device 101 in a network environment 100 according to various embodiments of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In various embodiments of the disclosure, at least one (e.g., the connection terminal 178) of the components may be omitted from the electronic device 101, or one or more other components may be added in the electronic device 101. In various embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to various embodiments of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support highspeed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to various embodiments of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to various embodiments of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to various embodiments of the disclosure, the external electronic device 104 or the server 108 may be included in the second network 199. The electronic device 101 may be applied to an intelligent service (e.g., smart home, smart city, smart car, or healthcare) based on 5G communication technology or loT-related technology.

An electronic device according to various embodiments of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

The term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to various embodiments of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORETM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

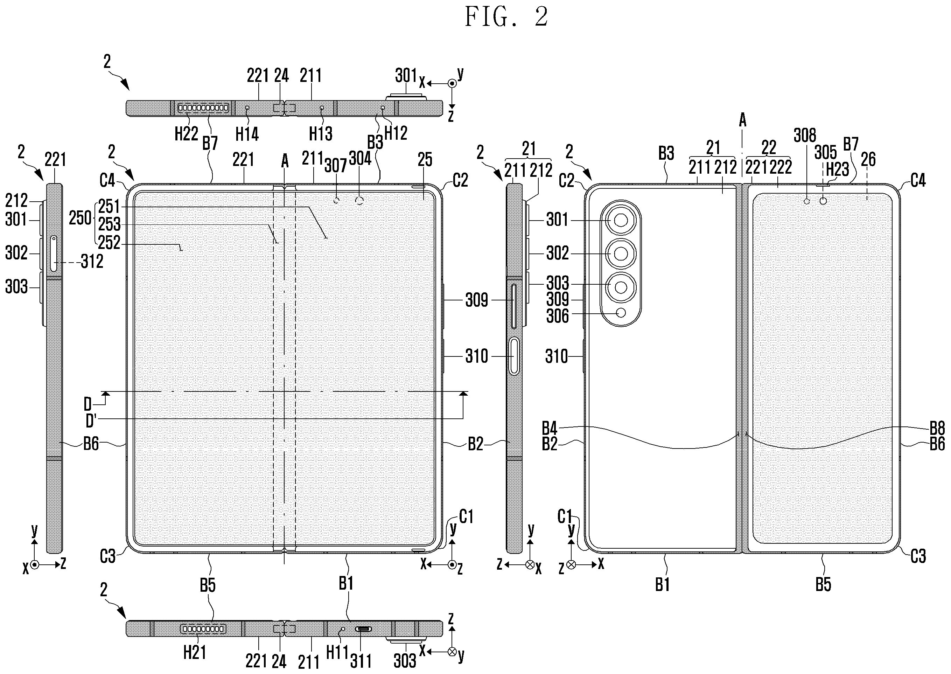

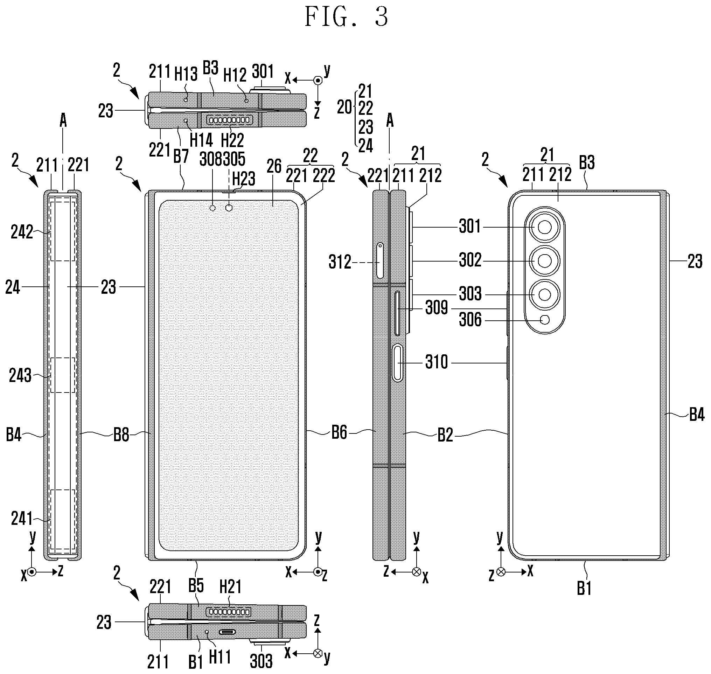

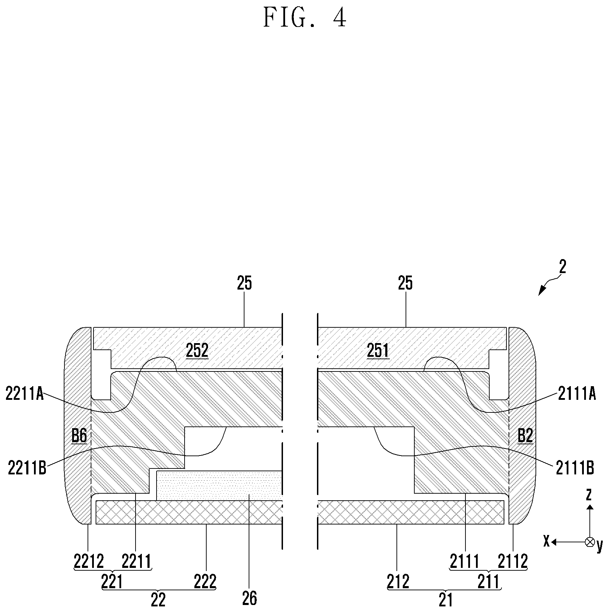

FIG. 2 shows a view illustrating appearances of the foldable electronic device 2 in an unfolded state (also referred to as an unfolding state or a flat state) according to various embodiments of the disclosure. FIG. 3 shows a view illustrating appearances of the foldable electronic device 2 according to various embodiments of the disclosure in a folded state (also referred to as a folding state). FIG. 4 shows a cross-sectional view of the foldable electronic device 2 according to various embodiments of the disclosure taken along line D-D' in FIG. 2.

Referring to FIGS. 2, 3, and 4, the foldable electronic device 2 may include a foldable housing 20, a first display module 25, a second display module 26, a first camera module 301, a second camera module 302, a third camera module 303, a fourth camera module 304, a fifth camera module 305, a light-emitting module 306, a sensor module 307, a first sound input module, a second sound input module, a third sound input module, a fourth sound input module, a first sound output module, a second sound output module, a third sound output module, a key input module, a first connection terminal 311, and/or a second connection terminal 312.

According to various embodiments, the unfolded state and the folded state of the foldable electronic device 2 may be substantially provided by the foldable housing 20. The "unfolded state of the foldable electronic device 2" and the "unfolded state of the foldable housing 20" described herein may be interpreted as being substantially the same. The "folded state of the foldable electronic device 2" and the "folded state of the foldable housing 20" described herein may be interpreted as being substantially the same.

According to various embodiments, the foldable housing 20 may include a first housing (also referred to as a first housing portion or a first housing structure) 21, a second housing (also referred to as a second housing portion or a second housing structure) 22, a hinge housing 23, and/or a hinge module 24. The first housing 21 and the second housing 22 may be connected to each other via the hinge module 24. The first housing 21 and the second housing 22 may be mutually rotatable with respect to the hinge module 24. The hinge module (also referred to as a hinge unit or hinge assembly) 24 may include, for example, one or more hinges (e.g., a first hinge 241, a second hinge 242, and/or a third hinge 243).

According to various embodiments, a first display module (also referred to as a first display) 25 may be disposed in the foldable housing 20. The first display module 25 may include, for example, a flexible display module (also referred to as a flexible display) or a foldable display module (also referred to as a foldable display) that is transformable in response to the switching of the foldable electronic device 2 between the unfolded state and the folded state.

According to various embodiments, the first display module 25 may include a display area 250. The display area 250 may include an active area or a screen area that is capable of displaying an image based on electrical signals. The display area 250 may include a first display area 251 corresponding to the first housing 21, a second display area 252 corresponding to the second housing 22, and a third display area 253 corresponding to the hinge module 24. The third display area 253 may extend the first display area 251 and the second display area 252.

According to various embodiments, the first display area 251 may be disposed on the first housing 21. The shape of the first display area 251 may be maintained by the support of the first housing 21. For example, the first display area 251 may be provided (or formed) substantially flat by being supported by the first housing 21.

According to various embodiments, the second display area 252 may be disposed on the second housing 22. The shape of the second display area 252 may be maintained by the support of the second housing 22. For example, the second display area 252 may be provided (or formed) substantially flat by being supported by the second housing 22.

According to various embodiments, the third display area 253 may be located corresponding to the hinge module 24. When the foldable electronic device 2 is switched between the unfolded state and the folded state, the third display area 253 may be transformed corresponding to the relative position between the first display area 251 and the second display area 252. In the unfolded state of the foldable electronic device 2, the third display area 253 may be disposed substantially flat. In the folded state of the foldable electronic device 2, the third display area 253 may be disposed in a bent form. The unfolded state of the foldable electronic device 2 may be defined or interpreted as the state in which the third display area 253 is laid flat. The folded state of the foldable electronic device 2 may be defined or interpreted as the state in which the third display area 253 is disposed in a bent form.

According to various embodiments, in the unfolded state of the foldable electronic device 2, the first display area 251 and the second display area 252 may form an angle of about 180 degrees therebetween, and the display area 250 may be provided (or disposed) in a substantially planar form. In the unfolded state of the foldable electronic device 2, due to the relative position between the first display area 251 disposed on the first housing 21 and the second display area 252 disposed on the second housing 22, the third display area 253 may be laid flat. In the unfolded state of the foldable electronic device 2, the third display area 253 may be pulled from opposite sides by the first display area 251 and the second display area 252, and the pulling force may be provided to reduce damage to the third display area 253 while allowing the third display area 253 to be laid flat. In the unfolded state of the foldable electronic device 2, the third display area 253 may be provided (formed) with an extended width that may be pulled by the first display area 251 and the second display area 252 and arranged flat while reducing stress.

According to various embodiments, in the unfolded state of the foldable electronic device 2, the hinge module 24 may support the third display area 253 of the first display module 25 to be substantially flat. For example, in the unfolded state of the foldable electronic device 2, the hinge module 24 may support the third display area 253 such that the third display area 253 may be laid flat without sagging or with reduced sagging, thereby reducing a crease phenomenon.

According to various embodiments, when an external force (e.g., an external pressure such as a touch input using a user's finger or a touch input using an electronic pen) is applied to the third display area 253 in the unfolded state of the foldable electronic device 2, the hinge module 24 may support the third display area 253 to be maintained flat by reducing sagging of the third display area 253.

According to various embodiments, when an external impact, such as due to a drop, is applied to the foldable electronic device 2 in the unfolded state, the hinge module 24 may be configured to reduce or absorb the external impact to reduce the effect of the external impact on the third display area 253.

According to various embodiments, the display area 250 of the first display module 25 may substantially provide (or form) the front surface in the exterior of the foldable electronic device 2. The front surface of the foldable electronic device 2 may include a first front surface area provided (or formed) by the first display area 251, a second front surface area provided (or formed) by the second display area 252, and a third front surface area provided (or formed) by the third display area 253. The illustrated coordinate axes of the foldable electronic device 2 are indicated, for example, with reference to the first housing 21, and the +z-axis direction may be defined or interpreted as a direction where the substantially flat first front surface area is oriented. For example, the first front area provided (or formed) by the first display area 251 may be substantially parallel to the x-y plane. In the unfolded state of the foldable electronic device 2, the front surface of the foldable electronic device 2 may be provided (or formed) as a substantially flat surface.

According to various embodiments, the foldable electronic device 2 may be implemented in an infolding type in which the display area 250 of the first display module 25 (or the front surface of the foldable electronic device 2 where the display area 250 is visually visible) is foldable inward. FIG. 3 illustrates the fully folded state of the foldable electronic device 2 in which the first housing 21 and the second housing 22 are disposed such that they cannot come closer to each other anymore. When the foldable electronic device 2 is in the fully folded state, the first display area 251 and the second display area 252 (or the first front surface area and the second front surface area) may face each other. For example, in the fully folded state of the foldable electronic device 2, the angle between the first housing 21 and the second housing 22 (or the angle between the first display area 251 and the second display area 252 or the angle between the first front surface area and the second front surface area) may range from about 0 degrees to about 10 degrees. In the fully folded state of the foldable electronic device 2, the display area 250 may be substantially invisible.

The foldable electronic device 2 may be placed in an intermediate state between the unfolded state and the fully folded state. For example, in the intermediate state of the foldable electronic device 2 where the angle between the first housing 21 and the second housing 22 is greater than or equal to a certain angle, the foldable electronic device 2 may be configured to provide a use environment in which the display area 250 can be used by a user.

Hereinafter, the "folded state of the foldable electronic device 2" of the disclosure may refer to the fully folded state as opposed to the intermediate state.

According to various embodiments, when viewing the foldable electronic device 2 in the unfolded state, the display area 250 of the first display module 25 may be provided (or formed) in a symmetrical shape with respect to a center line A of the foldable electronic device 2. The center line A of the foldable electronic device 2 may correspond to the center of the width of the third display area 253 extending from a first boundary between the first display area 251 and the third display area 253 to a second boundary between the second display area 251 and the third display area 253 when the foldable electronic device 2 is viewed in the unfolded state. For example, the illustrated +x coordinate axis may be substantially perpendicular to the center line A, and the illustrated +y coordinate axis may be substantially parallel to the center line A.

According to various embodiments, the center line A of the foldable electronic device 2 may be defined or interpreted as the "folding axis" of the foldable housing 20 or the foldable electronic device 2. The folding axis may be substantially provided (or formed) by the hinge module 24.

According to various embodiments, in the folded state of the foldable electronic device 2, the third display area 253 disposed in the bent shape may be provided in a substantially symmetrical shape with respect to the center line A of the foldable electronic device 2.

According to various embodiments, when viewing the foldable electronic device 2 in the unfolded state, the display area 250 of the first display module 25 may have a substantially rectangular shape.

According to various embodiments, the first housing 21 may include a first frame (also referred to as a first frame structure or a first framework) 211, and a first cover (also referred to as a first back cover or a first rear surface plate) 212 disposed on (or coupled to) the first frame 211. The combination of the first frame 211 and the first cover 212 may provide (or form) a first rear surface area and a first side surface area of the exterior of the foldable electronic device 2. The first frame 211 may provide (or form) at least a portion of a first side surface area of the foldable electronic device 2. The first cover 212 may provide (or form) at least a portion of the first rear surface area of the foldable electronic device 2. The first rear surface area may be oriented in a direction opposite to the first front surface area of the foldable electronic device 2 provided (or formed) by the first display area 251 of the first display module 25.

According to various embodiments, the first frame 211 may include a first side member (also referred to as a first side surface member, a first side surface structure, or a first side surface bezel structure) 2112. The first side member 2112 may surround at least a portion of the space between the first display area 251 and the first cover 212, and may provide (or form) at least a portion of the first side surface area of the exterior of the foldable electronic device 2.

According to various embodiments, the first frame 211 may include a first bracket (also referred to as a first support plate, a first support member, a first support structure, or a first support portion) 2111 extending from (or connected to) the first side member 2112. The first bracket 2111 may be a structural element located inside the foldable electronic device 2 to correspond to the first housing 21.

According to various embodiments, the first frame 211 may be provided (formed) as an integrated or single structure (e.g., a single continuous structure or complete structure) including the first bracket 2111 and the first side member 2112.

According to various embodiments, the first frame 211 may be provided as a combination of a conductor (or a metal body) including one or more conductive portions and a non-conductor (or a non-metal body) including one or more non-conductive portions.

According to various embodiments, the first bracket 2111 may be at least partially located between the first display area 251 and the first cover 212. The first display area 251 may be disposed on the first bracket 2111, and the first bracket 2111 may support the first display area 251.

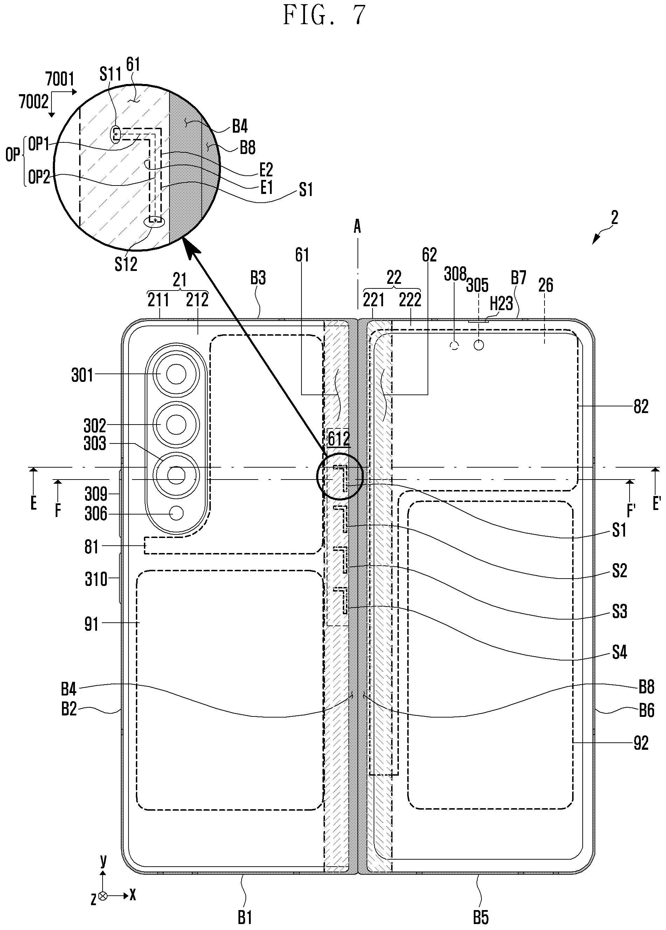

According to various embodiments, various electrical components, such as a first printed circuit board (e.g., the first printed circuit board 81 in FIG. 7) or a first battery (e.g., the first battery 91 in FIG. 7), may be at least partially disposed on the first bracket 2111 of the first frame 211 between the first frame 211 and the first cover 212.

According to various embodiments, electrical components (or electronic components) or various members associated to the electrical components may be disposed on the first frame 211 or the first bracket 2111 or may be supported by the first frame 211 or the first bracket 2111. The first bracket 2111 may include, for example, a first support surface 2111A and a third support surface 2111B. The first support surface 2111A may be substantially face the first display area 251 of the first display module 25. The third support surface 2111B may be located on opposite side of the first support surface 2111A. The third support surface 2111B may substantially face the first cover 212. The electrical components (or electronic components) or various members associated with the electrical components may be disposed on the first support surface 2111A and/or the third support surface 2111B or may be supported by the first support surface 2111A and/or the third support surface 2111B.

According to various embodiments, the second housing 22 may include a second frame (also referred to as a second frame structure or a second framework) 221, and/or a second cover (also referred to as a second back cover or a second rear surface plate) 222 disposed on the first frame 221. The combination of the second frame 221 and the second cover 222 may provide (or form) the second rear surface area and the second side surface area in the exterior of the foldable electronic device 2. The second frame 221 may provide (or form) at least a portion of the second side surface area of the foldable electronic device 2. The second cover 222 may provide (or form) at least a portion of the second rear surface area of the foldable electronic device 2. The second rear surface area may face away from the second front surface area of the foldable electronic device 2 provided (or formed) by the second display area 252.

According to various embodiments, the second frame 221 may include a second side member (also referred to as a second side surface member, a second side surface structure, or a second side surface bezel structure) 2212. The second side member 2212 may surround at least a portion of the space between the second display area 252 and the second cover 222, and may provide (or form) at least a portion of the second side surface area of the exterior of the foldable electronic device 2.

According to various embodiments, the second frame 221 may include a second bracket (also referred to as a second support plate, a second support member, a second structure, or a second support portion) 2211 extending from (or connected to) the second side member 2212. The second bracket 2211 may be a structural element located inside the foldable electronic device 2 to correspond to the second housing 22.

According to various embodiments, the second frame 221 may be provided (formed) as an integrated or single structure (e.g., a single continuous structure or complete structure) including the second bracket 2211 and the second side member 2212.

According to various embodiments, the second frame 221 may be provided as a combination of a conductor (or a metal body) including one or more conductive portions and a non-conductor (or a non-metal body) including one or more non-conductive portions.

According to various embodiments, the second bracket 2211 may be at least partially located between the second display area 252 and the second cover 222. The second display area 252 may be disposed on the second bracket 2211, and the second bracket 2211 may support the second display area 252.

According to various embodiments, various electrical components, such as a second printed circuit board (e.g., the second printed circuit board 82 in FIG. 7) or a second battery (e.g., the second battery 92 in FIG. 7), may be at least partially disposed on the second bracket 2211 of the second frame 221 between the second frame 221 and the second cover 222.

According to various embodiments, the electrical components (or electronic components) or various members associated to the electrical components may be disposed on the second frame 221 or the second bracket 2211 or may be supported by the second frame 221 or the second bracket 2211. The second bracket 2211 may include, for example, a second support surface 2211A and a fourth support surface 2211B. The second support surface 2211A may be substantially face the second display area 252 of the first display module 25. The fourth support surface 2211B may be located on opposite side of the second support surface 2211A. The fourth support surface 2211B may substantially face the second cover 222. The electrical components (or electronic components) or various members associated with the electrical components may be disposed on the second support surface 2211A and/or the fourth support surface 2211B or may be supported by the second support surface 2211A and/or the fourth support surface 2211B.

According to various embodiments, the first side member 2112 of the first frame 211 may include a first side surface portion B1, a second side surface portion B2, a third side surface portion B3, and/or a fourth side surface portion B4. The first side surface portion B1 may extend in a direction perpendicular to the center line A of the foldable electronic device 2. The third side surface portion B3 may be spaced apart from the first side surface portion B1 in the direction of the center line A of the foldable electronic device 2 (e.g., the y-axis direction) and may be substantially parallel to the first side surface portion B1. The second side surface portion B2 may extend or interconnect one end of the first side surface portion B1 and one end of the third side surface portion B3. The fourth side surface portion B4 may extend or interconnect the other end of the first side surface portion B1 and the other end of the third side surface portion B3. The second side surface portion B2 and the fourth side surface portion B4 may be substantially parallel to each other. The fourth side surface portion B4 may be located closer to the center line A of the foldable electronic device 2 than the second side surface portion B2.

According to various embodiments, a first corner C1 where the first side surface area B1 and the second side surface area B2 are extended or connected, and/or a second corner C2 where the second side surface portion B2 and the third side surface portion B3 are extended or connected may be provided (or formed) in a smooth curved shape.

According to various embodiments, when viewed from above the first cover 212, the first side surface portion B1, the second side surface portion B2, the third side surface portion B3, and the fourth side surface portion B4 may surround the first cover 112.

According to various embodiments, the second side member 2212 of the second frame 221 may include a fifth side surface portion B5, a sixth side surface portion B6, a seventh side surface portion B7, and/or an eighth side surface portion B8. The fifth side surface portion B5 may extend in a direction perpendicular to the center line A of the foldable electronic device 2. The seventh side surface portion B7 may be spaced apart from the fifth side surface portion B5 in the direction of the center line A of the foldable electronic device 2, and may be substantially parallel to the fifth side surface portion B5. The sixth side surface portion B6 may extend or interconnect one end of the fifth side surface portion B5 and one end of the seventh side surface portion B7. The eighth side surface portion B8 may extend or interconnect the other end of the fifth side surface portion B5 and the other end of the seventh side surface portion B7. The sixth side surface portion B6 and the eighth side surface portion B8 may be substantially parallel to each other. The eight side surface portion B8 may be located closer to the center line A of the foldable electronic device 2 than the sixth side surface portion B6.

According to various embodiments, a third corner C3 where the fifth side surface area B5 and the sixth side surface area B6 are extended or connected, and/or a fourth corner C4 where the sixth side surface portion B6 and the seventh side surface portion B7 are extended or connected may be provided (or formed) in a smooth curved shape.

According to various embodiments, when viewed from above the second cover 222, the fifth side surface portion B5, the sixth side surface portion B6, the seventh side surface portion B7, and the eighth side surface portion B8 may surround the second cover 222.

According to various embodiments, in the folded state of the foldable electronic device 2, the first side member 2112 of the first frame 211 and the second side member 2212 of the second frame 221 may be aligned with and overlap each other. In the folded state of the foldable electronic device 2, the first side surface portion B1 and the fifth side surface portion B5 may be aligned with and overlap each other. In the folded state of the foldable electronic device 2, the second side surface portion B2 and the sixth side surface portion B6 may be aligned with and overlap each other. In the folded state of the foldable electronic device 2, the third side surface portion B3 and the seventh side surface portion B7 may be aligned with and overlap each other.

According to various embodiments, the first side surface portion B1, the second side surface portion B2, and the third side surface portion B3 may be one side bezel (or a first screen bezel) surrounding one side area of the first display module 25 with respect to the center line A of the foldable electronic device 2. The fifth side surface portion B5, the sixth side surface portion B6, and the seventh side surface portion B7 may be the other side bezel (or a second screen bezel) surrounding the other side area of the first display module 25 with respect to the center line A of the foldable electronic device 2.

According to various embodiments, the fourth side surface portion B4 and the eighth side surface portion B8 may be located on the opposite side of the third display area 253. When viewed from above the front surface of the foldable electronic device 2 in the unfolded state, the fourth side surface portion B4 and the eighth side surface portion B8 may be invisible.

According to various embodiments, the hinge housing (also referred to as a hinge cover) 23 may include one or more hinges (e.g., a first hinge 241, a second hinge 242, and a third hinge 243) included in the hinge module 24.

According to various embodiments, when the foldable electronic device 2 is switched from the unfolded state to the folded state, a gap between the first frame 211 and the second frame 221 may open on the opposite side of the third display area 253 due to a change in the relative position between the first frame 211 and the second frame 221 connected via the hinge module 24 and a change in the state of the hinge module 24 coupled with the hinge housing 23. The hinge housing 23 may be exposed to the outside through the open gap. For example, in the folded state of the foldable electronic device 2, the hinge housing 23 may be exposed to the outside through the open gap between the fourth side surface portion B4 of the first frame 211 and the eighth side surface portion B8 of the second frame 221. The width of the gap between the fourth side surface portion B4 of the first frame 211 and the eighth side surface portion B8 of the second frame 221 may vary depending on the angle between the first frame 211 and the second frame 221. The hinge housing 23 may be exposed to the outside to a greater extent in the folded state of the foldable electronic device 2 than in the intermediate state of the foldable electronic device 2. In the folded state of the foldable electronic device 2, the hinge housing 23 may be a portion of the exterior that covers the interior of the foldable electronic device 2. In the folded state of the foldable electronic device 2, the side surface of the foldable electronic device 2 may include a first side surface area provided by the first side member 2112 of the first frame 211, a second side surface area provided by the second side member 2212 of the second frame 221, and a third side surface area provided by the hinge housing 23.

According to various embodiments, when the foldable electronic device 2 is switched from the folded state to the unfolded state, the gap between the first frame 211 and the second frame 221 may be closed on the opposite side of the third display area 253 due to a change in the relative position between the first frame 211 and the second frame 221 connected via the hinge module 24 and a change in the state of the hinge module 24 coupled with the hinge housing 23. For example, in the unfolded state of the foldable electronic device 2, the gap between the fourth side surface portion B4 of the first frame 211 and the eighth side surface portion B8 of the second frame 221 may be closed, and the hinge housing 23 may not be exposed to the outside.

According to various embodiments, the second display module 26 (also referred to as a second display) may be located between the second cover 222 and the second bracket 2211 of the second frame 221. The second display module 26 may be disposed on or coupled to the second cover 222 and/or the second bracket 2211. The display area of the second display module 26 may be visually visible through the second cover 222.

According to various embodiments, the foldable electronic device 2 may be configured to display an image through the second display module 26 instead of the first display module 25, in the folded state.

According to various embodiments, the first camera module 301, the second camera module 302, the third camera module 303, the fourth camera module 304, and/or the fifth camera module 305 may include at least one lens, image sensor, and/or image signal processor (ISP).

According to various embodiments, the first camera module 301, the second camera module 302, and the third camera module 303 may be accommodated in the first housing 21 to correspond to the first cover 212 (or the first rear surface area of the foldable electronic device 2). For example, the first cover 212 may include a first camera hole (or a first light transmission area) corresponding to the first camera module 301, a second camera hole (or a second light transmission area) corresponding to the second camera module 302, and/or a third camera hole (or a third light transmission area) corresponding to the third camera module 303. The positions or number of camera modules accommodated in the first housing 21 to correspond to the first cover 212 may vary without being limited to the illustrated example.

According to various embodiments, the first camera module 301 (also referred to as a first camera, a first rear camera module, or a first rear camera), the second camera module 302 (also referred to as a second camera, a second rear camera module, or a second rear camera), or the third camera module 303 (also referred to as a third camera, a third rear camera module, or a third rear camera) may include a wide-angle camera module, a telephoto camera module, a color camera module, a black- and-white camera module, or an IR camera (e.g., a time of flight (TOF) camera or a structured light camera) module.

According to various embodiments, the first camera module 301, the second camera module 302, and the third camera module 303 may have different properties (e.g., angles of view) or functions.

According to various embodiments, the first camera module 301, the second camera module 302, or the third camera module 303 may provide different angles of view (or lenses with different angles of view). The foldable electronic device 2 may selectively use the angle of view of the first camera module 301, the second camera module 302, or the third camera module 303 based on a user's selection regarding the angle of view.

According to various embodiments, the fourth camera module 304 may be accommodated in the first housing 21 to correspond to the first front surface area of the foldable electronic device 2.

According to various embodiments, the fourth camera module 304 (also referred to as a fourth camera, a first front camera module, or a first front camera) may overlap the first display area 251 of the first display module 25 when viewed from above the first front surface area of the foldable electronic device 2. The fourth camera module 304 may be located on the rear surface of the first display area 251 or below the first display area 251. When viewed from the outside of the foldable electronic device 2, the fourth camera module 304 or the position of the fourth camera module 304 may not be substantially visually distinguished (or exposed). The fourth camera module 304 may include, for example, a hidden behind-display camera (e.g., an under-display camera (UDC)). External light may pass through the first display module 25 and reach the fourth camera module 304.

According to various embodiments, the fourth camera module 304 may be accommodated in the second housing 22 to correspond to the second front surface area of the foldable electronic device 2.

According to various embodiments, an additional camera module may be accommodated in the second housing 22 to correspond to the second front surface area of the foldable electronic device 2.

According to various embodiments, the fifth camera module 305 may be accommodated in the second housing 22 to correspond to the second cover 222 (or the second rear surface area of the foldable electronic device 2).

According to various embodiments, the fifth camera module 305 may be located in alignment with an opening provided in the second display module 26 or may be at least partially inserted into the opening. External light may pass through the second cover 222 and the opening provided in the second display module 26 and reach the fifth camera module 305. The opening of the second display module 26 aligned with or overlapping the fifth camera module 305 may be a through hole. In various embodiments, the opening of the second display module 26 aligned with or overlapping the fifth camera module 305 may be provided as a notch.

According to various embodiments, the fifth camera module 305 (also referred to as a fifth camera, a second front camera module, or a second front camera) may overlap the second display area 26 when viewed from above the second rear surface area of the foldable electronic device 2. The fifth camera module 305 may be located on the rear surface of the second display area 26 or below the second display area 26. When viewed from the outside of the foldable electronic device 2, the fifth camera module 305 or the position of the fifth camera module 305 may not be substantially visually distinguished (or exposed). The fifth camera module 305 may include, for example, a hidden behind-display rear camera (e.g., a UDC). External light may pass through the second cover 222 and the second display module 26 and reach the fifth camera module 305.

According to various embodiments, the first camera module 301, the second camera module 302, the third camera module 303, the fourth camera module 304, or the fifth camera module 305 may operate as at least a portion of a sensor module. For example, an IR camera module may operate as at least portion of a sensor module.

According to various embodiments, the light-emitting module 306 may be accommodated in the first housing 21 to correspond to the first cover 212 (or the first rear surface area of the foldable electronic device 2). The first cover 212 may include a flash hole (or a fourth light transmission area) corresponding to the light-emitting module 306. The light-emitting module 306 may include, for example, an LED or a xenon lamp. The light-emitting module 306 may include a light source for the first camera module 301, the second camera module 302, and/or the third camera module 303.

According to various embodiments, the foldable electronic device 2 may further include another light-emitting module accommodated in the foldable housing 20 to correspond to the front surface of the foldable electronic device 2. The light-emitting module may provide, for example, the state information of the foldable electronic device 2 in an optical form. In various embodiments, the light-emitting module may provide a light source that operates in conjunction with the operation of the fourth camera module 304.

According to various embodiments, the sensor module 307 may be accommodated in the foldable housing 20 to correspond to the front surface of the foldable electronic device 2.

According to various embodiments, the sensor module 307 may include an optical sensor module. The optical sensor module may include, for example, a proximity sensor module or an illuminance sensor module.

According to various embodiments, the sensor module 307 may overlap the first display area 251 of the first display module 25 when viewed from above the first front surface area of the foldable electronic device 2. The sensor module 307 may be located on the rear surface of the first display area 251 or below the first display area 251. When viewed from the outside of the foldable electronic device 2, the sensor module 307 or the position of the sensor module 307 may not be substantially visually distinguished (or exposed). External light may pass through the first display module 25 and reach the sensor module 307.

According to various embodiments, the foldable electronic device 2 may further include various other sensor modules (e.g., a biometric sensor modules).

According to various embodiments, the first audio input module may include a first microphone (also referred to as a first mic). The second audio input module may include a second microphone (also referred to as a second mic). The third audio input module may include a third microphone (also referred to as a third mic). The fourth audio input module may include a fourth microphone (also referred to as a fourth mic). The first microphone may be accommodated in the first housing 21 to correspond to, for example, the first mic hole H11 included in the first side surface portion B1 of the first side member 2112. The second microphone may be accommodated in the first housing 21 to correspond to, for example, the second mic hole H12 included in the third side surface portion B3 of the first side member 2112. The third microphone may be accommodated in the first housing 21 to correspond to, for example, the third mic hole H13 included in the third side surface portion B3 of the first side member 2112. The fourth microphone may be accommodated in the second housing 22 to correspond to, for example, the fourth mic hole H14 included in the seventh side surface portion B7 of the second side member 2212. The positions or numbers of microphones and mic holes corresponding to the microphones may vary without being limited to the illustrated example.

According to various embodiments, the first sound output module may include a first speaker. The second sound output module may include a second speaker. The first speaker or the second speaker may be a speaker for multimedia playback or recording playback. The first speaker may be accommodated in the second housing 22 to correspond to, for example, the first speaker hole H21 included in the second side member 2212. The second speaker may be accommodated in the second housing 22 to correspond to, for example, the second speaker hole H21 provided in the second side member 2212. The positions or numbers of speakers for multimedia playback or recording playback and speaker holes corresponding to the speakers may vary without being limited to the illustrated example.

According to various embodiments, the third audio output module may include a third speaker. The third speaker may include a call receiver. The third speaker may be accommodated in the second housing 22 to correspond to, for example, the third speaker hole H23 provided between the second cover 222 and the seventh side surface portion B7 of the second side member 2212. The positions or numbers of call speakers and speaker holes corresponding to the speakers may vary without being limited to the illustrated example.

According to various embodiments, the key input module may include a first key (also referred to as a first side key) 309, a second key (also referred to as a second side key) 310, and/or a key signal generator. For example, the first key 309 may be located in a first key hole included in the second side surface portion B2 of the first side member 2112, and the second key 310 may be located in a second hey hole included in the second side surface portion B2 of the first side member 2112. The key signal generator may be configured to generate a first key signal in response to a press or touch on the first key 309 and a second key signal in response to a press or touch on the second key 310. The positions or number of key input modules may vary without being limited to the illustrated example.

According to various embodiments, the first connection terminal 311 (also referred to as a first connector or a first interface terminal) may be accommodated in the first housing 21 to correspond to a first connection terminal hole (e.g., a first connector hole) included in the first side surface portion B1 of the first side member 2112. The foldable electronic device 2 may transmit and/or receive power and/or data to/from an external electronic device electrically connected to the first connection terminal 311. The first connection terminal 311 may include, for example, a USB connector or an HDMI connector. The positions of the first connection terminal 311 and the first connection terminal hole corresponding to the first connection terminal 311 may vary without being limited to the illustrated example.

According to various embodiments, the second connection terminal 312 (also referred to as a second connector or a second interface terminal) may be accommodated in the second housing 22 to correspond to a second connection terminal hole (e.g., a second connector hole) included in the sixth side surface portion B6 of the second side member 2212. An external storage medium such as a secure digital memory (SD) card, a SIM card, or a universal SIM (USIM) may be connected to the second connection terminal 312. The positions of the second connection terminal 312 and the second connection terminal hole corresponding to the second connection terminal 312 may vary without being limited to the illustrated example.

The foldable electronic device 2 may further include various components depending on its provided form. Although all of these components cannot be listed since the components are modified diversely depending on the convergence trend of foldable electronic devices 2, components equivalent to the above-mentioned components may be further included in the foldable electronic device 2. In various embodiments, specific components may be excluded from the above components or replaced with other components depending on the provided form of the foldable electronic device.

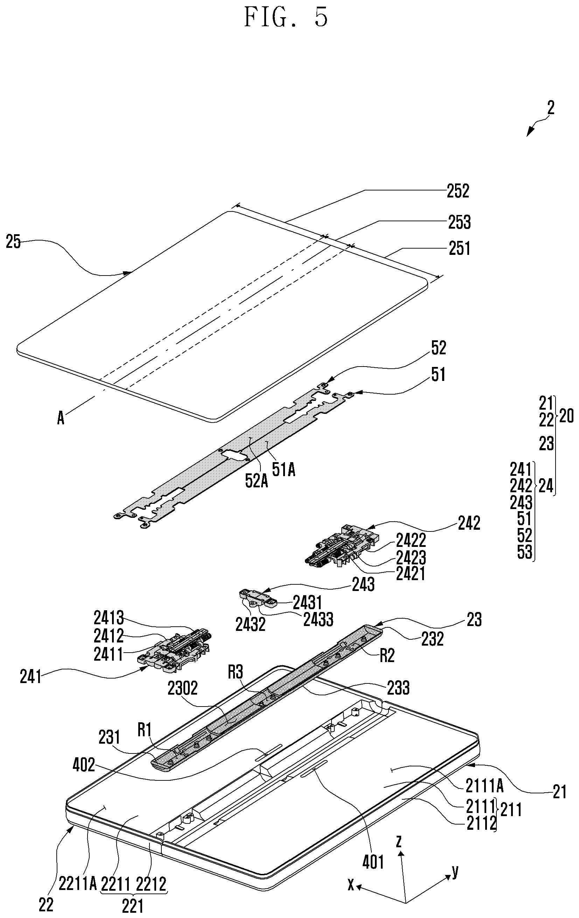

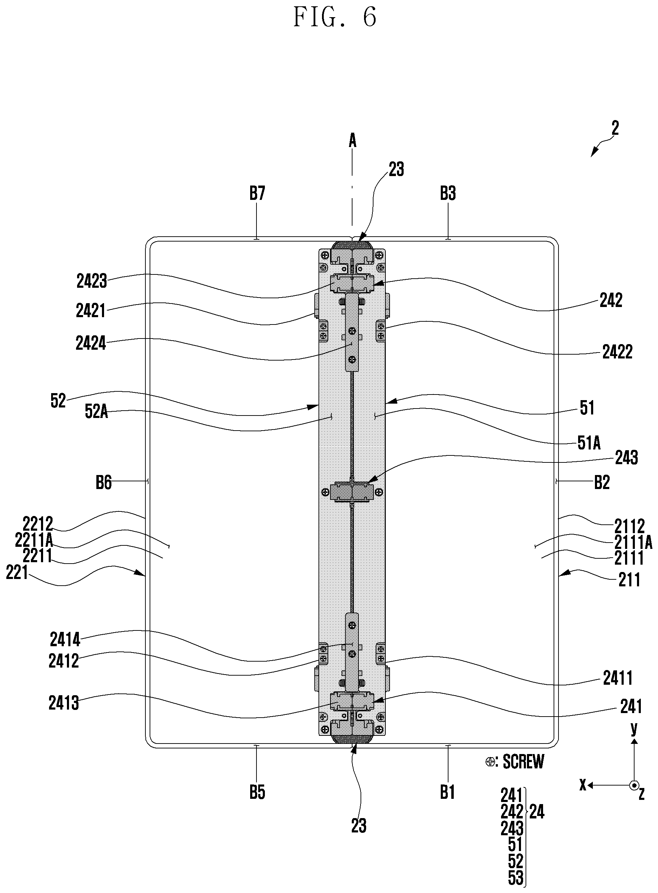

FIG. 5 shows an exploded perspective view of a portion a foldable electronic device 2 according to various embodiments of the disclosure in the unfolded state. FIG. 6 shows a view illustrating a portion of the foldable electronic device 2 according to various embodiments of the disclosure in the unfolded state.

Referring to FIGS. 5 and 6, the foldable electronic device 2 may include a foldable housing 20 and a first flexible display module 25. Descriptions of some components that have the same reference numerals as those illustrated in FIGS. 2, 3, and 4 will be omitted.

According to various embodiments, the foldable housing 20 may include a first housing 21, a second housing 22, a hinge housing 23, and/or a hinge module 24.

According to various embodiments, the first housing 21 may include a first frame 211. The first frame 211 may include a first bracket 2111 and a first side member 2112.

According to various embodiments, the first support surface 2111A of the first bracket 2111 may include a first front surface seating portion on which one or more components, such as the first display area 251 of the first display module 25, are stably placed or supported. The first front surface seating portion may be configured with, for example, a combination of surface areas having different heights.

According to various embodiments, the third support surface 1111B of the first bracket 2111 (see FIG. 4) may include a first rear surface seating portion on which one or more components, such as a first printed circuit board and/or a first battery, are stably placed or supported. The first rear surface seating portion may be configured with, for example, a combination of surface areas having different heights.

According to various embodiments, the second housing 22 may include a second frame 221. The second frame 221 may include a second bracket 2211 and a second side member 2212.

According to various embodiments, the second support surface 2211A of the second bracket 2211 may include a second front surface seating portion on which one or more components, such as the second display area 252 of the first display module 25, are stably placed or supported. The second front surface seating portion may be configured with, for example, a combination of surface areas having different heights.

According to various embodiments, the fourth support surface 2211B of the second bracket 2211 (see FIG. 4) may include a second rear surface seating portion on which one or more components, such as a second printed circuit board and/or a second battery, are stably placed or supported. The second rear surface seating portion may be configured with, for example, a combination of surface areas having different heights.

According to various embodiments, via an adhesive material (or a bonding material), the first display area 251 of the first display module 25 may be disposed on the first support surface 2111A of the first bracket 2111, and the second display area 252 of the first display module 25 may be disposed on the second support surface 2211A of the second bracket 2211. The adhesive material (or the bonding material) may include, for example, a heat-reactive adhesive material (or a heat-reactive bonding material), a light-reactive adhesive material (or a light-reactive bonding material), a general adhesive (or a general bonding agent), and/or double-sided tape.

According to various embodiments, the hinge housing 23 may include a first side wall (also referred to as a first end) 231 and a second side wall (also referred to as a second end) 232. The hinge housing 23 may extend from the first side wall 231 to the second side wall 232 in the direction of the center line A of the foldable electronic device 2.

According to various embodiments, the first side wall 231 and the second side wall 232 of the hinge housing 23 may be substantially perpendicular to the direction of the center line A of the foldable electronic device 2, and may be spaced apart from each other in the direction of the center line A of the foldable electronic device 2.

According to various embodiments, the first side wall 231 and the second side wall 232 of the hinge housing 23 may be provided (or formed) to be convex in opposite directions.

According to various embodiments, the first side wall 231 and the second side wall 232 of the hinge housing 23 may be provided (or formed) on opposite sides to be substantially symmetrical to each other.

According to various embodiments, the first side wall 231 of the hinge housing 23 may be located corresponding to the first side surface portion B1 of the first frame 211 and the fifth side surface portion B5 of the second frame 221. In the unfolded state of the foldable electronic device 2, the first side wall 231 may be covered by the first side surface portion B1 of the first frame 211 and the fifth side surface portion B5 of the second frame 221. In the folded state of the foldable electronic device 2, the first side wall 231 may be exposed to the outside through an open gap between the first side surface portion B1 of the first frame 211 and the fifth side surface portion B5 of the second frame 121.

According to various embodiments, the second side wall 232 of the hinge housing 23 may be located corresponding to the third side surface portion B3 of the first frame 211 and the seventh side surface portion B7 of the second frame 221. In the unfolded state of the foldable electronic device 2, the second side wall 232 may be covered by the third side surface portion B3 of the first frame 211 and the seventh side surface portion B7 of the second frame 221. In the folded state of the foldable electronic device 2, the second side wall 232 may be exposed to the outside through an open gap between the third side surface portion B3 of the first frame 211 and the seventh side surface portion B7 of the second frame 221.

According to various embodiments, the portion between the first and second side walls 231 and 232 of the hinge housing 23 (hereinafter, referred to as a "side wall extension 233") may extend or interconnect the first side wall 231 and the second side wall 232. In the folded state of the foldable electronic device 2, the side wall extension 233 may be exposed to the outside through an open gap between the fourth side surface portion B4 of the first frame 211 and the eighth side surface portion B8 of the second frame 221. In the unfolded state of the foldable electronic device 2, the gap between the fourth side surface portion B4 of the first frame 211 and the eighth side surface portion B8 of the second frame 221 may be closed, and the side wall extension 233 may not be exposed to the outside.

According to various embodiments, the hinge housing 23 may include a first surface and a second surface 2302 provided through a combination of the first side wall 231, the second side wall 232, and the side wall extension 233. The first surface may be exposed to the outside in the folded state of the foldable electronic device 2. The second surface 2302 may be disposed on the opposite side of the first surface. The second surface 2302 may include a seating portion configured such that the first hinge 241, the second hinge 242, and the third hinge 243 are stably placed and supported thereon. The seating portion may be provided by a combination of surface areas having different heights. For example, the seating portion may include a first recess R1 corresponding to the first hinge 241, a second recess R3 corresponding to the second hinge 242, and a third recess R3 corresponding to a third hinge 243.

According to various embodiments, the hinge housing 23 may be coupled to the hinge module 24. The hinge housing 23 may be connected to the first frame 211 of the first housing 21 and the second frame 221 of the second housing 22 via, for example, the hinge module 24. When the foldable electronic device 2 is switched between the unfolded state and the folded state, the first housing 21 and the second housing 22 connected to each other via the hinge module 24 may rotate in different directions with respect to the hinge module 24 when viewed in the direction of the center line A of the foldable electronic device 2. In the unfolded state of the foldable electronic device 2, the hinge housing 23 may be covered by the first frame 211 of the first housing 21 and the second frame 221 of the second housing 22. In the folded state of the foldable electronic device 2, the hinge housing 23 may be exposed to the outside through a gap between the first frame 211 of the first housing 21 and the second frame 221 of the second housing 22.

According to various embodiments, the hinge housing 23 may be defined or interpreted as a component included in the hinge module 24.

According to various embodiments, the hinge module 24 may include a first hinge 241, a second hinge 242, a third hinge 243, a first plate (also referred to as a first hinge plate or a first wing plate) 51, and/or a second plate (also referred to as a second hinge plate or a second wing plate) 52.

According to various embodiments, the first hinge 241, the second hinge 242, and the third hinge 243 may interconnect the first frame 211 and the second frame 221. The first frame 211 and the second frame 221 may be rotatably connected to each other via the first hinge 241, the second hinge 242, and the third hinge 243.

According to various embodiments, the first hinge 241, the second hinge 242, and the third hinge 243 may be arranged along the center line A of the foldable electronic device 2, and the third hinge 243 may be located between the first hinge 241 and the second hinge 242.

According to various embodiments, the third hinge 243 may be located corresponding to the center between the first hinge 241 and the second hinge 242 (e.g., a point on the center line A that is substantially equidistant from the first hinge 141 and the second hinge 242).

According to various embodiments, the first hinge 241 may include a first hinge bracket 2411, a second hinge bracket 2412, and/or a first bracket connection portion 2413. The first hinge bracket 2411 may be disposed on or coupled to the first support surface 2111A of the first frame 211, for example, through screw fastening. The second hinge bracket 2412 may be disposed on or coupled to the second support surface 2211A of the second frame 221, for example, through screw fastening. The first bracket connection portion 2413 may interconnect the first hinge bracket 2411 and the second hinge bracket 2412. The first hinge bracket 2411 and the second hinge bracket 2412 may be rotatable relative to the first bracket connection portion 2413. The first bracket connection portion 2413 may be configured such that a first frame 211, to which the first hinge bracket 2411 is fixed, and a second frame 221, to which the second hinge bracket 2412 is fixed, are rotatable at substantially the same angle in opposite directions. The first bracket connection portion 2413 may be configured such that the first frame 211, to which the first hinge bracket 2411 is fixed, and the second frame 221, to which the second hinge bracket 2412 is fixed, may be maintained after rotating by at least one predetermined angle. The first bracket connection portion 1413 may have, for example, a free-stop function.

According to various embodiments, the first bracket connection portion 2413 of the first hinge 241 may be configured to provide a force by which the first frame 211, to which the first hinge bracket 2411 of the first hinge 241 is fixed, and the second frame 221, to which the second hinge bracket 2412 of the first hinge 241 is fixed, can be rotated relative to each other. The first bracket connection portion 2413 may be configured with a combination of, for example, at least one shaft, at least one cam gear, and/or at least one compression spring providing elasticity.

According to various embodiments, the first bracket connection portion 2413 of the first hinge 241 may be coupled to the hinge housing 23. The first bracket connection portion 2413 may be coupled to the hinge housing 23, for example, through screw fastening.

According to various embodiments, the first bracket connection portion 2413 of the first hinge 241 may be disposed in or coupled to the first recess R1 of the hinge housing 23 through screw fastening.

According to various embodiments, the second hinge 242 may be provided at least partially or substantially identical to the first hinge 241. The second hinge 242 may include, for example, a third hinge bracket 2421 (e.g., the first hinge bracket 2411), a fourth hinge bracket 2422 (e.g., the second hinge bracket 2412), and/or a second bracket connection portion 2423 (e.g., the first bracket connection portion 2413). In various embodiments, the second hinge 242 may be disposed in the foldable electronic device 2 in an arrangement direction opposite to that of the first hinge 241. The third hinge bracket 2421 of the second hinge 242 may be disposed on or coupled to the second support surface 2211A of the second frame 221, and the fourth hinge bracket 2422 of the second hinge 242 may be disposed on or coupled to the first support surface 2111A of the first frame 211.

According to various embodiments, the second bracket connection portion 2423 of the second hinge 242 may be coupled to the hinge housing 23. The second bracket connection portion 2423 may be coupled to the hinge housing 23, for example, through screw fastening.

According to various embodiments, the second bracket connection portion 2423 of the second hinge 242 may be disposed in or coupled to the second recess R2 of the hinge housing 23 through screw fastening.

According to various embodiments, the third hinge 243 may include a guide rail assembly or a rotational motion guide. The third hinge 243 may include, for example, a first slider 2431, a second slider 2432, and a guide rail 2433. The first slider 2431 may be connected to the guide rail 2433 to be slidable with respect to the guide rail 2433. The second slider 2432 may be slidably connected to the guide rail 2433. The guide rail 2433 may include a first guide rail in a sliding pair relationship with the first slider 2431, and a second guide rail in a sliding pair relationship with the second slider 2432.

According to various embodiments, the guide rail 2433 of the third hinge 243 may be coupled to the hinge housing 23. The guide rail 2433 may be coupled to the hinge housing 23, for example, through screw fastening.

According to various embodiments, the guide rail 2433 of the third hinge 243 may be disposed in or coupled to the third recess R3 of the hinge housing 23 through screw fastening.

According to various embodiments, the first plate 51 may be located corresponding to the first frame 211 of the first housing 21, and the second plate 52 may be located corresponding to the second frame 221 of the second housing 22. The first plate 51 and the second plate 52 may be located on opposite sides with respect to the center line A of the foldable electronic device 2. The first plate 51 and the second plate 52 may have a first width in the direction of the center line A of the foldable electronic device 2 (e.g., the y-axis direction) that is relatively larger than a second width in a direction perpendicular to the above-mentioned direction. The first plate 51 and the second plate 52 may extend from the first hinge 241 to the second hinge 242 across the third hinge 243. With respect to the center line A of the foldable electronic device 2, one side of each of the first, second, and third hinges 241, 242, and 243 may be located between the first plate 51 and the first bracket 2111 of the first frame 211, and the other side of each of the first, second, and third hinges 241, 242, and 243 may be located between the second plate 52 and the second bracket 2211 of the second frame 221.

According to various embodiments, the first plate 51 and the second plate 52 may be connected to the first hinge 241, the second hinge 242, and the third hinge 243. The first plate 51 and the second plate 52 may be connected to the first hinge 241, the second hinge 242, and the third hinge 243, for example, through screw fastening.

According to various embodiments, the hinge module 24 may be configured such that the first plate 51 and the second plate 52 may support the third display area 253 of the first display module 25 to be flat in the unfolded state of the foldable electronic device 2.

According to various embodiments, the first plate 51 may include a first display support surface 51A provided to correspond to the third display area 253 of the first display module 25. The second plate 52 may include a second display support surface 52A provided to correspond to the third display area 253 of the first display module 25. The first display support surface 51A and the second display support surface 52A may support the third display area 253 to be flat with respect to the first display area 251 and the second display area 252 in the unfolded state of the foldable electronic device 2. The first display support surface 51A may include a flat surface capable of supporting one side area of the third display area 253 with respect to the center line A of the foldable electronic device 2 to be flat in the unfolded state of the foldable electronic device 2. The second display support surface 52A of the second plate 52 may include a flat surface capable of supporting the other side area of the third display area A3 to be flat with respect to the center line A of the foldable electronic device 2 in the unfolded state of the foldable electronic device 2.

According to various embodiments, in the unfolded state of the foldable electronic device 2, the first display support surface 51A of the first plate 51 and the second display support surface 52A of the second plate 52 may substantially form an angle of about 180 degrees and may be disposed without a substantial difference in height. In the unfolded state of the foldable electronic device 2, even if an external force (e.g., an external pressure such as a touch input made by using a user's finger or a touch input made by using an electronic pen) is applied to the third display area 253 of the first display module 25, the third display area 253 may remain flat by being supported by the first plate 51 and the second plate 52.

According to various embodiments, the first bracket connection portion 2413 of the first hinge 241 may include a first center plate 2414 aligned corresponding to the center line A of the foldable electronic device 2. The second bracket connection portion 2423 of the second hinge 242 may include a second center plate 2424 aligned corresponding to the center line A of the foldable electronic device 2. In the unfolded state of the foldable electronic device 2, the first center plate 2414 and the second center plate 2424 may support a portion of the third display area 253 of the first display module 25 corresponding to the gap between the first display support surface 51A of the first plate 51 and the second display support surface 52A of the second plate 52. The first center plate 2414 and the second center plate 2424 may reduce or prevent a sagging phenomenon or a creasing phenomenon in the portion of the third display area 253 corresponding to the gap between the first display support surface 51A of the first plate 51 and the second display support surface 52A of the second plate 52 when the foldable electronic device 2 device is in the unfolded state.

According to various embodiments, in the unfolded state of the foldable electronic device 2, the third hinge 243 may support a portion of the third display area 253 of the first display module 25 corresponding to the gap between the first display support surface 51A of the first plate 51 and the second display support surface 52A of the second plate 52.

According to various embodiments, in the folded state of the foldable electronic device 2, the first plate 51 and the second plate 52 may face each other and be spaced apart from each other. In the folded state of the foldable electronic device 2, the third display area 253 of the first display module 25 may be bent and located between the first plate 51 and the second plate 52.

According to various embodiments, the hinge module 24 may be configured such that the relative position of the first plate 51 with respect to the first frame 211 and the relative position of the second plate 52 with respect to the second frame 221 change during the switching of the foldable electronic device 2 between the unfolded state and the folded state.

According to various embodiments, the hinge module 24 may be configured such that the first plate 51 and the second plate 52 are substantially parallel in the folded state of the foldable electronic device 2. In the folded state of the foldable electronic device 2, the first display support surface 51A of the first plate 51 and the second display support surface 52A of the second plate 52 may face each other and be substantially parallel.

According to various embodiments, the hinge module 24 may be configured such that the first plate 51 and the second plate 52 form an acute angle in the folded state of the foldable electronic device 2. In the folded state of the foldable electronic device 2, the space between the first display support surface 51A of the first plate 51 and the second display support surface 52A of the second plate 52 may be provided in a form that is widened toward the hinge housing 23, allowing the third display area 253 of the first display module 25 to be disposed in a bent shape capable of reducing bending stress and/or buckling.

According to various embodiments, in the folded state of the foldable electronic device 2, the third display area 253 may be disposed in a bent shape capable of reducing collision (e.g., bending stress) between compressive stress generated in one side area of the third display area 253 with reference to a neutral plane inside the third display area 253 and tensile stress generated in the other side area of the third display area 253.

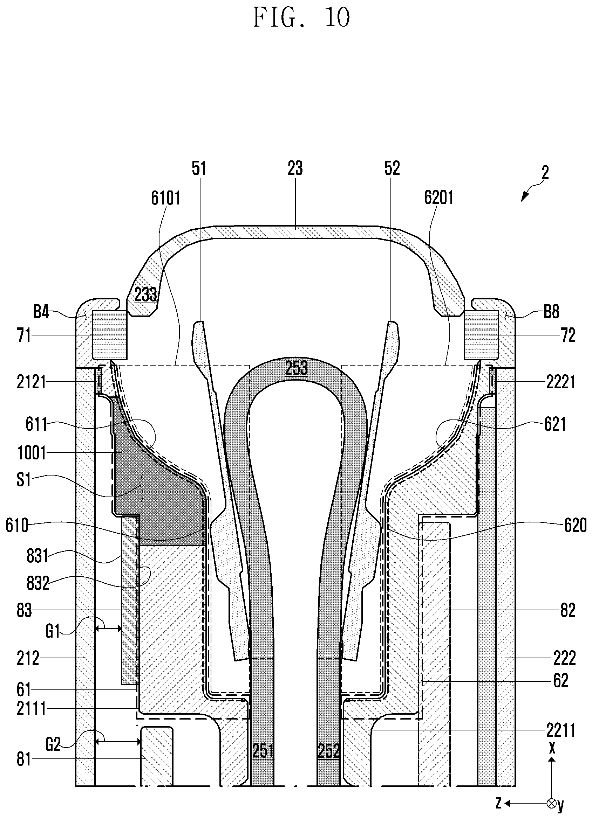

According to various embodiments, when the foldable electronic device 2 is switched from the unfolded state to the folded state, the third display area 253 of the first display module 25 may be located between the first plate 51 and the second plate 52 in a water droplet shape or dumbbell shape (see FIG. 10) capable of reducing damage or permanent deformation.

According to various embodiments, in the folded state of the foldable electronic device 2, the first plate 51 and the second plate 52 may support the third display area 253 of the first display module 25. The third display area 253 may be supported by the first plate 51 and the second plate 52 between the first plate 51 and the second plate 52 to be disposed in a bent shape (e.g., a droplet shape or a dumbbell shape) capable of reducing bending stress and/or buckling.

According to various embodiments, the first slider 2431 of the third hinge 243 may be coupled with the first plate 51, and the second slider 2432 of the third hinge 243 may be coupled with the second plate 52. Due to the operation (or state change) of the first hinge 241 and the second hinge 242 during the angle change between the first frame 211 and the second frame 221, the relative position of the first plate 51 to the first frame 211 and the relative position of the second plate 52 with respect to the second frame 221 change. In response to the changes in the relative positions of the first and second plates 51 and 52, the first guide rail may be configured to guide the path along which the first slider 2431 coupled with the first plate 51 moves with respect to the guide rail 2433, and the second guide rail may be configured to guide the path along which the second slider 2432 coupled with the second plate 52 moves with respect to the guide rail 2433.

According to various embodiments, the structure in which the third hinge 243, located between the first hinge 241 and the second hinge 242, is coupled with the first plate 51 and the second plate 52 may reduce or prevent the phenomenon of the first plate 51 and the second plate 52 being lifted, or the phenomenon of the first plate 51 and the second plate 52 being separated. According to various embodiments, the first bracket 2111 of the first frame 211 may include a first hole (also referred to as a first through hole) 401. The first hole 401 may, for example, penetrate between the first support surface 2111A and the third support surface 2111C (see FIG. 4) of the first bracket 2111. The second bracket 2211 of the second frame 221 may include a second hole (also referred to as a second through hole) 402. The second hole 402 may, for example, penetrate between the second support surface 2211A and the fourth support surface 2111B (see FIG. 4) of the second bracket 2211.

According to various embodiments, the foldable electronic device 2 may include a flexible printed circuit (FPCB) board that crosses the hinge module 24. The flexible printed circuit board may penetrate the first hole 401 and the second hole 402.

According to various embodiments, the first hole 401 and the second hole 402 may overlap and be aligned with each other in the folded state of the foldable electronic device 2.

According to various embodiments, the foldable electronic device 2 may include a ground structure. For example, the ground structure may include one or more ground areas included in one or more printed circuit boards (e.g., the first printed circuit board 81, the second printed circuit board 82, and/or the third printed circuit board 83 in FIG. 7) included in the foldable electronic device 2. For example, the ground structure may include a first conductor (also referred to as a first conductive structure or a first metal) included in the first housing 21. For example, the ground structure may include a second conductor (also referred to as a second conductive structure or a second metal) included in the second housing 22. For example, the ground structure may include a third conductor (also referred to as a third conductive structure or a third metal) included in the hinge housing 23. For example, the ground structure may include a fourth conductor (also referred to as a fourth conductive structure or a fourth metal) included in the hinge module 24. For example, the ground structure may include a fifth conductor (also referred to as a fifth conductive structure or a fifth metal) included in the first display module 25. For example, the ground structure may include a sixth conductor (also referred to as a sixth conductive structure or a sixth metal) included in the second display module 26 (see FIG. 4). At least one ground area, the first conductor, the second conductor, the third conductor, the fourth conductor, the fifth conductor, and/or the sixth conductor may be electrically connected. The ground structure may further include at least one other conductor electrically connected to at least one ground area, the first conductor, the second conductor, the third conductor, the fourth conductor, the fifth conductor, and/or the sixth conductor. The ground structure may be provided (or formed) by various other combinations.

According to various embodiments, the ground structure of the foldable electronic device 2 may reduce or prevent electromagnetic interference (EMI) to electric components included in the foldable electronic device 2. The ground structure of the foldable electronic device 2 may reduce or prevent the electromagnetic influence of noise from the outside of the foldable electronic device 2 on the electric components included in the foldable electronic device 2. The ground structure of the foldable electronic device 2 may reduce or prevent electromagnetic interference between the electric components included in the foldable electronic device 2.

According to various embodiments, the foldable electronic device 2 may include a first conductive area and a second conductive area. The first conductive area and the second conductive area may be electrically connected to each other, or may be electrically and physically connected to each other. According to various embodiments of the disclosure, when the first conductive area is configured to substantially radiate electromagnetic waves, the first conductive area of the combination of the first conductive area and the second conductive area may be defined or interpreted as a radiator (or an antenna radiator, a radiator, or an antenna radiator), and the second conductive area of the combination of the first conductive area and the second conductive area may be defined or interpreted as a ground structure of the foldable electronic device 2 that is distinguished from the radiator. According to various embodiments of the disclosure, when the first conductive area is configured to substantially radiate electromagnetic waves, the combination of the first conductive area and the second conductive area may be defined or interpreted as a ground structure of the foldable electronic device 2, and the first conductive area may be defined or interpreted as a radiator implemented through a portion of the ground structure of the foldable electronic device 2. According to various embodiments of the disclosure, when the first conductive area is configured to substantially radiate electromagnetic waves, the second conductive area may operate as an antenna ground that electromagnetically affects the first conductive area (e.g., an antenna radiator). The antenna ground may contribute to securing antenna radiation performance (also referred to as radio wave transmission/reception performance or communication performance) and/or coverage relative to the antenna radiator. The antenna ground may reduce electromagnetic interference (EMI) or signal loss relative to the radiator.

According to various embodiments, some of the ground structures of the foldable electronic device 2 may operate as a radiator (or an antenna radiator, a radiating element, or an antenna radiating element). Some of the ground structures of the foldable electronic device 2 may be electrically connected to a wireless communication circuit (e.g., the wireless communication module 192 in FIG. 1) disposed on a printed circuit board (e.g., the first printed circuit board 81 in FIG. 7). Some of the ground structures of the foldable electronic device 2 may operate as a radiator (e.g., a resonator) by receiving (or being fed with) an electromagnetic signal (or a wireless signal, a radio frequency (RF) signal, or a radiation current) from the wireless communication circuit. Others of the ground structures of the foldable electronic device 2 may be provided as an antenna ground that exerts an electromagnetic influence on at least one antenna radiator.

According to various embodiments, the wireless communication circuit (e.g., the wireless communication module 192 in FIG. 1) may process a transmission signal or a reception signal in at least one selected or predetermined frequency band via at least one radiator (or an antenna radiator, a radiator, or an antenna radiator). The selected or predetermined frequency band may include, for example, a low band (LB) (about 600 MHz to about 1 GHz), a middle band (MB) (about 1 GHz to about 2.3 GHz), a high band (HB) (about 2.3 GHz to about 2.7 GHz), or an ultra-high band (UHB) (about 2.7 GHz to about 6 GHz). The selected or predetermined frequency band may include various other frequency bands.

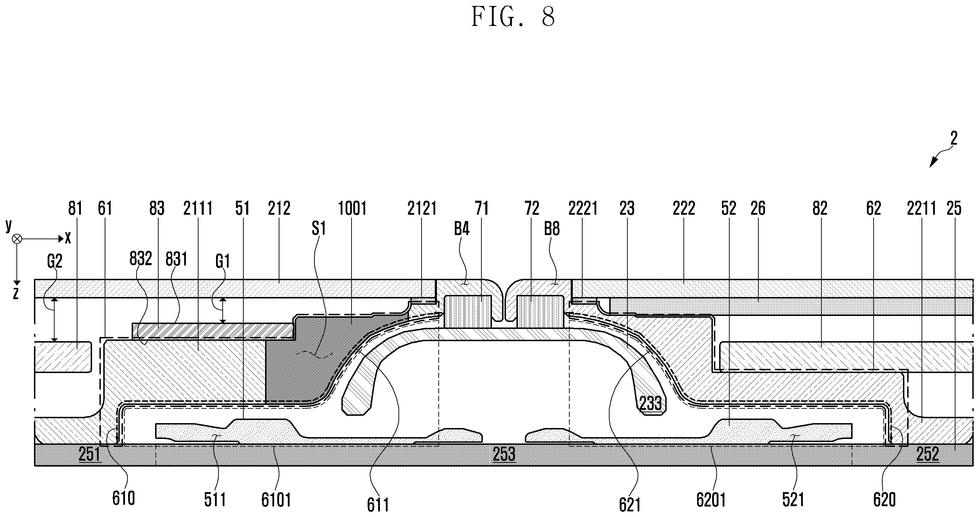

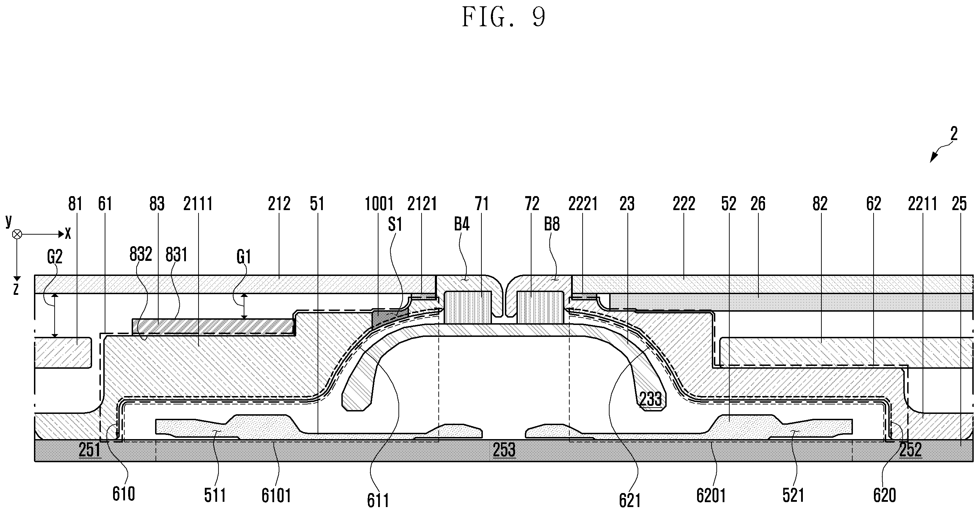

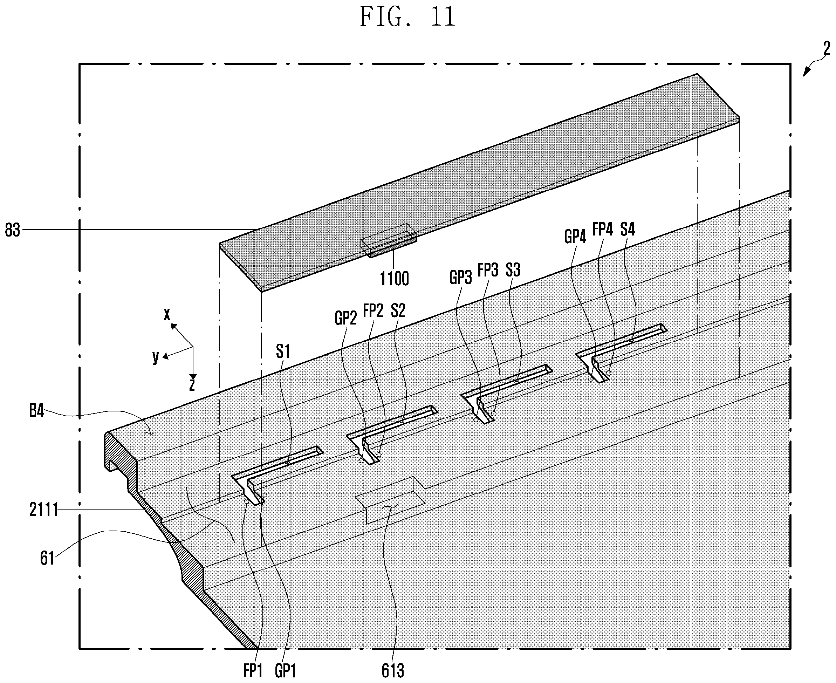

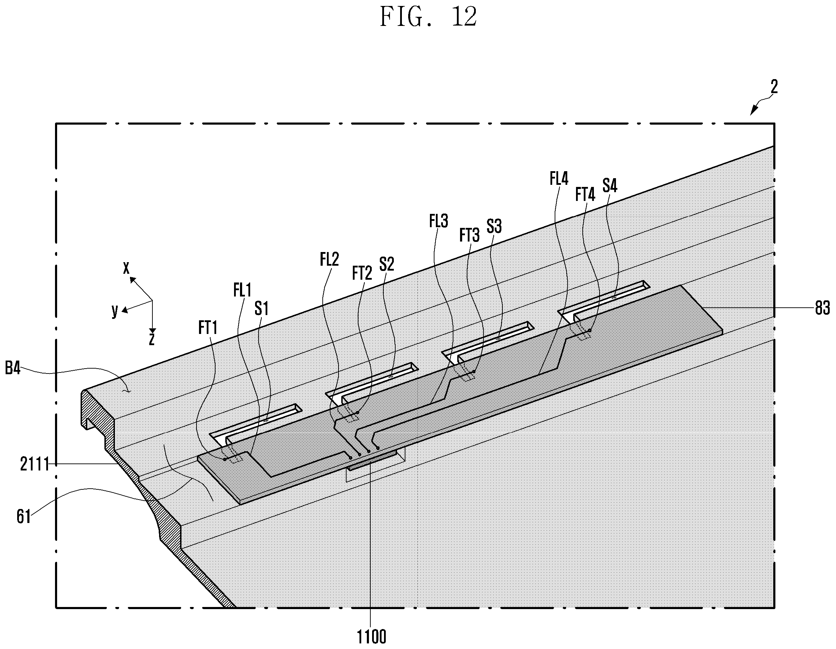

FIG. 7 shows a view illustrating a portion of the foldable electronic device 2 according to various embodiments of the disclosure in the unfolded state. FIG. 8 shows a cross-sectional view of a portion of the foldable electronic device 2 according to various embodiments of the disclosure in the unfolded state taken along line E-E' in FIG. 7. FIG. 9 shows a cross-sectional view of a portion of the foldable electronic device 2 according to various embodiments of the disclosure in the unfolded state taken along line F-F' in FIG. 7. FIG. 10 shows a cross-sectional view of a portion of the foldable electronic device 2 in the folded state in relation to FIG. 8 according to various embodiments of the disclosure. FIG. 11 shows an exploded perspective view of a portion of the foldable electronic device 2 according to various embodiments of the disclosure. FIG. 12 shows a perspective view of a portion of the foldable electronic device 2 according to various embodiments of the disclosure.

Referring to FIGS. 7, 8, 9, 10, 11, and 12, the foldable electronic device 2 may include a first bracket 2111, a second bracket 2211, a hinge housing 23, a first cover 212, a second cover 222, a first display module 25, a first plate 51, a second plate 52, a first foreign matter prevention member 71, a second foreign matter prevention member 72, a first printed circuit board 81, a second printed circuit board 82, a third printed circuit board 83, a first battery 91, and/or a second battery 92. Descriptions of some components that have the same reference numerals as those illustrated in FIGS. 2, 3, 4, 5, and 6 are omitted.

According to various embodiments, in the unfolded state of the foldable electronic device 2, the first display module 25 may be laid flat. In the unfolded state of the foldable electronic device 2, the third display area 253 may extend the first display area 251 and the second display area 252 in a substantially smooth and flat form.

According to various embodiments, when the foldable electronic device 2 is switched from the folded state to the unfolded state, the first plate 51 and the second plate 52 may support the third display area 253 of the first display module 25 to be flat. One or more hinges (e.g., the first hinge 241, the second hinge 242, and the third hinge 243 in FIG. 5) operatively connected to the first plate 51 and the second plate 52 may be configured such that the first plate 51 and the second plate 52 support the third display area 253 to be flat when the foldable electronic device 2 is switched from the folded state to the unfolded state.

According to various embodiments, in the folded state of the foldable electronic device 2, the first display area 251 and the second display area 252 of the first display module 25 face each other, and the third display area 253 of the first display module 25 may be located between the first plate 51 and the second plate 52. In the folded state of the foldable electronic device 2, the third display area 253 may be supported by the first plate 51 and the second plate 52 between the first plate 51 and the second plate 52 to be disposed in a bent shape (e.g., a droplet shape or a dumbbell shape) capable of reducing bending stress and/or buckling.

According to various embodiments, when the foldable electronic device 2 is switched from the unfolded state to the folded state, the first plate 51 and the second plate 52 operatively connected to one or more hinges (e.g., the first hinge 241, the second hinge 242, and the third hinge 243 in FIG. 5) may face each other and form an acute angle. When the foldable electronic device 2 is switched from the unfolded state to the folded state, the space between the first plate 51 and the second plate 52 may be provided in a shape that is widened toward the hinge housing 23, allowing the third display area 253 of the first display module 25 to be disposed in a bent shape (e.g., a droplet shape or a dumbbell shape) that is capable of reducing bending stress and/or buckling.

According to various embodiments, in the folded state of the foldable electronic device 2, the third display area 253 disposed in the bent shape may be provided (or formed) in a substantially symmetrical shape with reference to the center line A of the foldable electronic device 2.

According to various embodiments, the first bracket 2111 may include a first portion (also referred to as a first support area or a first hinge area) 61 extending the fourth side surface portion B4 of the first side member 2112 (see FIG. 4). The first hinge bracket 2411 of the first hinge 241 (see FIG. 5), the fourth hinge bracket 2422 of the second hinge 242 (see FIG. 5), and the first slider 2431 of the third hinge 243 (see FIG. 5) may be coupled with the first portion 61.

According to various embodiments, the first portion 61 of the first bracket 2111 may be at least partially located between the first cover 212 and the first plate 51.

According to various embodiments, in the unfolded state of the foldable electronic device 2, the first portion 61 of the first bracket 2111 may be positioned relative to the hinge housing 23 to cover a portion of the hinge housing 23 with reference to the center line A of the foldable electronic device 2. In the folded state of the foldable electronic device 2, the first portion 61 may be positioned relative to the hinge housing 23 not to cover a portion of the hinge housing 23 with reference to the center line A of the foldable electronic device 2.

According to various embodiments, the hinge housing 23 may include a third curved surface exposed to the outside in the folded state of the foldable electronic device 2 with reference to the center line A of the foldable electronic device 2, and the first portion 61 of the first bracket 2111 may include a first curved surface 611 corresponding to the third curved surface of the hinge housing 23.

According to various embodiments, in the unfolded state of the foldable electronic device 2, a portion of the hinge housing 23 may be located between the first portion 61 of the first bracket 2111 and the first plate 51.

According to various embodiments, the first portion 61 of the first bracket 2111 may include a first recessed portion (also referred to as a first recessed surface) 610. Due to the first recessed portion 610, the first portion 61 may have a space 6101 recessed toward the first cover 212 with reference to the first display area 251 that is laid substantially flat. When viewed from above the first cover 212 in the unfolded state of the foldable electronic device 2, the first recessed portion 610 (or the space 6101 formed due to the first recessed portion 610) may be located between the center line (also called folding axis) A of the foldable electronic device 2 (see FIG. 2) and the first display area 251. In the unfolded state of the foldable electronic device 2, a portion 511 of the first plate 51 may be accommodated in the first recessed portion 610 (or the space 6101 formed due to the first recessed portion 610). In the folded state of the foldable electronic device 2, a portion of the first plate 51 may be accommodated in the first recessed portion 610 (or the space 6101 formed due to the first recessed portion 610). During the switching between the unfolded state and the folded state of the foldable electronic device 2, the relative position of the first plate 51 with respect to the first recessed portion 610 may change. In the unfolded state of the foldable electronic device 2, a portion of the hinge housing 23 may be accommodated in the first recessed portion 610 (or the space 6101 formed due to the first recessed portion 610), and may face the first curved surface 611 included in the first recessed portion 610.

According to various embodiments, the fourth side surface portion B4 may be defined or interpreted as an element included in the first portion 61 of the first bracket 2111 rather than the first side member 2112 (see FIG. 4).

According to various embodiments, the first bracket 2111 may be provided (or formed) as a combination of at least one conductive portion and at least one non-conductive portion.

According to various embodiments, the second bracket 2211 may include a second portion (also referred to as a second support area or a second hinge area) 62 extending the eighth side surface portion B8 of the second side member 2212 (see FIG. 4). The second hinge bracket 2412 of the first hinge 241 (see FIG. 5), the third hinge bracket 2421 of the second hinge 242 (see FIG. 5), and the second slider 2432 of the third hinge 243 (see FIG. 5) may be coupled with the second portion 62.

According to various embodiments, the second portion 62 of the second bracket 2211 may be at least partially located between the second cover 222 and the second plate 52.

According to various embodiments, in the unfolded state of the foldable electronic device 2, the second portion 62 of the second bracket 2211 may be positioned relative to the hinge housing 23 to cover a portion of the hinge housing 23 with reference to the center line A of the foldable electronic device 2. In the folded state of the foldable electronic device 2, the second portion 62 may be positioned relative to the hinge housing 23 not to cover a portion of the hinge housing 23 with reference to the center line A of the foldable electronic device 2.

According to various embodiments, the hinge housing 23 may include a fourth curved surface exposed to the outside in the folded state of the foldable electronic device 2 with reference to the center line A of the foldable electronic device 2, and the second portion 62 of the second bracket 2211 may include a second curved surface 621 corresponding to the fourth curved surface of the hinge housing 23.

According to various embodiments, in the unfolded state of the foldable electronic device 2, a portion of the hinge housing 23 may be located between the second portion 62 of the second bracket 2211 and the second plate 52.

According to various embodiments, the second portion 62 of the second bracket 2211 may include a second recessed portion (also referred to as a second recessed surface) 620. Due to the second recessed portion 620, the second portion 62 may have a space 6201 recessed toward the second cover 222 with reference to the second display area 252 that is laid substantially flat. When viewed from above the second cover 222 in the unfolded state of the foldable electronic device 2, the second recessed portion 620 (or the space 6201 formed due to the second recessed portion 620) may be located between the center line (also called folding axis) A of the foldable electronic device 2 (see FIG. 2) and the second display area 252. In the unfolded state of the foldable electronic device 2, a portion 521 of the second plate 52 may be accommodated in the second recessed portion 620 (or the space 6201 formed due to the second recessed portion 620). In the folded state of the foldable electronic device 2, a portion of the second plate 52 may be accommodated in the second recessed portion 620 (or the space 6201 formed due to the second recessed portion 620). During the switching between the unfolded state and the folded state of the foldable electronic device 2, the relative position of the second plate 52 with respect to the second recessed portion 620 may change. In the unfolded state of the foldable electronic device 2, a portion of the hinge housing 23 may be accommodated in the second recessed portion 620 (or the space 6201 formed due to the second recessed portion 620), and may face the second curved surface 621 included in the second recessed portion 620.

According to various embodiments, the eighth side surface portion B8 may be defined or interpreted as an element included in the second portion 62 of the second bracket 2211 rather than the second side member 2212 (see FIG. 4).

According to various embodiments, the second bracket 2211 may be provided (or formed) as a combination of at least one conductive portion and at least one non-conductive portion.

According to various embodiments, a combination of the first curved surface 611 of the first bracket 2111 and the second curved surface 621 of the second bracket 2211 may provide (or form) a recess (see FIGS. 8 and 9) in which the hinge housing 23 is located in the unfolded state of the foldable electronic device 2.

According to various embodiments, the first cover 212 may be disposed on (or coupled to) the first portion 61 of the first bracket 2111 via a first adhesive material (or a first bonding material) 2121. The first adhesive material 2121 may be placed, for example, between the edge area of the first cover 212 and the first portion 61 of the first bracket 2111.

According to various embodiments, the second cover 222 may be disposed on (or coupled to) the second portion 62 of the second bracket 2211 via a second adhesive material (or a second bonding material) 2221. The second adhesive material 2221 may be placed, for example, between the edge area of the second cover 222 and the second portion 62 of the second bracket 2211.

According to various embodiments, a first hole 401 (see FIG. 5) may be provided (or formed) in the first portion 61.

According to various embodiments, a second hole 402 (see FIG. 5) may be provided (or formed) in the second portion 62.

According to various embodiments, when viewed in the direction of the center line A of the foldable electronic device 2, the relative position and shape of the third display area 253 of the first display module 25 relative to the hinge housing 23 may vary depending on the switching of the foldable electronic device 2 between the unfolded state and the folded state.

According to various embodiments, when viewed in the direction of the center line A of the foldable electronic device 2, the relative positions and shapes of the first plate 51 and the second plate 52 to the hinge housing 23 may vary depending on the switching of the foldable electronic device 2 between the unfolded state and the folded state.

According to various embodiments, the first foreign matter prevention member 71 may be disposed on or coupled to the fourth side surface portion B4. The first foreign matter prevention member 71 may reduce the gap between the fourth side surface portion B4 and the hinge housing 23. The first foreign matter prevention member 71 may reduce or prevent external foreign matter from entering the interior of the foldable electronic device 2 (e.g., the hinge module 24 in FIG. 5) through the gap between the fourth side portion B4 and the hinge housing 23.

According to various embodiments, the second foreign matter prevention member 72 may be disposed on or coupled to the eighth side surface portion B8. The second foreign matter prevention member 72 may reduce the gap between the eighth side surface portion B8 and the hinge housing 23. The second foreign matter prevention member 72 may reduce or prevent external foreign matter from entering the interior of the foldable electronic device 2 (e.g., the hinge module 24 in FIG. 5) through the gap between the eighth side portion B8 and the hinge housing 23.

According to various embodiments, the first foreign matter prevention member 71 and the second foreign matter prevention member 72 may be configured to be in elastic contact with the hinge housing 23. The first foreign matter prevention member 71 and the second foreign matter prevention member 72 may be configured to have durability capable of maintaining their shapes even when the foldable electronic device 2 is repeatedly switched between the unfolded state and the folded state.

According to various embodiments, the first foreign matter prevention member 71 and/or the second foreign matter prevention member 72 may include a brush, a porous form (e.g., a sponge), or a mesh form. The first foreign matter prevention member 71 and/or the second foreign matter prevention member 72 may include various other flexible materials.

According to various embodiments, the first foreign matter prevention member 71 may include a first brush. The first brush may include a support portion (also referred to as a fixing portion) and multiple bristles arranged on or coupled to the support portion. The support portion may be disposed on or coupled to the fourth side surface portion B4 of the first side member 2112 (see FIG. 4) by, for example, an adhesive material (or bonding material) or screw fastening. The multiple bristles may be in elastic contact with the hinge housing 23. The multiple bristles may be implemented to have sufficient elasticity and long-lasting flexibility. The multiple bristles may be made of various fibers, such as nylon fibers. The first brush may be referred to as a first sweeper.

According to various embodiments, the second foreign matter prevention member 72 may include a second brush (also referred to as a second sweeper). The second brush may be provided (or formed) in substantially the same manner as the first brush.

According to various embodiments, the first printed circuit board 81 and the first battery 91 may be located between the first cover 212 and the first bracket 2111. The first printed circuit board 81 and the first battery 91 may be disposed on or coupled to the first bracket 2111.

According to various embodiments, when viewed from above the first cover 212, the first printed circuit board 91 may be located closer to the third side surface portion B3 of the first frame 21 than the first battery 91. When viewed from above the first cover 212, the first battery 91 may be located closer to the first side surface portion B1 of the first frame 21 than the first printed circuit board 91. For example, when viewed from above the first cover 212, the first printed circuit board 91 may be at least partially located between the first battery 91 and the third side surface portion B3. For example, when viewed from above the first cover 212, the first battery 91 may be at least partially located between the first printed circuit board 81 and the first side surface portion B1.

According to various embodiments, when viewed from above the first cover 212, the first printed circuit board 81 and the first battery 91 may be located between the first portion 61 of the first bracket 2111 and the second side portion B2 of the first frame 21.

According to various embodiments, the second printed circuit board 82 and the second battery 92 may be located between the second cover 222 and the second bracket 2211. The second printed circuit board 82 and the second battery 92 may be disposed on or coupled to the second bracket 2211.

According to various embodiments, when viewed from above the second cover 222, the second printed circuit board 82 may be located closer to the seventh side surface portion B7 of the second frame 22 than the second battery 92. When viewed from above the second cover 222, the second battery 92 may be located closer to the fifth side surface portion B5 of the second frame 22 than the second printed circuit board 92. For example, when viewed from above the second cover 222, the second printed circuit board 82 may be at least partially located between the second battery 92 and the seventh side surface portion B7. For example, when viewed from above the second cover 222, the second battery 92 may be at least partially located between the second printed circuit board 82 and the fifth side surface portion B5.

According to various embodiments, when viewed from above the second cover 222, the second printed circuit board 82 may include a first board area located between the second battery 92 and the seventh side surface portion B7 of the second frame 22, and a second board area extending from the first board area and overlapping the second portion 62 of the second bracket 2211. The second board area may, for example, extend between the second battery 92 and the eighth side surface portion B8 of the second frame 22 when viewed from above the second cover 222.

According to various embodiments, the second printed circuit board 82 may not overlap the second portion 62 of the second bracket 2211.

According to various embodiments, when viewed from above the second cover 222, the second battery 92 may be located between the second portion 62 of the second bracket 2211 and the sixth side portion B6 of the second frame 22.

According to various embodiments, the third printed circuit board 83 may be located between the first bracket 2111 and the first cover 212. The third printed circuit board 83 may be at least partially disposed on (or coupled to) the first portion 61 of the first bracket 2111. The third printed circuit board 83 may be coupled to the first portion 61, for example, through mechanical fastening such as screw fastening, or bonding. The first portion 61 may support the third printed circuit board 83.

According to various embodiments, when viewed from above the first cover 212, the third printed circuit board 83 may not overlap the first printed circuit board 81 and the first battery 91.

According to various embodiments, the third printed circuit board 83 may include multiple pattern layers including conductive patterns, and one or more non-conductive layers (e.g., insulating layers) between the multiple pattern layers. The pattern layers may each include a signal line pattern (e.g., a conductive line pattern) utilized as a signal line (also referred to as an electrical path). The pattern layers may each include a ground pattern (ground plane) included in a ground area of the third printed circuit board 83.

According to various embodiments, the third printed circuit board 83 may include one or more conductive vias. The conductive vias may be conductive holes provided to allow for arranging connecting wires for electrically interconnecting conductive patterns of different pattern layers. The conductive vias may include, for example, a plated through hole (PTH), a laser via hole (LVH), a buried via hole (BVH), or a stacked via. At least one conductive via may electrically interconnect, for example, signal line patterns included in different pattern layers, as part of a signal line. At least one conductive via may electrically interconnect, for example, ground patterns included in different pattern layers, as part of a ground area.

According to various embodiments, the third printed circuit board 83 may include a rigid printed circuit board (rigid-PCB) or a flexible printed circuit board.

According to various embodiments, the third printed circuit board 83 may be electrically connected to the first printed circuit board 81. The third printed circuit board 83 may be electrically connected to the first printed circuit board 81 via an electrical connection member, such as a flexible printed circuit board. A connector (or receptacle) 1100 for electrical connection with a flexible printed circuit board may be disposed on the third printed circuit board 83.

According to various embodiments, the third printed circuit board 83 may be electrically connected to a wireless communication circuit (e.g., the wireless communication module 192 in FIG. 1) disposed on the first printed circuit board 81.

According to various embodiments, a ground area included in the third printed circuit board 83 may be electrically connected to a ground area included in the first printed circuit board 81.

According to various embodiments, the third printed circuit board 83 may include a third surface 831 and a fourth surface 832 facing away from the third surface 831. The third surface 831 may face the first cover 212, and the fourth surface 832 may face the first bracket 2111.

According to various embodiments, a connector 1100 may be disposed on the fourth surface 832 of the third printed circuit board 83.

According to various embodiments, the first portion 61 of the first bracket 2111 may include at least one recess to accommodate one or more elements disposed on the fourth surface 832 of the third printed circuit board 83. The at least one recess may slim the combination of the first portion 61 and the third printed circuit board 83. The first portion 61 may include, for example, a recess 613 to accommodate the connector 1100 disposed on the fourth surface 832 of the third printed circuit board 83.

According to various embodiments, the connector 1100 may be disposed on the third surface 831 of the third printed circuit board 83.

According to various embodiments, the first printed circuit board 81 and the third printed circuit board 83 may be substantially parallel. A first gap G1 may be provided (or formed) in which the third printed circuit board 83 is spaced apart from the first cover 212 in a direction from the first cover 212 toward the first display area 251 (e.g., in the +z axis direction). A second gap G2 may be provided (or formed) in which the first printed circuit board 81 is spaced apart from the first cover 212 in a direction from the first cover 212 toward the first display area 251. The first gap G1 may be narrower than the second gap G2. The first space in which the third printed circuit board 83 is located among the spaces between the first cover 212 and the first bracket 2211 may be thinner than the second space in which the first printed circuit board 81 is located among the spaces between the first cover 212 and the first bracket 2211.

According to various embodiments, the first portion 61 of the first bracket 2211 may include a first opening S1, a second opening S2, a third opening S3, and/or a fourth opening S4. The first opening S1, the second opening S2, the third opening S3, and the fourth opening S4 may penetrate between the first support surface 2111A (see FIG. 4) and the third support surface 2111B (see FIG. 4) of the first bracket 2111.

According to various embodiments, the first opening S1, the second opening S2, the third opening S3, and the fourth opening S4 may be provided (or formed) in the conductive area 612 at least partially included in the first portion 61. To aid understanding, the conductive area 612 is only disclosed in a limited manner in FIG. 7, but is not limited thereto.

According to various embodiments, the first opening S1, the second opening S2, the third opening S3, and the fourth opening S4 may be positioned or formed in the first recessed portion (the first recessed surface 610) of the first portion 61 included in the first bracket 2111.

According to various embodiments, the conductive area 612 included in the first portion 61 may be a portion of a ground structure of the foldable electronic device 2.

According to various embodiments, the first opening S1, the second opening S2, the third opening S3, and the fourth opening S4 may be provided (or formed) in substantially the same shape.

According to various embodiments, when viewed from above the first cover 212, the first opening S1, the second opening S2, the third opening S3, and/or the fourth opening S4 may be arranged in a second direction 7002 from the third side surface portion B3 of the first frame 21 to the first side surface portion B1 of the first frame 21 (e.g., the -y axis direction).

According to various embodiments, when viewed from above the first cover 212, the first opening S1, the second opening S2, the third opening S3, and the fourth opening S4 may be arranged at regular intervals in the second direction 7002.

According to various embodiments, when viewed from above the first cover 212, the first opening S1 may include a first edge E1 and a second edge E2 located on the opposite side of the first edge E1. The first opening S1 may include a slot (or slit) having a pattern (also referred to as an opening pattern) OP extending from a first end S11 to a second end S12 and having a width between the first edge E1 and the second edge E2. The first opening S1 may be referred to as a first slot (or a first slit), the second opening S2 may be referred to as a second slot (or a second slit), the third opening S3 may be referred to as a third slot (or a third slit), and the fourth opening S4 may be referred to as a fourth slot (or a fourth slit).

According to various embodiments, when viewed from above the first cover 212, the pattern OP of the first opening S1 extending from the first end S11 to the second end S12 may include a first pattern OP1 and a second pattern OP2. The first pattern OP1 may extend in a first direction 7001 from the second side surface portion B2 of the first frame 21 to the fourth side surface portion B4 of the first frame 21 (e.g., the +x-axis direction). The second pattern OP2 may extend in a second direction 7002 from an end of the first pattern OP1 (e.g., the -y-axis direction).

According to various embodiments, the conductive area 612 may surround the entire edge of the first opening S1, the entire edge of the second opening S2, the entire edge of the third opening S3, and the entire edge of the fourth opening S4. For example, a first end S11 of the first opening S1 (also referred to as a first slot end or a first slit end) and a second end S12 of the first opening S1 (also referred to as a second slot end or the first slit end) may be provided (or formed) in a closed form. The closed form of the first end S11 and the closed form of the second end S12 may be defined or interpreted as not having a gap formed by disposing a conductive material (e.g., the conductive area 612).

According to various embodiments, the first bracket 2111 may include a non-conductive portion 1001 at least partially disposed in the first opening S1, the second opening S2, the third opening S3, and/or the fourth opening S4.

According to various embodiments, in the unfolded state and the folded state of the foldable electronic device 2, the first opening S1, the second opening S2, the third opening S3, and/or the fourth opening S4 may be located between the third display area 253 and the first cover 212.

According to various embodiments, in the unfolded state of the foldable electronic device 2, a portion of the hinge housing 23 may be located between the first plate 51 and the first to fourth openings S1, S2, S3, and S4. In the folded state of the foldable electronic device 2, the hinge housing 23 may not be located between the first plate 51 and the first to fourth openings S1, S2, S3, and S4. When the foldable electronic device 2 is switched from the folded state to the unfolded state, a portion of the hinge housing 23 may be inserted between the first plate 51 and the first to fourth openings S1, S2, S3, and S4.

According to various embodiments, when viewed from above the first cover 212, at least a portion of the third printed circuit board 83 may overlap the first to fourth openings S1 to S4.

According to various embodiments, when viewed from above the first cover 212, the third printed circuit board 83 may overlap a portion corresponding to the first pattern OP1 of the first opening S1. When viewed from above the first cover 212, the third printed circuit board 83 may overlap a portion corresponding to the first pattern (e.g., the first pattern OP1) of the second opening S2. When viewed from above the first cover 212, the third printed circuit board 83 may overlap a portion corresponding to the first pattern (e.g., the first pattern OP1) of the third opening S3. When viewed from above the first cover 212, the third printed circuit board 83 may overlap a portion corresponding to the first pattern (e.g., the first pattern OP1) of the fourth opening S4.

According to various embodiments, the third printed circuit board 83 may include a first feed line (also referred to as a first feed path, a first electrical path, or a first signal line) FL1, a second feed line (also referred to as a second feed path, a second electrical path, or a second signal line) FL2, a third feed line (also referred to as a third feed path, a third electrical path, or a third signal line) FL3, and/or a fourth feed line (also referred to as a fourth feed path, a fourth electrical path, or a fourth signal line) FL4.

According to various embodiments, the third printed circuit board 83 may include a first feed terminal FT1, a second feed terminal FT2, a third feed terminal FT3, and/or a fourth feed terminal FT4. For example, the first feed terminal FT1, the second feed terminal FT2, the third feed terminal FT3, and the fourth feed terminal FT4 may be disposed on the fourth surface 832 of the third printed circuit board 83.

According to various embodiments, the first feed line FL1 may electrically interconnect the first feed terminal FT1 and the connector 1100. The second feed line FL2 may electrically interconnect the second feed terminal FT2 and the connector 1100. The third feed line FL3 may electrically interconnect the third feed terminal FT3 and the connector 1100. The fourth feed line FL4 may electrically interconnect the fourth feed terminal FP4 and the connector 1100.

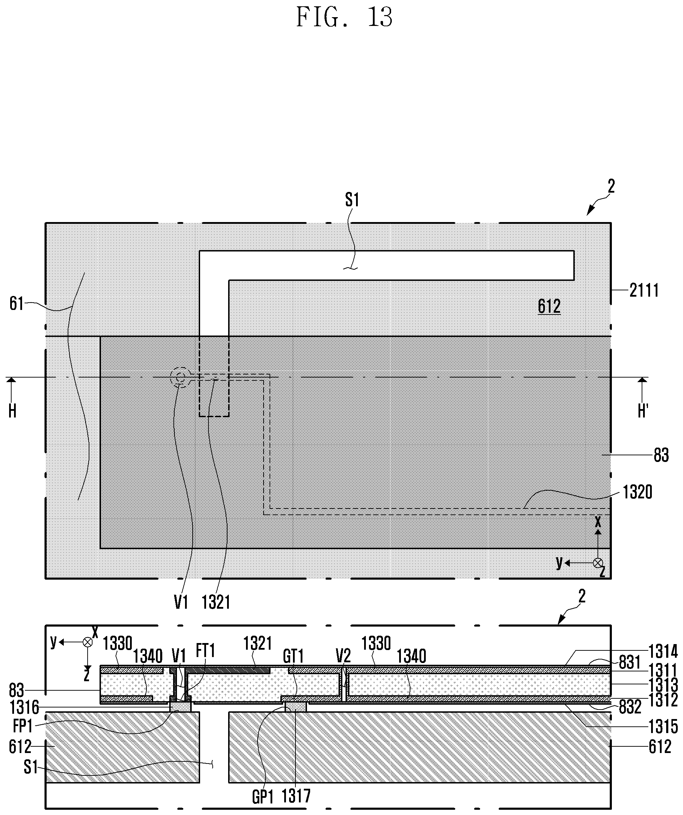

According to various embodiments, the third printed circuit board 83 may include a first ground terminal (e.g., the first ground terminal GT1 in FIG. 13), a second ground terminal, a third ground terminal, and a fourth ground terminal. For example, the first ground terminal, the second ground terminal, the third ground terminal, and the fourth ground terminal may be disposed on the fourth surface 832 of the third printed circuit board 83. The first ground terminal, the second ground terminal, the third ground terminal, and/or the fourth ground terminal may be electrically connected to a ground area of the third printed circuit board 83.

According to various embodiments, the ground area of the third printed circuit board 83 may include a first ground area (also referred to as a first ground portion), a second ground area (also referred to as a second ground portion), a third ground area (also referred to as a third ground portion), and/or a fourth ground area (also referred to as a fourth ground portion). The first ground area may reduce or block an electromagnetic influence of the first feed line on surrounding electrical elements. The first ground area may extend at least partially along, for example, the first feed line FL1. The first ground area may be disposed to at least partially surround, for example, the first feed line FL1. Substantially identical to the first ground area for the first feed line FL1, the second ground area may be configured to substantially reduce electromagnetic interference on the second feed line FL2. Substantially identical to the first ground area for the first feed line FL1, the third ground area may be configured to substantially reduce electromagnetic interference on the third feed line FL3. Substantially identical to the first ground area for the first feed line FL1, the fourth ground area may be configured to substantially reduce electromagnetic interference on the fourth feed line FL4. The first ground terminal may be electrically connected to the first ground area. The second ground terminal may be electrically connected to the second ground area. The third ground terminal may be electrically connected to the third ground area. The fourth ground terminal may be electrically connected to the fourth ground area.

According to various embodiments, the first ground area may be formed such that the first feed line FL1 can match the characteristic impedance. The second ground area may be formed such that the second feed line FL2 can match the characteristic impedance. The third ground area may be formed such that the third feed line FL3 can match the characteristic impedance. The fourth ground area may be formed such that the fourth feed line FL4 can match the characteristic impedance.

According to various embodiments, the conductive area 612 at least partially included in the first portion 61 of the first bracket 2111 may include a first feed point FP1 and a first ground point GP1. When viewed from above the first cover 212, the first feed terminal FT1 of the third printed circuit board 83 overlaps the first feed point FP1 of the conductive area 612, and the first ground terminal (e.g., the first ground terminal GT1 in FIG. 13) of the third printed circuit board 83 may overlap the first ground point GP1 of the conductive area 612. The first feed terminal FT1 may be electrically connected to the first feed point FP1. The first ground terminal may be electrically connected to the first ground point GP1.

According to various embodiments, the first feed terminal FT1 of the third printed circuit board 83 may be electrically connected to the first feed point FP1 of the conductive area 612 via a flexible conductor (also referred to as a flexible conductive portion or a flexible conductive member) or a conductive adhesive material (a conductive bonding member) disposed between the first feed terminal FT1 and the conductive area 612 of the first bracket 2111. The flexible conductor may include, for example, a conductive clip (e.g., a conductive structure including an elastic structure), a pogo-pin, a spring, conductive Poron, conductive sponge, conductive rubber, conductive tape, or a conductive connector.

According to various embodiments, the first ground terminal (e.g., the first ground terminal GT1 in FIG. 13) of the third printed circuit board 83 may be electrically connected to the first ground point GP1 of the conductive area 612 via a flexible conductor (also referred to as a flexible conductive portion or a flexible conductive member) or a conductive adhesive material (a conductive bonding member) disposed between the first ground terminal and the conductive area 612 of the first bracket 2111.

According to various embodiments, when viewed from above the first cover 212, the first feed point FP1 and the first ground point GP1 may be located on opposite sides with the first opening S1 interposed therebetween. When viewed from above the first cover 212, the first feed point FP1 and the first ground point GP1 may be located on opposite sides with the first edge E1 and the second edge E2 of the first opening S1 interposed therebetween. In various embodiments, the relative position between the first feed point FP1 and the first ground point GP1 may also vary.

According to various embodiments, the second feed terminal FT2 of the third printed circuit board 83 may be electrically connected to the second feed point FP2 of the conductive area 612, substantially in the same manner as the first feed terminal FT1 of the third printed circuit board 83 is electrically connected to the first feed point FP1 of the conductive area 612. The third feed terminal FT3 of the third printed circuit board 83 may be electrically connected to the third feed point FP3 of the conductive area 612, substantially in the same manner as the first feed terminal FT1 of the third printed circuit board 83 is electrically connected to the first feed point FP1 of the conductive area 612. The fourth feed terminal FT4 of the third printed circuit board 83 may be electrically connected to the fourth feed point FP4 of the conductive area 612, substantially in the same manner as the first feed terminal FT1 of the third printed circuit board 83 is electrically connected to the first feed point FP1 of the conductive area 612.

According to various embodiments, the second ground terminal of the third printed circuit board 83 may be electrically connected to the second ground point GP2 of the conductive area 612, substantially in the same manner as the first ground terminal (e.g., the first ground terminal GT1 in FIG. 13) of the third printed circuit board 83 is electrically connected to the first ground point GP1 of the conductive area 612. The third ground terminal of the third printed circuit board 83 may be electrically connected to the third ground point GP3 of the conductive area 612, substantially in the same manner as the first ground terminal of the third printed circuit board 83 is electrically connected to the first ground point GP1 of the conductive area 612. The fourth ground terminal of the third printed circuit board 83 may be electrically connected to the fourth ground point GP4 of the conductive area 612, substantially in the same manner as the first ground terminal of the third printed circuit board 83 is electrically connected to the first ground point GP1 of the conductive area 612.

According to various embodiments, when viewed from above the first cover 212, the first feed line FL1 may cross the first opening S1. The first feed line FL1 may cross, for example, the first edge E1 and the second edge E2 of the first opening S1. When viewed from above the first cover 212, the second feed line FL2 may cross the second opening S2. When viewed from above the first cover 212, the third feed line FL3 may cross the third opening S3. When viewed from above the first cover 212, the fourth feed line FL4 may cross the fourth opening S4.

According to various embodiments, a wireless communication circuit (e.g., the wireless communication module 192 in FIG. 1) disposed on the first printed circuit board 81 may provide (or feed) an electromagnetic signal (or a radio signal, an RF signal, or a radiation current) to the first feed point FP1 of the conductive area 612 via the first feed line FL1 of the third printed circuit board 83. When an electromagnetic signal is provided to the first feed point FP1, a first electromagnetic field (also referred to as a first radiation field) that resonates the first opening S1 may be generated due to a potential difference or impedance difference between the first feed point FP1 and the first ground point GP1. When an electromagnetic signal is provided to the first feed point FP1, energy of a selected or predetermined frequency band may be substantially concentrated at the first opening S1. The wireless communication circuit may transmit electromagnetic waves to the outside or receive electromagnetic waves from the outside through the first opening S1.

According to various embodiments, the wireless communication circuit (e.g., the wireless communication module 192 in FIG. 1) disposed on the first printed circuit board 81 may provide (or feed) an electromagnetic signal (or a radio signal, an RF signal, or a radiation current) to the second feed point FP2 of the conductive area 612 via the second feed line FL2 of the third printed circuit board 83. When an electromagnetic signal is provided to the second feed point FP2, a second electromagnetic field (also referred to as a second radiation field) that resonates the second opening S2 may be generated due to a potential difference or impedance difference between the second feed point FP2 and the second ground point GP2. When an electromagnetic signal is provided to the second feed point FP2, energy of a selected or predetermined frequency band may be substantially concentrated at the second opening S2. The wireless communication circuit may transmit electromagnetic waves to the outside or receive electromagnetic waves from the outside through the second opening S2.

According to various embodiments, the wireless communication circuit (e.g., the wireless communication module 192 in FIG. 1) disposed on the first printed circuit board 81 may provide (or feed) an electromagnetic signal (or a radio signal, an RF signal, or a radiation current) to the third feed point FP3 of the conductive area 612 via the third feed line FL3 of the third printed circuit board 83. When an electromagnetic signal is provided to the third feed point FP3, a third electromagnetic field (also referred to as a third radiation field) that resonates the third opening S3 may be generated due to a potential difference or impedance difference between the third feed point FP3 and the third ground point GP3. When an electromagnetic signal is provided to the third feed point FP3, energy of a selected or predetermined frequency band may be substantially concentrated at the third opening S3. The wireless communication circuit may transmit electromagnetic waves to the outside or receive electromagnetic waves from the outside through the third opening S3.

According to various embodiments, the wireless communication circuit (e.g., the wireless communication module 192 in FIG. 1) disposed on the first printed circuit board 81 may provide (or feed) an electromagnetic signal (or a radio signal, an RF signal, or a radiation current) to the fourth feed point FP4 of the conductive area 612 via the fourth feed line FL4 of the third printed circuit board 83. When an electromagnetic signal is provided to the fourth feed point FP4, a fourth electromagnetic field (also referred to as a fourth radiation field) that resonates the fourth opening S4 may be generated due to a potential difference or impedance difference between the fourth feed point FP4 and the fourth ground point GP4. When an electromagnetic signal is provided to the fourth feed point FP4, energy of a selected or predetermined frequency band may be substantially concentrated at the fourth opening S4. The wireless communication circuit may transmit electromagnetic waves to the outside or receive electromagnetic waves from the outside through the fourth opening S4.

A combination of the conductive area 612 and the third printed circuit board 83 may be defined or interpreted as a slot antenna or a slot antenna structure. The combination of the conductive area 612 and the third printed circuit board 83 (e.g., the slot antenna or the slot antenna structure) may include a first slot radiator (also referred to as a first slot resonator) capable of resonating the first opening S1, a second slot radiator (also referred to as a second slot resonator) capable of resonating the second opening S2, a third slot radiator (also referred to as a third slot resonator) capable of resonating the third opening S3, and a fourth slot radiator (also referred to as a fourth slot resonator) capable of resonating the fourth opening S4.

According to various embodiments, a combination of the first slot radiator, the second slot radiator, the third slot radiator, and the fourth slot radiator may be implemented as an antenna array configured to transmit and/or receive a signal in a selected or predetermined frequency band. Due to interference (e.g., constructive interference and/or destructive interference) between the first electromagnetic field generated from the first slot radiator, the second electromagnetic field generated from the second slot radiator, the third electromagnetic field generated from the third slot radiator, and the fourth electromagnetic field generated from the fourth slot radiator, composite waves (or beam pattern) capable of relatively radiating or concentrating electromagnetic wave energy (also referred to as wave energy) in a desired direction may be provided (or formed). The number or locations of the slot radiators included in the antenna array are not limited to the illustrated example and may vary.

According to various embodiments, the first opening S1, the second opening S2, the third opening S3, and/or the fourth opening S4 may be provided (or formed) in a form having an open end. The open form of the end may be defined or interpreted as a substantial gap being formed due to the absence of a conductive material (e.g., a conductive area 612).

According to various embodiments, the pattern OP of the first opening S1, the second opening S2, the third opening S3, and/or the fourth opening S4 may have a physical size capable of securing antenna radiation performance in a selected or predetermined frequency band or reducing degradation of antenna radiation performance. The physical size may refer to an electrical size or electrical length expressed as a ratio of wavelengths λ.

According to various embodiments, the first slot radiator is an electrically small antenna, wherein the pattern OP of the first opening S1 may be formed with a physical size less than or equal to a selected or predetermined wavelength ratio (e.g., about λ/10, about λ/8, or about λ/4). The second opening S2 of the second slot radiator, the third opening S3 of the third slot radiator, and/or the fourth opening S4 of the fourth slot radiator may be formed be formed to be substantially the same physical size as, for example, the first opening S1 of the first slot radiator.

According to various embodiments, the first slot radiator may be implemented such that the first feed line FL1 indirectly feeds power to the first opening S1 of the conductive area 612. The second slot radiator may be implemented such that the second feed line FL2 indirectly feeds power to the second opening S2 of the conductive area 612. The third slot radiator may be implemented such that the third feed line FL3 indirectly feeds power to the third opening S3 of the conductive area 612. The fourth slot radiator may be implemented such that the fourth feed line FL4 indirectly feeds power to the fourth opening S4 of the conductive area 612.

According to various embodiments, the positions or shapes of the first to fourth openings S1 to S4 are not limited to the illustrated examples and may vary. For example, any two of the first to fourth openings S1 to S4 may be provided (or formed) in different shapes.

According to various embodiments, any two of the slot radiators among the first to fourth slot radiators may be implemented to have different resonant frequencies. A wireless communication circuit (e.g., the wireless communication module 192 in FIG. 1) may be configured to transmit and/or receive signals of different frequency bands, respectively, through any two of the slot radiators among the first to fourth slot radiators.

In various embodiments, instead of the third printed circuit board 83 and the flexible printed circuit board electrically interconnecting the first printed circuit board 81 and the third printed circuit board 83, an integral or single printed circuit board may be provided (or formed). The integral or single printed circuit board may include, for example, a flexible printed circuit board. The integral or single printed circuit board may include, for example, a rigid-flexible printed circuit board (RJC) including a rigid portion corresponding to the third printed circuit board 83 and a flexible portion corresponding to the flexible printed circuit board electrically interconnecting the first printed circuit board 81 and the third printed circuit board 83.

According to various embodiments, the foldable electronic device 2 may include a matching circuit disposed on the third printed circuit board 83. The matching circuit (e.g., a switching circuit or a frequency adjustment circuit) may shift the resonant frequency of a slot radiator to a predetermined frequency or may shift the resonant frequency by a predetermined amount. The matching circuit may substantially match the impedance of a feed line and the impedance of a slot radiator. Impedance matching may reduce the amount of reflection at a connection portion between a feed line and a slot radiator, thereby reducing the degradation of the antenna radiation performance. The matching circuit may include electrical elements having components such as inductance, capacitance, or conductance. The matching circuit may include various elements such as lumped elements or passive elements.

In various embodiments, the matching circuit disposed on the third printed circuit board 83 may be disposed on or electrically connected to a feed line (e.g., the first feed line FL1, the second feed line FL2, the third feed line FL3, and/or the fourth feed line FL4).

According to various embodiments, the matching circuit disposed on the third printed circuit board 83 may be arranged on a first ground line electrically interconnecting a first ground terminal (e.g., the first ground terminal GT1 in FIG. 13) and a first ground area, or may be electrically connected to a first ground line. The matching circuit may be arranged on a second ground line electrically interconnecting a second ground terminal and a second ground area, or may be electrically connected to the second ground line. The matching circuit may be arranged on a third ground line electrically interconnecting a third ground terminal and a third ground area, or may be electrically connected to the third ground line. The matching circuit may be arranged on a fourth ground line electrically interconnecting a fourth ground terminal and a fourth ground area, or may be electrically connected to the fourth ground line.

According to various embodiments, a matching circuit (e.g., a switching circuit or a frequency adjustment circuit) disposed on the third printed circuit board 83 may be configured to reduce a difference between the antenna radiation performance of the slot radiator in the unfolded state of the foldable electronic device 2 and the antenna radiation performance of the slot radiator in the folded state of the foldable electronic device 2. Since the relative position between at least one element and the slot radiator changes when the foldable electronic device 2 is switched between the unfolded state and the folded state, the electromagnetic influence of the at least one element on the slot radiator may change. At least one element that may have an electromagnetic influence on the slot radiator in the unfolded state or the folded state of the foldable electronic device 2 may contain a conductive material and/or a non-conductive material (or a dielectric material). For example, the relative position of at least one of the first display module 25, the hinge housing 23, and the first plate 51 with respect to the first portion 61 including the first opening S1, the second opening S2, the third opening S3, and the fourth opening S4 may change when the foldable electronic device 2 is switched between the unfolded state and the folded state. A processor (e.g., the processor 120 in FIG. 1) or a wireless communication circuit (e.g., the wireless communication module 192 in FIG. 1) disposed on the first printed circuit board 81 may control a matching circuit such that a slot radiator remains resonant in a selected or predetermined frequency band even when the foldable electronic device 2 is switched between the unfolded state and the folded state.

Hereinafter, various examples of a slot radiator will be described. Any one example may be interpreted as being within the scope of various embodiments of the disclosure as it may be a modification or alteration of at least some parts of any other example. With respect to any one example, the same terminology and/or the same reference numerals may be used for components that are at least partially identical, similar, or related to any other examples. In any two examples, two components that share the same terminology but have different reference numerals may be understood to be substantially the same or have their forms varied or modified.

FIG. 13 shows a view illustrating a portion of a foldable electronic device 2 according to various embodiments of the disclosure and a cross-section of the portion of the foldable electronic device 2 taken along the line H-H'.

Referring to FIG. 13, the foldable electronic device 2 may include a first bracket 2111 and a third printed circuit board 83. The third printed circuit board 83 may be disposed on or coupled to the first portion 61 of the first bracket 2111. The conductive area 612 at least partially included in the first portion 61 may include a first opening S1. When viewed from above the first cover 212 (see FIG. 8), the third printed circuit board 83 may overlap a portion of the first opening S1.

According to various embodiments, the third printed circuit board 83 may include a first pattern layer 1311, a second pattern layer 1312, an insulating layer 1313, a first cover layer (also referred to as a first protective layer) 1314, and/or a second cover layer (also referred to as a second protective layer) 1315. The first pattern layer 1311 may be located closer to the third surface 831 than the second pattern layer 1312. The second pattern layer 1312 may be located closer to the fourth surface 832 than the first pattern layer 1311. The insulating layer 1313 may be located between the first pattern layer 1311 and the second pattern layer 1312. The first pattern layer 1311 and the second pattern layer 1312 may be physically separated by the insulating layer 1313 therebetween. The first cover layer 1314 may contain a non-conductive material and may form at least a portion of the third surface 831 of the third printed circuit board 83. The second cover layer 1315 may contain a non-conductive material and may form at least a portion of the fourth surface 832 of the third printed circuit board 83.

According to various embodiments, the first pattern layer 1311 may include a signal line pattern 1320. The signal line pattern 1320 may be included in the first feed line FL1 of FIG. 12.

According to various embodiments, the first pattern layer 1311 may include a first ground pattern 1330 physically separated from the signal line pattern 1320.

According to various embodiments, the second pattern layer 1312 may include a first feed terminal FT1.

According to various embodiments, the second pattern layer 1312 may include a second ground pattern 1340 physically separated from the first feed terminal FT1.

According to various embodiments, the second pattern layer 1312 may include a first ground terminal GT1 connected to the second ground pattern 1340.

According to various embodiments, the signal line pattern 1320 of the first pattern layer 1311 and the first feed terminal FT1 of the second pattern layer 1312 may be electrically connected via a first conductive via V1 (e.g., a first PTH). The first conductive via V1 may be included in the first feed line FL1 in FIG. 12.

According to various embodiments, the first feed terminal FT1 of the second pattern layer 1312 may be electrically connected to the first feed point FP1 of the conductive area 612 through a first flexible conductor (or a first conductive adhesive material) 1316.

According to various embodiments, the first ground pattern 1330 of the first pattern layer 1311 and the second ground pattern 1340 of the second pattern layer 1312 may be electrically connected via at least one second conductive via V2 (e.g., at least one second PTH).

According to various embodiments, a combination of the first ground pattern 1330, the second ground pattern 1340, and the at least one second conductive via V2 may be a first ground area configured to substantially reduce electromagnetic interference to the first feed line FL1 in FIG. 12. For example, the first ground area may be arranged substantially along the first feed line FL1 in FIG. 12. The first ground area may be provided in various ways without being limited to the example of FIG. 13. For example, the first ground area may be arranged to at least partially surround the first feed line FL1 in FIG. 12.

According to various embodiments, when viewed from above the third surface 831, the signal line pattern 1320 may cross the first opening S1. A portion of the signal line pattern 1320 that crosses the first opening S1 may be referred to as a feed pattern 1321. The feed pattern 1321 may correspond to a portion of the first feed line FL1 in FIG. 12 that is not substantially electromagnetically protected by the first ground area.

According to various embodiments, the first ground terminal GT1 of the second pattern layer 1312 may be electrically connected to the first feed point GP1 of the conductive area 612 via a second flexible conductor (or a second conductive adhesive material) 1317.

According to various embodiments, since the feed pattern 1321 is electrically connected to the first feed point FP1 of the conductive area 612 across the first opening S1 of the conductive area 612, and the first ground area is electrically connected to the first ground point GP1 of the conductive area 612, when an electromagnetic signal is provided (or fed) to the first feed terminal FT1 via the first feed line FL1, a potential difference or an impedance difference occurs between the first feed point FP1 and the first ground point GP1, and resonance of the first opening S1 may occur due to the potential difference or the impedance difference.

According to various embodiments, the laminated structure of the third printed circuit board 83 may vary without being limited to the illustrated example. For example, the feed pattern 1312 may be included in the second pattern layer 1312, and the first conductive via V1 may be omitted. The feed pattern 1312 may be included, for example, in the third pattern layer which is located closer to the fourth surface 832 than the first pattern layer 1311 and closer to the third surface 831 than the second pattern layer 1312, and the first conductive via V1 may be provided (or formed) as a via of a different form (e.g., BVH) than the illustrated PTH. The first ground area is not limited to the illustrated example, and may be implemented in various ways.

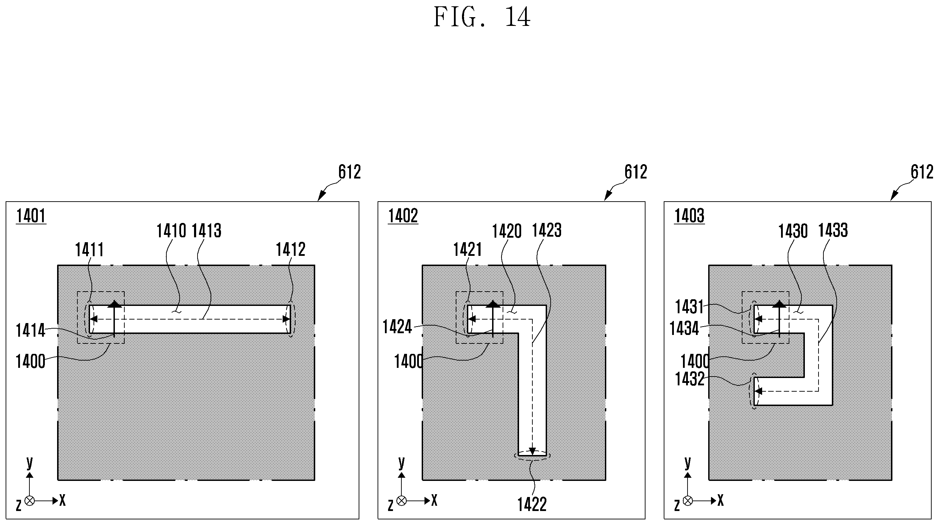

FIG. 14 shows views each illustrating a conductive area 612 including an opening according to various embodiments of the disclosure.

Referring to FIG. 14, the conductive area 612 may include a first exemplary opening 1410 according to a first example 1401, a second exemplary opening 1420 according to a second example 1402, or a third exemplary opening 1403 according to a third example 1403. In various embodiments, the first exemplary opening 1410, the second exemplary opening 1420, and the third exemplary opening 1430 may be formed (or extended) in different patterns (also referred to as opening patterns) using slots (or slits) having the same width.

According to various embodiments, the first exemplary opening 1410 may have a first physical length (e.g., an electrical size or electrical length expressed as a ratio of wavelengths λ) 1413 extending from one end 1411 to the other end 1412. The second exemplary opening 1420 may have a second physical length 1423 extending from one end 1421 to the other end 1422. The third exemplary opening 1430 may have a third physical length 1433 extending from one end 1431 to the other end 1432.

According to various embodiments, when feeding 1414 is executed (i.e. when a signal is transmitted, received, or transmitted and received) via a feed line crossing the first exemplary opening 1410 of the conductive area 612 according to the first example 1401, a resonance of a first frequency may be formed through the first exemplary opening 1410. When feeding 1424 is executed via a feed line crossing the second exemplary opening 1420 of the conductive area 612 according to the second example 1402, a resonance of a second frequency may be formed through the second exemplary opening 1420. When feeding 1434 is executed via a feed line crossing the third exemplary opening 1430 of the conductive area 612 according to the third example 1403, a resonance of a third frequency may be formed through the third exemplary opening 1430. For comparison of the first example 1401, the second example 1402, and the third example 1403, as illustrated, substantially the same feed structure 1400 corresponding to the first ends 1411, 1421, and 1431 may be formed.

According to various embodiments, if the first pattern of the first exemplary opening 1410, the second pattern of the second exemplary opening 1420, and the third pattern of the third exemplary opening 1430 are different from each other, but the first physical length 1413 of the first pattern, the second physical length 1423 of the second pattern, and the third physical length 1433 of the third pattern are substantially the same, the resonant frequencies of respective examples 1401, 1402, and 1403 during feeding may be substantially the same.

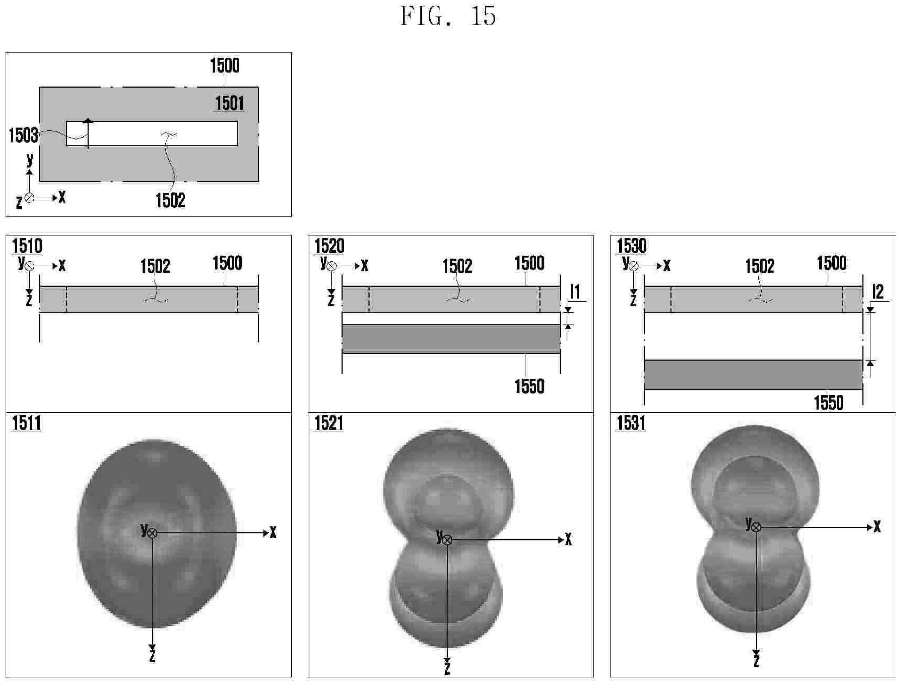

FIG. 15 shows diagrams each illustrating the electromagnetic influence of a surrounding conductive member 1550 on a slot radiator 1500 according to various embodiments of the disclosure.

Referring to FIG. 15, the slot radiator 1500 may be implemented through a conductive area 1501 (e.g., the conductive area 612 in FIG. 7) including an opening 1502 (e.g., the first opening S1 in FIG. 7) and feeding 1503 via a feed line (e.g., the first feed line FL1 in FIG. 12) crossing the opening 1502.

The first example 1510 shows the state in which the slot radiator 1500 is substantially electromagnetically isolated (or separated) from the surrounding conductive member 1550. The second example 1520 shows the state in which the surrounding conductive member 1550 is spaced apart from the slot radiator 1500 by a first distance I1. The third example 1530 shows the state in which the surrounding conductive member 1550 is spaced apart from the slot radiator 1500 by a second distance 12 larger than the first distance I1. 1511 illustrates a radiation pattern (also referred to as a beam pattern) of the slot radiator 1500 according to the first example 1510. 1521 illustrates a radiation pattern of the slot radiator 1500 according to the second example 1520. 1531 illustrates a radiation pattern of the slot radiator 1500 according to the third example 1530.

According to various embodiments, the surrounding conductive member 1550, which changes the relative position with respect to the slot radiator 1500 when the foldable electronic device 2 is switched between the unfolded state and the folded state, may take various forms such as the first display module 25 (see FIGS. 8 and 10), the hinge housing 23 (see FIGS. 8 and 10), and/or the first plate 51 (see FIGS. 8 and 10).

Compared to the first example 1510, the second example 1520 or the third example 1530 may have a radiation pattern (also referred to as a beam pattern), in which, as a result of the electromagnetic influence (e.g., reflection) of the surrounding conductive member 1550 on the slot radiator 1500, the gain (also referred to as an antenna gain) decreases in the direction from the slot radiator 1500 toward the surrounding conductive member 1550 (e.g., in the +z-axis direction) and increases in the opposite direction (e.g., in the -z-axis direction).

When comparing the second example 1520 and the third example 1530, the radiation pattern may vary depending on the separation distance between the slot radiator 1500 and the surrounding conductive member 1550.

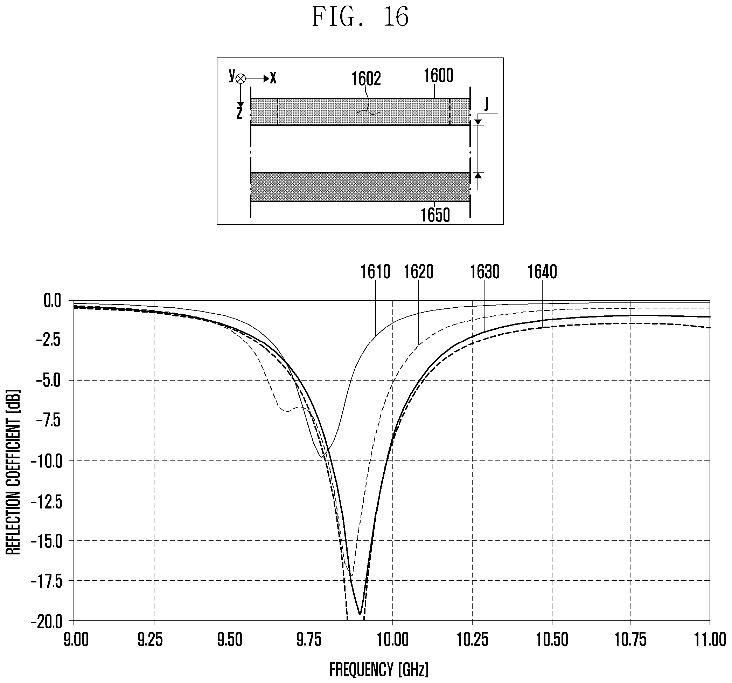

FIG. 16 shows graphs each illustrating a frequency characteristic (e.g., a reflection coefficient) depending on a separation distance J between a slot radiator 1600 and a surrounding conductive member 1650 according to various embodiments of the disclosure.

Referring to FIG. 16, 1610 illustrates a graph showing frequency characteristics of the slot radiator 1600 when the separation distance J between the slot radiator 1600 and the surrounding conductive member 1650 is about 0.5 mm. 1620 illustrates a graph showing frequency characteristics of the slot radiator 1600 when the separation distance J between the slot radiator 1600 and the surrounding conductive member 1650 is about 1.0 mm. 1630 illustrates a graph showing frequency characteristics of the slot radiator 1600 when the separation distance J between the slot radiator 1600 and the surrounding conductive member 1650 is about 1.5 mm. 1640 illustrates a graph showing frequency characteristics of the slot radiator 1600 when the separation distance J between the slot radiator 1600 and the surrounding conductive member 1650 is about 2.0 mm.

Referring to 1610, 1620, 1630, and 1640, the resonant frequency may vary depending on the separation distance J between the slot radiator 1600 and the surrounding conductive member 1650. As the separation distance J between the slot radiator 1600 and the surrounding conductive member 1650 decreases, the resonant frequency of the slot radiator 1600 during feeding may also decrease. As the separation distance J between the slot radiator 1600 and the surrounding conductive member 1650 decreases, the surrounding conductive member 1650 may have a relatively greater influence on the impedance of the slot radiator 1600.

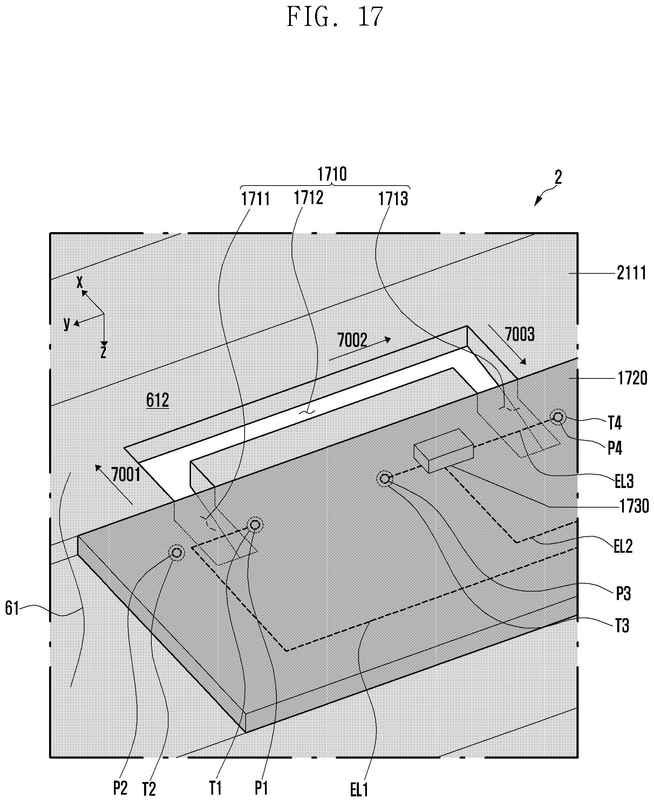

FIG. 17 shows a perspective view of a portion of the foldable electronic device 2 according to various embodiments of the disclosure.

Referring to FIG. 17, the foldable electronic device 2 may include a first bracket 2111, a third printed circuit board 1720 (e.g., the third printed circuit board 83 in FIG. 8), and a third matching circuit 1730.

According to various embodiments, the first bracket 2111 may include an opening (e.g., a slot or a slit) 1710 provided (or formed) in a conductive area 612 at least partially included in the first portion 61.

According to various embodiments, the opening 1710 may include a first partial opening 1711, a second partial opening 1712, and a third partial opening 1713. When viewed from above the first cover 212 (see FIG. 8), the first partial opening 1711 may extend in a first direction 7001 (e.g., the +x-axis direction). When viewed from above the first cover 212 (see FIG. 8), the second partial opening 1712 may extend from the first partial opening 1711 in a second direction 7002 (e.g., the -y-axis direction). When viewed from above the first cover 212 (see FIG. 8), the third partial opening 1713 may extend from the second partial opening 1712 in a third direction 7003 (e.g., the -x-axis direction) opposite to the first direction 7001. When viewed from above the first cover 212 (see FIG. 8), the first partial opening 1711 and the third partial opening 1713 may extend from one end and the other end of the second partial opening 1712, respectively.

According to various embodiments, the third printed circuit board 1720 may be disposed on or coupled to the first portion 61 of the first bracket 2111. For example, when viewed from above the first cover 212 (see FIG. 8), the third printed circuit board 1720 may overlap the first partial opening 1711 and the third partial opening 1713 of the opening 1710.

According to various embodiments, the third printed circuit board 1720 may include a first terminal T1, a second terminal T2, a third terminal T3, and/or a fourth terminal T4. The first terminal T1, the second terminal T2, the third terminal T3, and the fourth terminal T4 may be disposed on a fourth surface (e.g., the fourth surface 832 in FIG. 8) of the third printed circuit board 1720 facing the first bracket 1211.

According to various embodiments, the first terminal T1 may be electrically connected to a first point P1 on the conductive area 612 via a first flexible conductor (or first conductive adhesive material) (e.g., the first flexible conductor (or first conductive adhesive material) 1316 in FIG. 13) disposed between the first terminal T1 and the conductive area 612. For example, the first terminal T1 may be the first feed terminal FT1 in FIG. 13, and the first point P1 may be the first feed point FP1 in FIG. 13.

According to various embodiments, the second terminal T2 may be electrically connected to a second point P2 on the conductive area 612 via a second flexible conductor (or second conductive adhesive material) (e.g., the second flexible conductor (or second conductive adhesive material) 1317 in FIG. 13) disposed between the second terminal T2 and the conductive area 612. For example, the second terminal T2 may be the first ground terminal GT1 in FIG. 13, and the second point P2 may be the first ground point GP1 in FIG. 13. The second terminal T2 may be electrically connected to a ground area included in the third printed circuit board 1720.

According to various embodiments, the third terminal T3 may be electrically connected to a third point P3 on the conductive area 612 via a third flexible conductor (or a third conductive adhesive material) disposed between the third terminal T3 and the conductive area 612.

According to various embodiments, the fourth terminal T4 may be electrically connected to a fourth point P4 on the conductive area 612 via a fourth flexible conductor (or a fourth conductive adhesive material) disposed between the fourth terminal T4 and the conductive area 612.

According to various embodiments, the third printed circuit board 1720 may include a first electrical path EL1. The first electrical path EL1 may electrically interconnect the first terminal T1 and the connector (e.g., the connector 1100 in FIG. 12). The first electrical path EL1 may be, for example, the first feed line FL1 in FIG. 12.

According to various embodiments, when viewed from above the first cover 212 (see FIG. 8), the first electrical path EL1 may extend across the first partial opening 1711 of the opening 1710 of the conductive area 612. A wireless communication circuit (e.g., the wireless communication module 192 in FIG. 1) disposed on the first printed circuit board 81 (see FIG. 8) may provide (or feed) an electromagnetic signal (or a radio signal, an RF signal, or a radiation current) to the first point P1 of the conductive area 612 via the first electrical path EL1 of the third printed circuit board 1720. When an electromagnetic signal is provided (or fed) to the first point P1, an electromagnetic field (also referred to as a radiation field) that resonates the opening 1710 of the conductive area 612 may be generated due to a potential difference or impedance difference between the first point P1 and the second point P2 of the conductive area 612. When an electromagnetic signal is provided (or fed) to the first point P1, energy of a selected or predetermined frequency band may be substantially concentrated at the opening 1710. When an electromagnetic signal is provided (or fed) to the first point P1, the wireless communication circuit may substantially transmit electromagnetic waves to the outside or receive electromagnetic waves from the outside through the opening 1710.

According to various embodiments, the third printed circuit board 1720 may include a third electrical path EL3. The third electrical path EL3 may electrically interconnect the third terminal T3 and the fourth terminal T4.

According to various embodiments, when viewed from above the first cover 212 (see FIG. 8), the third electrical path EL3 may cross the third partial opening 1713 of the opening 1710 of the conductive area 612. When viewed from above the first cover 212 (see FIG. 8), for example, the third terminal T3 and the fourth terminal T4 may be located on opposite sides with the third partial opening 1713 interposed therebetween. In various embodiments, the relative position between the third terminal T3 and the fourth terminal T4 may also vary.

According to various embodiments, the foldable electronic device 2 may include a third matching circuit disposed on the third printed circuit board 1720. The third matching circuit 1730 may be disposed on the third electrical path EL3 or electrically connected to the third electrical path EL3.

According to various embodiments, the third printed circuit board 1720 may include a second electrical path EL2. The second electrical path EL2 may electrically interconnect the third matching circuit 1730 and the connector (e.g., the connector 1100 in FIG. 12).

According to various embodiments, a processor (e.g., the processor 120 in FIG. 1) or a wireless communication circuit (e.g., the wireless communication module 192 in FIG. 1) disposed on the first printed circuit board 81 (see FIG. 8) may control the third matching circuit 1730 depending on whether the foldable electronic device 2 is in the unfolded state or the folded state. When the foldable electronic device 2 is switched from the folded state to the unfolded state, the processor or the wireless communication circuit may provide a first control signal (e.g., a first digital signal) regarding the unfolded state of the foldable electronic device 2 to the second electrical path EL2. The third electrical path EL3 crossing the third partial opening 1713 may electromagnetically influence the slot antenna (or slot antenna structure), which is configured with the combination of the conductive area 612 and the third printed circuit board 1720, so that the slot antenna resonates in a selected or predetermined frequency band when the electronic device 2 is in the unfolded state, according to the operation of the third matching circuit 1730 responding to the first control signal. When the foldable electronic device 2 is switched from the unfolded state to the folded state, the processor or the wireless communication circuit may provide a second control signal (e.g., a second digital signal) regarding the folded state of the foldable electronic device 2 to the second electrical path EL2. The third electrical path EL3 crossing the third partial opening 1713 may electromagnetically influence the slot antenna, so that the slot antenna resonates in a selected or predetermined frequency band when the foldable electronic device 2 is in the unfolded state, according to the operation of the third matching circuit 1730 responding to the second control signal.

According to various embodiments, the third matching circuit 1730 may adjust a time constant affecting the slot antenna under the control of the processor (e.g., the processor 120 in FIG. 1) or the wireless communication circuit (e.g., the wireless communication module 192 in FIG. 1). The third matching circuit 1730 may include, for example, a switching circuit or a tuner.

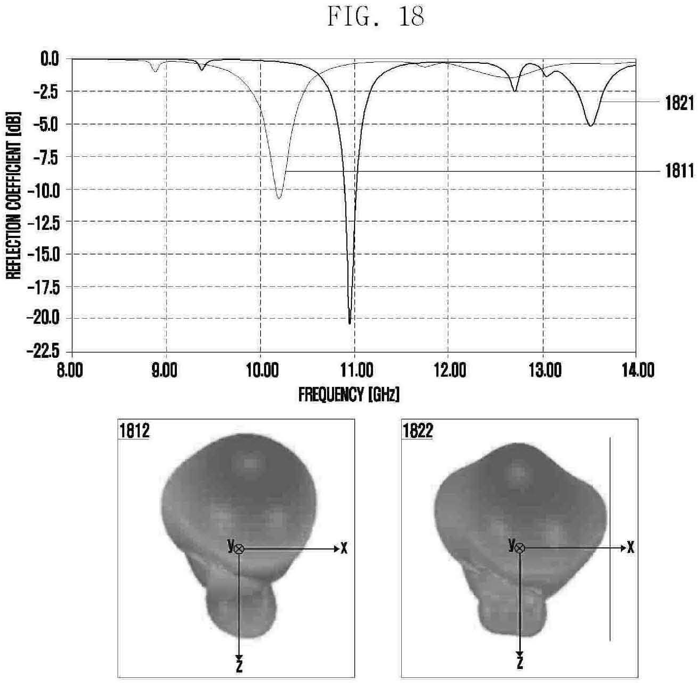

FIG. 18 shows graphs and radiation patterns each illustrating a frequency characteristic (e.g., a reflection coefficient) of a slot antenna when a foldable electronic device of a comparative example, in which the third matching circuit 1730, the third electrical path EL3 and the fourth electrical path EL4 in FIG. 17 are omitted, is in the unfolded state or the folded state.

Referring to FIG. 18, graph 1811 illustrates a graph showing the frequency characteristic of the slot antenna when the foldable electronic device of the comparative example is in the unfolded state. Graph 1821 illustrates a graph showing the frequency characteristic of the slot antenna when the foldable electronic device of the comparative example is in the folded state. Graph 1812 illustrates a radiation pattern radiated from the slot antenna when the foldable electronic device of the comparative example is in the unfolded state. Graph 1822 illustrates a radiation pattern radiated from the slot antenna when the foldable electronic device of the comparative example is in the folded state.

Referring to graphs 1811 and 1812, the resonant frequencies of the slot antenna may change depending on whether the foldable electronic device of the comparative example is in the unfolded state or the folded state. Referring to graphs 1812 and 1822, the radiation patterns radiated from the slot antenna may change depending on whether the foldable electronic device of the comparative example is in the unfolded state or the folded state. The third matching circuit 1730, the third electrical path EL3, and the fourth electrical path E4 according to the example of FIG. 17 can reduce the difference between the resonant frequency of the slot antenna when the foldable electronic device 2 is in the unfolded state and the resonant frequency of the slot antenna when the foldable electronic device 2 is in the folded state. The third matching circuit 1730, the third electrical path EL3, and the fourth electrical path E4 according to the example of FIG. 17 can reduce the difference between the radiation pattern of the slot antenna when the foldable electronic device 2 is in the unfolded state and the radiation pattern of the slot antenna when the foldable electronic device 2 is in the folded state.

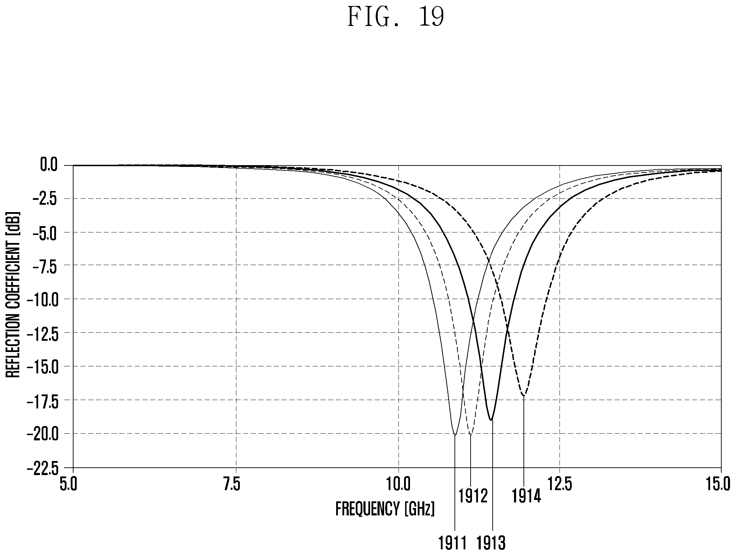

FIG. 19 shows graphs 1911, 1912, 1913, and 1914 each illustrating a frequency characteristic (e.g., a reflection coefficient) of a slot antenna according to the time constants of the third matching circuit 1730 of FIG. 17, according to various embodiments of the disclosure.

Referring to FIG. 19, the third matching circuit 1730 of FIG. 17 may adjust the resonant frequency of a slot antenna by adjusting a time constant affecting the slot antenna under the control of a processor (e.g., the processor 120 in FIG. 1) or a wireless communication circuit (e.g., the wireless communication module 192 in FIG. 1).

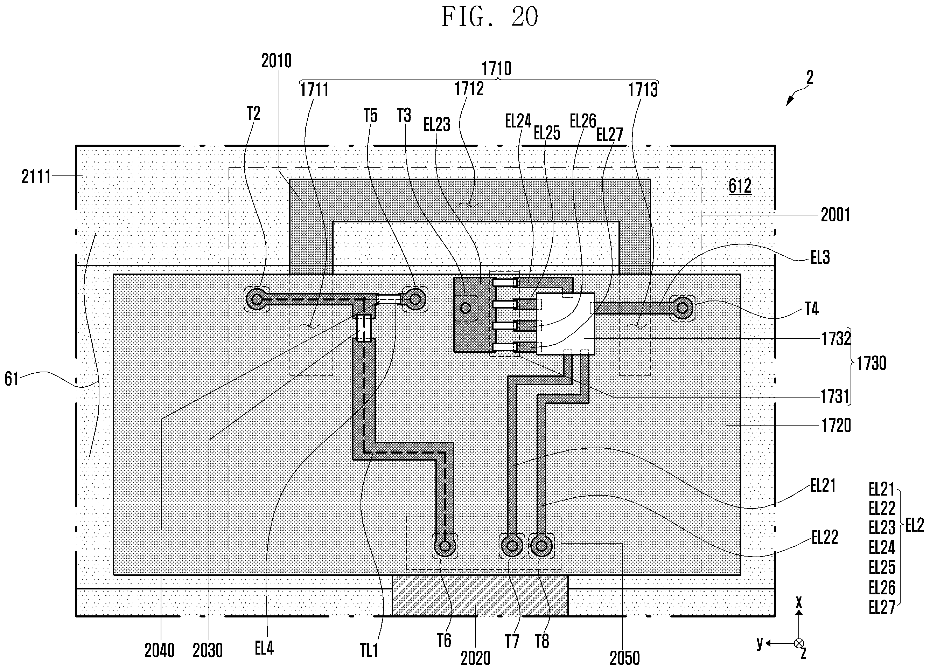

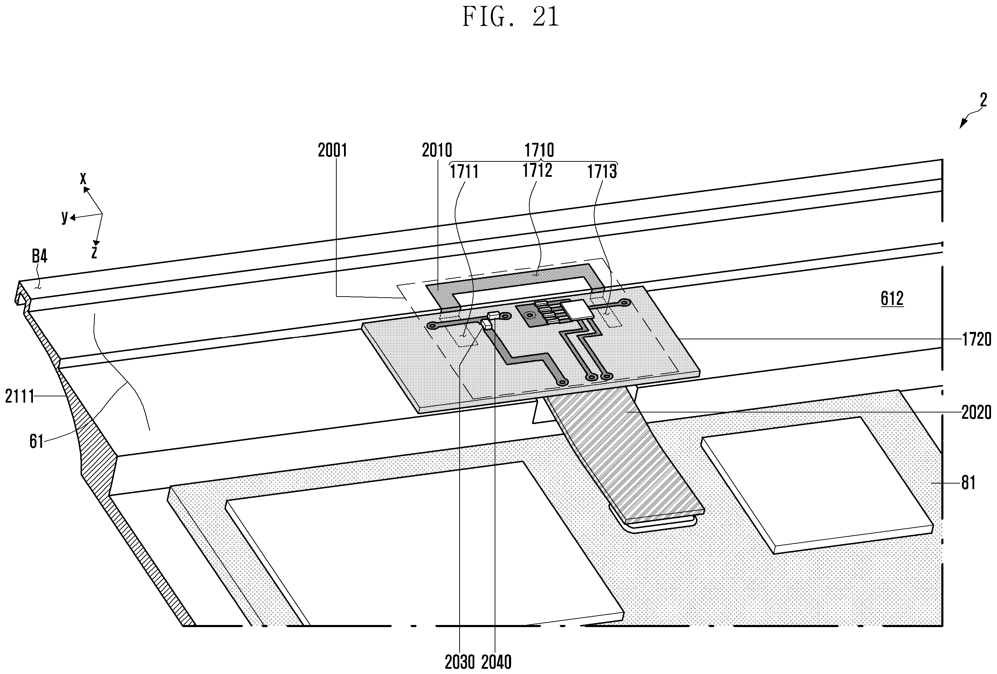

FIG. 20 shows a view illustrating a portion of a foldable electronic device 2 according to various embodiments of the disclosure. FIG. 21 shows a perspective view of a portion of the foldable electronic device 2 according to various embodiments of the disclosure.

Referring to FIGS. 20 and 21, the foldable electronic device 2 may include a first bracket 2111, a third printed circuit board 1720 (e.g., the third printed circuit board 83 in FIG. 8), a first matching circuit 2030, a second matching circuit 2040, and/or a third matching circuit 1730. Descriptions of some components that are indicated by the same reference numerals as those illustrated in FIG. 17 will be omitted.

According to various embodiments, the first bracket 2111 may include an opening (e.g., a slot or a slit) 1710 provided (or formed) in a conductive area 612 at least partially included in the first portion 61.

According to various embodiments, the first bracket 2111 may include a non-conductive portion 2010 (e.g., the non-conductive portion 1001 in FIG. 8) at least partially disposed in the opening 1710.

According to various embodiments, the third printed circuit board 1720 may be disposed on or coupled to the first portion 61 of the first bracket 2111. For example, when viewed from above the first cover 212 (see FIG. 8), the third printed circuit board 1720 may overlap the first partial opening 1711 and the third partial opening 1713 of the opening 1710.

According to various embodiments, the third printed circuit board 1720 may include a first terminal T1, a second terminal (e.g., the first ground terminal GP1 in FIG. 13 or the second terminal T2 in FIG. 17), a third terminal T3, a fourth terminal T4, a fifth terminal T5, a sixth terminal T6, a seventh terminal T7, and/or an eighth terminal T8. For example, the first terminal T1, the second terminal, the third terminal T3, the fourth terminal T4, the fifth terminal T5, the sixth terminal T6, the seventh terminal T7, and/or the eighth terminal T8 may be disposed on a fourth surface (e.g., the fourth surface 832 in FIG. 8) of the third printed circuit board 1720 facing the first bracket 1211.

According to various embodiments, the first terminal T1 (e.g., the first feed terminal FT1 in FIG. 13) may be electrically connected to the conductive area 612 of the first portion 61 via a first flexible conductor (or first conductive adhesive material) (e.g., the first flexible conductor (or first conductive adhesive material) 1316 in FIG. 13) disposed between the first terminal T1 and the first portion 61.

According to various embodiments, the second terminal T1 (e.g., the first ground terminal GP1 in FIG. 13 or the second terminal T2 in FIG. 17) may be electrically connected to the conductive area 612 of the first portion 61 via a second flexible conductor (or second conductive adhesive material) (e.g., the second flexible conductor (or second conductive adhesive material) 1317 in FIG. 13) disposed between the second terminal T1 and the first portion 61.

According to various embodiments, the third terminal T3 may be electrically connected to the conductive area 612 of the first portion 61 via a third flexible conductor (or a third conductive adhesive material) disposed between the third terminal T3 and the first portion 61.

According to various embodiments, the fourth terminal T4 may be electrically connected to the conductive area 612 of the first portion 61 via a fourth flexible conductor (or a fourth conductive adhesive material) disposed between the fourth terminal T4 and the first portion 61.

According to various embodiments, the fifth terminal T5 may be electrically connected to a fifth point on the conductive area 612 of the first portion 61 via a fifth flexible conductor (or a fifth conductive adhesive material) disposed between the fifth terminal T5 and the first portion 61.

According to various embodiments, the sixth terminal T6, the seventh terminal T7, and the eighth terminal T8 may be electrically connected to a connector (or a receptacle) 2050 (e.g., the connector 1100 in FIG. 12) disposed on a fourth surface (e.g., the fourth surface 832 in FIG. 8) of the third printed circuit board 1720.

According to various embodiments, when the connector 2050 is disposed on a third surface (e.g., the third surface 831 in FIG. 8) of the third printed circuit board 1720, the sixth terminal T6, the seventh terminal T7, and the eighth terminal T8 may be disposed on a third surface (e.g., the third surface 831 in FIG. 8) of the third printed circuit board 1720.

According to various embodiments, the third printed circuit board 1720 may include a first electrical path EL1 (e.g., the first feed line FL1 in FIG. 12). The first electrical path EL1 may electrically interconnect the first terminal T1 and the sixth terminal T6.

According to various embodiments, when viewed from above the first cover 212 (see FIG. 8), the first electrical path EL1 may cross the first partial opening 1711 of the opening 1710 of the conductive area 612. A wireless communication circuit (e.g., the wireless communication module 192 in FIG. 1) disposed on the first printed circuit board 81 may provide (or feed) an electromagnetic signal (or a radio signal, an RF signal, or a radiation current) to the conductive area 612 via the first electrical path EL1 of the third printed circuit board 1720. When an electromagnetic signal is provided (or fed) to the conductive area 612, an electromagnetic field that resonates the opening 1710 of the conductive area 612 may be provided (or formed).

According to various embodiments, the first matching circuit 2030 may be disposed on the third printed circuit board 1720. For example, the first matching circuit 2030 may be disposed on the first electrical path EL1 or electrically connected to the first electrical path EL1.

According to various embodiments, the third printed circuit board 1720 may include a fourth electrical path EL4. The fourth electrical path EL4 may electrically interconnect the fifth terminal T5 and the first electrical path El1.

According to various embodiments, the second matching circuit 2040 may be disposed on the third printed circuit board 1720. For example, the second matching circuit 2040 may be disposed on the fourth electrical path EL4 or electrically connected to the fourth electrical path EL4.

According to various embodiments, the first matching circuit 2030 and/or the second matching circuit 2040 may shift the resonant frequency of the slot antenna, which is configured with a combination of the conductive area 612 and the third printed circuit board 1720, to a predetermined frequency or by a predetermined amount.

According to various embodiments, the first matching circuit 2030 and/or the second matching circuit 2040 may match the impedance of the first electrical path EL1 and the impedance of the slot antenna.

According to various embodiments, the first matching circuit 2030 and/or the second matching circuit 2040 may include electrical elements having a component such as inductance, capacitance, or conductance. For example, the first matching circuit 2030 and/or the second matching circuit 2040 may include various elements, such as lumped elements or passive elements.

According to various embodiments, the third printed circuit board 1720 may include a second electrical path EL2. The second electrical path EL2 may include multiple electrical paths EL21, EL22, EL23, EL24, EL25, EL26, and EL27 between the third terminal T3 and the connector 2050.

According to various embodiments, the third matching circuit 1730 may be disposed on the second electrical path EL2 or electrically connected to the second electrical path EL2.

According to various embodiments, the third matching circuit 1730 may include multiple lumped elements 1731 and a switching circuit (also referred to as a switching element or switching module) (or tuner) 1732.

According to various embodiments, one electrical path EL21 among the multiple electrical paths EL21, EL22, EL23, EL24, EL25, EL26, and EL27 included in the second electrical path EL2 may electrically interconnect the switching circuit 1732 and the seventh terminal T7. Another electrical path EL22 among the multiple electrical paths EL21, EL22, EL23, EL24, EL25, EL26, and EL27 may electrically interconnect the switching circuit 1732 and the eighth terminal T8. Another electrical path EL23 among the multiple electrical paths EL21, EL22, EL23, EL24, EL25, EL26, and EL27 may be electrically connected to the third terminal T3. Among the multiple electrical paths EL21, EL22, EL23, EL24, EL25, EL26, and EL27, the remaining electrical paths EL24, EL25, EL26, and EL27 may electrically interconnect the multiple lumped elements 1731 and the switching circuit 1732, and may be electrically connected, via the multiple lumped elements 1731, to one electrical path EL23 that is electrically connected to the third terminal T3.

According to various embodiments, the third printed circuit board 1720 may include a third electrical path EL3. The third electrical path EL3 may electrically interconnect the switching circuit 1732 and the fourth terminal T4.

According to various embodiments, the third printed circuit board 1720 may be electrically connected to the first printed circuit board 81 via a flexible circuit board 2020. One end of the flexible printed circuit board 2020 may be electrically connected to a connector 2050 disposed on the third printed circuit board 1720, and the other end of the flexible printed circuit board 2020 may be electrically connected to the first printed circuit board 81 through the connector connection.

According to various embodiments, a processor (e.g., the processor 120 in FIG. 1) or a wireless communication circuit (e.g., the wireless communication module 192 in FIG. 1) disposed on the first printed circuit board 81 may provide a control signal to the switching circuit 1732 via the electrical path EL21 electrically connected to the seventh terminal T7 and/or the electrical path EL22 electrically connected to the eighth terminal T8. The switching circuit 1732 may selectively electrically connect or disconnect multiple electrical paths (EL24, EL25, EL26, and EL27 included in the second electrical path EL2 to the third electrical path EL3 in response to a control signal. According to the selective electrical connection or disconnection between the multiple electrical paths EL24, EL25, EL26, and EL27 and the third electrical path EL3 due to the switching circuit 1732, element values(e.g., time constants) such as inductance, capacitance, and/or conductance acting on the third electrical path EL3 where at least some of the multiple lump elements 1731 are arranged across the third partial opening 1713 may be changed.

According to various embodiments, when the foldable electronic device 2 is switched from the folded state to the unfolded state, the processor (e.g., the processor 120 in FIG. 1) or the wireless communication circuit (e.g., the wireless communication module 192 in FIG. 1) may provide a first control signal (e.g., a first digital signal) regarding the unfolded state of the foldable electronic device 2 to the electrical path EL21 electrically connected to the seventh terminal T7 and/or the electrical path EL22 electrically connected to the eighth terminal T8. The third electrical path EL3 crossing the third partial opening 1713 included in the opening 1710 of the conductive area 1710 may electromagnetically influence the slot antenna with a selective component value (e.g., inductance, capacitance, and/or conductance) from the third matching circuit 1730 according to the operation of a switching circuit 1732 responding to the first control signal, thereby allowing the slot antenna to resonate in a selected or predetermined frequency band.

According to various embodiments, when the foldable electronic device 2 is switched from the unfolded state to the folded state, the processor (e.g., the processor 120 in FIG. 1) or the wireless communication circuit (e.g., the wireless communication module 192 in FIG. 1) may provide a second control signal (e.g., a second digital signal) regarding the folded state of the foldable electronic device 2 to the electrical path EL21 electrically connected to the seventh terminal T7 and/or the electrical path EL22 electrically connected to the eighth terminal T8. The third electrical path EL3 crossing the third partial opening 1713 included in the opening 1710 of the conductive area 1710 may electromagnetically influence the slot antenna, which uses the opening 1710 of the conductive area 612, with a selective component value (e.g., inductance, capacitance, and/or conductance) from the third matching circuit 1730 according to the operation of the switching circuit 1732 responding to the second control signal, thereby allowing the slot antenna to resonate in a selected or predetermined frequency band.

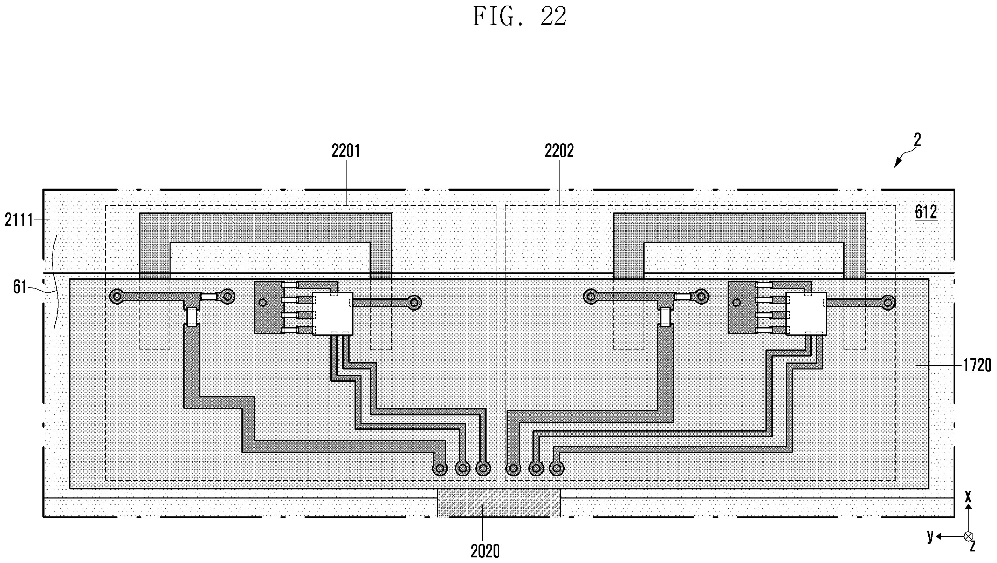

FIG. 22 shows a view illustrating a portion of a foldable electronic device 2 according to various embodiments of the disclosure.

Referring to FIG. 22, the foldable electronic device 2 may include a slot antenna or slot antenna structure configured with a combination of a conductive area 612 and a third printed circuit board 1720. The slot antenna may include a first slot radiator 2201 and a second slot radiator 2202. The first slot radiator 2201 and the second slot radiator 2202 may be formed substantially in the same manner as the slot radiator 2001 using the opening 1710 in FIGS. 20 and 21. The third printed circuit board 1720 may be provided (or formed) in an integral or single form corresponding to the first slot radiator 2201 and the second slot radiator 2202.

According to various embodiments, the foldable electronic device 2 may be implemented to include more slot radiators than the example of FIG. 22.

According to various embodiments, a combination of multiple slot radiators may be implemented as an antenna array configured to transmit and/or receive a signal in a selected or predetermined frequency band.

According to various embodiments, any two slot radiators among the multiple slot radiators may be implemented to have different resonant frequencies. A wireless communication circuit (e.g., the wireless communication module 192 in FIG. 1) may be configured to transmit and/or receive signals of different frequency bands, respectively, through any two slot radiators among the multiple slot radiators.

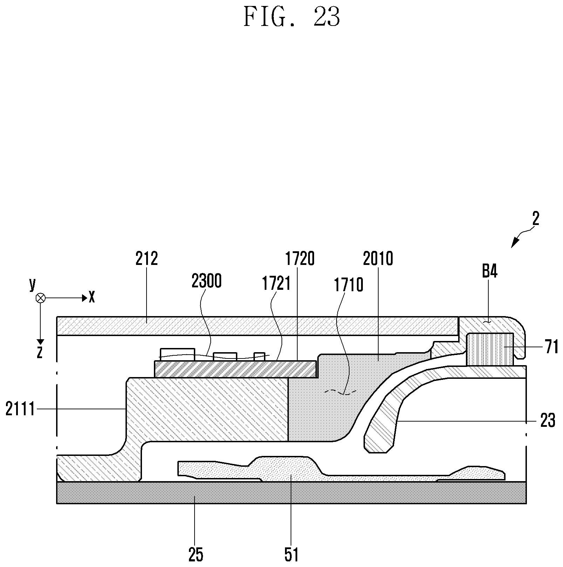

FIG. 23 shows a cross-sectional view of a portion of a foldable electronic device 2 according to various embodiments of the disclosure.

Referring to FIG. 23, the foldable electronic device 2 may include a first display module 25, a first cover 212, a hinge housing 23, a first plate 51, a first foreign matter prevention member 71, a fourth side surface portion B4, a first bracket 2111 including an opening 1710, a non-conductive portion 2010, and/or a third printed circuit board 1720. Descriptions of some components that have the same reference numerals as those illustrated in FIGS. 7, 8, 9, 10, 11, 12, 20, and 21 will be omitted.

According to various embodiments, the foldable electronic device 2 may include multiple electronic components 2300 disposed on the third surface 1721 (e.g., the third surface 831 in FIG. 8) of the third printed circuit board 1720. The multiple electronic components 2300 may include, for example, the connector 2050, the first matching circuit 2030, the second matching circuit 2040, and/or the third matching circuit 1730 in FIG. 20.

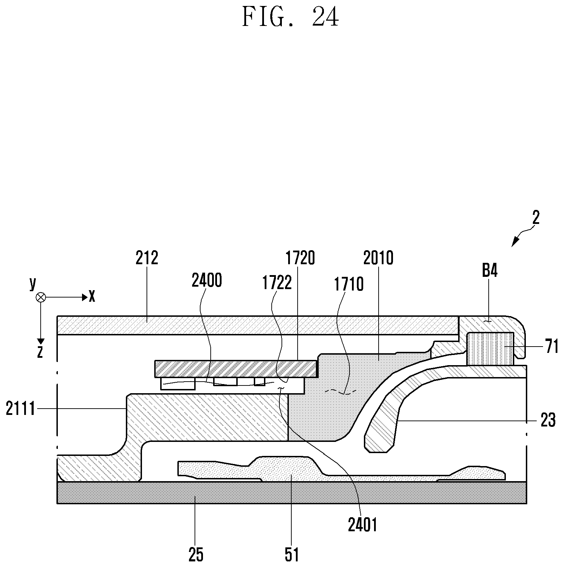

FIG. 24 shows a cross-sectional view of a portion of a foldable electronic device 2 according to various embodiments of the disclosure.

Referring to FIG. 24, the foldable electronic device 2 may include a first display module 25, a first cover 212, a hinge housing 23, a first plate 51, a first foreign matter prevention member 71, a fourth side surface portion B4, a first bracket 2111 including an opening 1710, a non-conductive portion 2010, and/or a third printed circuit board 1720. Descriptions of some components that have the same reference numerals as those illustrated in FIGS. 7, 8, 9, 10, 11, 12, 20, and 21 will be omitted.

According to various embodiments, the foldable electronic device 2 may include multiple electronic components 2400 disposed on the fourth surface 1722 (e.g., the fourth surface 832 in FIG. 8) of the third printed circuit board 1720. The multiple electronic components 2400 may include, for example, the connector 2050, the first matching circuit 2030, the second matching circuit 2040, and/or the third matching circuit 1730 in FIG. 20.

According to various embodiments, the first bracket 2111 may include a recess 2401 that accommodates the multiple electronic components 2400.

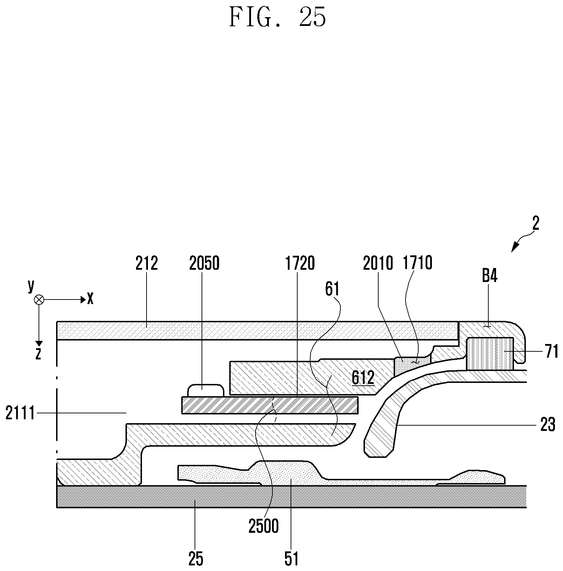

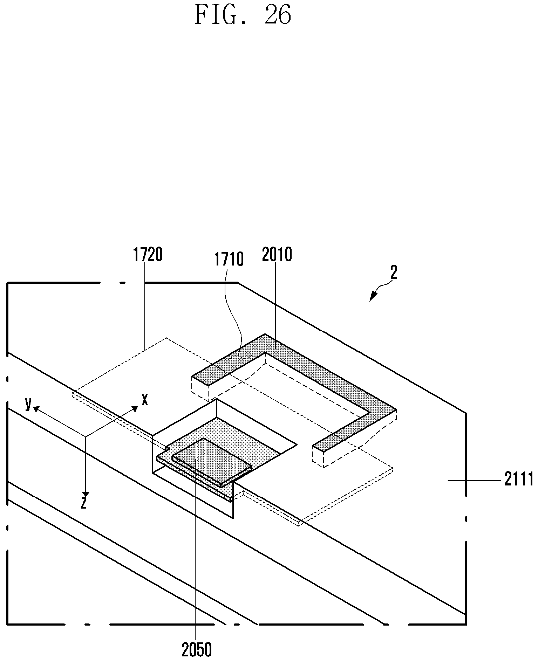

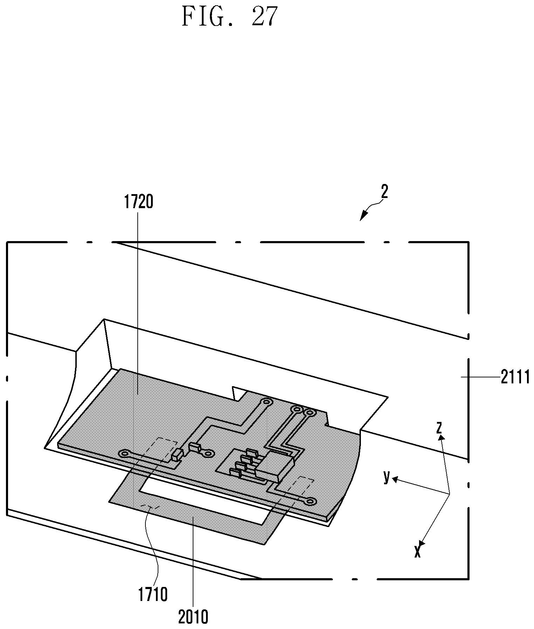

FIG. 25 shows a cross-sectional view of a portion of a foldable electronic device 2 according to various embodiments of the disclosure. FIG. 26 shows a perspective view of a portion of the foldable electronic device 2 according to various embodiments of the disclosure. FIG. 27 shows a perspective view of a portion of the foldable electronic device 2 according to various embodiments of the disclosure.

Referring to FIGS. 25, 26, and 27, the foldable electronic device 2 may include a first display module 25, a first cover 212, a hinge housing 23, a first plate 51, a first foreign matter prevention member 71, a fourth side surface portion B4, a first bracket 2111 including an opening 1710, a non-conductive portion 2010, and/or a third printed circuit board 1720. Descriptions of some components that have the same reference numerals as those illustrated in FIGS. 7, 8, 9, 10, 11, 12, 20, and 21 will be omitted.

According to various embodiments, the third printed circuit board 1720 may be located in a through hole 2500 provided (or formed) in the first portion 61 of the first bracket 2111. A portion of the third printed circuit board 1720 may be located inside the first portion 61, and another portion of the third printed circuit board 1720 on which the connector 2050 is positioned may be exposed outside the first bracket 2111.

In various embodiments, the opening 1710 included in the first portion 61 of the first bracket 2111 may be located closer to the first cover 212 than the third printed circuit board 1720. When viewed from above the first cover 212, the third printed circuit board 1720 may overlap the opening 1710 of the first portion 61. The third printed circuit board 1720 may be electrically connected to the conductive area 612 of the first portion 61. For example, the first terminal T1, the second terminal (e.g., the first ground terminal GP1 in FIG. 13 or the second terminal T2 in FIG. 17), the third terminal T3, the fourth terminal T4, the fifth terminal T5, the sixth terminal T6, the seventh terminal T7, and/or the eighth terminal T8 in FIG. 20 included in the third printed circuit board 1720 may be arranged on the third surface (e.g., the third surface 832 in FIG. 8) of the third printed circuit board 1720 facing the first bracket 1211.

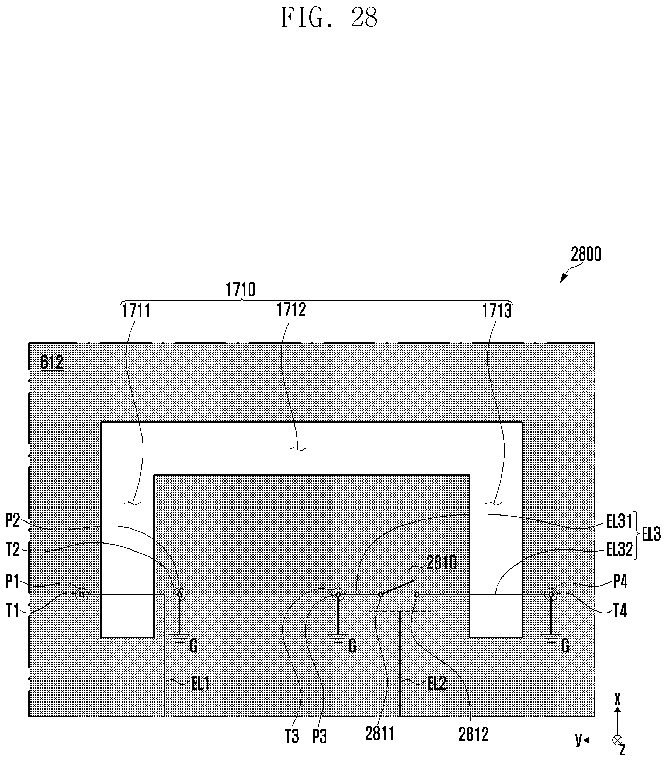

FIG. 28 shows a view illustrating a slot antenna 2800 according to various embodiments of the disclosure.

Referring to FIG. 28, the slot antenna 2800 may include a conductive area 612, a first terminal T1, a second terminal T2, a third terminal T3, a fourth terminal T4, a first electrical path EL1, a second electrical path EL2, a third electrical path EL3, and/or a switching circuit 2810. Descriptions of some components that have the same reference numerals as those illustrated in FIGS. 17 and 20 will be omitted.

According to various embodiments, the switching circuit 2810 may be disposed on the third electrical path EL3 or electrically connected to the third electrical path EL3. The switching circuit 2810 may be included, for example, in the third matching circuit 1730 in FIG. 17.

According to various embodiments, the third electrical path EL3 may include a first partial electrical path EL31 and a second partial electrical path EL32. The first partial electrical path EL31 may electrically interconnect the third terminal T3 and a first contact 2811 of the switching circuit 2810. The second partial electrical path EL32 may electrically interconnect the fourth terminal T4 and a second contact 2812 of the switching circuit 2810. The second partial electrical path EL32 may be disposed across the third partial opening 1713. When the switching circuit 2810 electrically disconnects the first contact 2811 and the second contact 2812 in response to a control signal, the first partial electrical path EL31 and the second partial electrical path EL32 may be electrically disconnected. When the switching circuit 2810 electrically interconnects the first contact 2811 and the second contact 2812 in response to a control signal, the first partial electrical path EL31 and the second partial electrical path EL32 may be electrically connected.

According to various embodiments, a processor (e.g., the processor 120 in FIG. 1) or a wireless communication circuit (e.g., the wireless communication module 192 in FIG. 1) disposed on the first printed circuit board 81 (see FIG. 8) may control the switching circuit 2810 depending on whether the foldable electronic device 2 is in the unfolded state or the folded state. When the foldable electronic device 2 is switched from the folded state to the unfolded state, the processor or the wireless communication circuit may provide a first control signal regarding the unfolded state of the foldable electronic device 2 to the second electrical path EL2. When the foldable electronic device 2 is switched from the unfolded state to the folded state, the processor or the wireless communication circuit may provide a second control signal regarding the folded state of the foldable electronic device 2 to the second electrical path EL2.

According to various embodiments, the switching circuit 2810 may electrically interconnect the first contact 2811 and the second contact 2812 in response to the first control signal, and the third electrical path EL3 may electromagnetically influence the slot antenna 2800 so that the slot antenna 2800 resonates in a selected or predetermined frequency band when the foldable electronic device 2 is in the unfolded state. The switching circuit 2810 may electrically disconnect the first contact 2811 and the second contact 2812 in response to the second control signal, and the third electrical path EL3 may substantially not have an electromagnetic influence on the slot antenna 2800 when the foldable electronic device 2 is in the folded state.

According to various embodiments, since the relative position between at least one element and the slot antenna 2800 changes when the foldable electronic device 2 is switched between the unfolded state and the folded state, the electromagnetic influence of the at least one element on the slot antenna 2800 may change. Referring to FIGS. 8, 9, and 10, for example, the relative positions of one or more elements, such as the first display module 25, the hinge housing 23, and the first plate 51, with respect to the slot antenna 2800 may change when the foldable electronic device 2 is switched between the unfolded state and the folded state. In various embodiments, the switching circuit 2810 may be controlled depending on whether the foldable electronic device 2 is in the unfolded state or the folded state, thereby reducing the difference between the antenna radiation performance of the slot antenna 2800 in the unfolded state of the foldable electronic device 2 and the antenna radiation performance of the slot antenna 2800 in the folded state of the foldable electronic device 2.

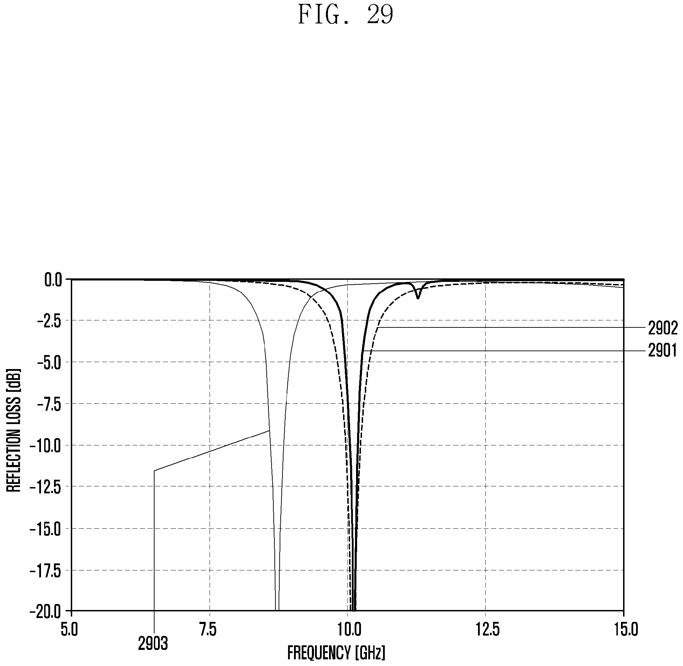

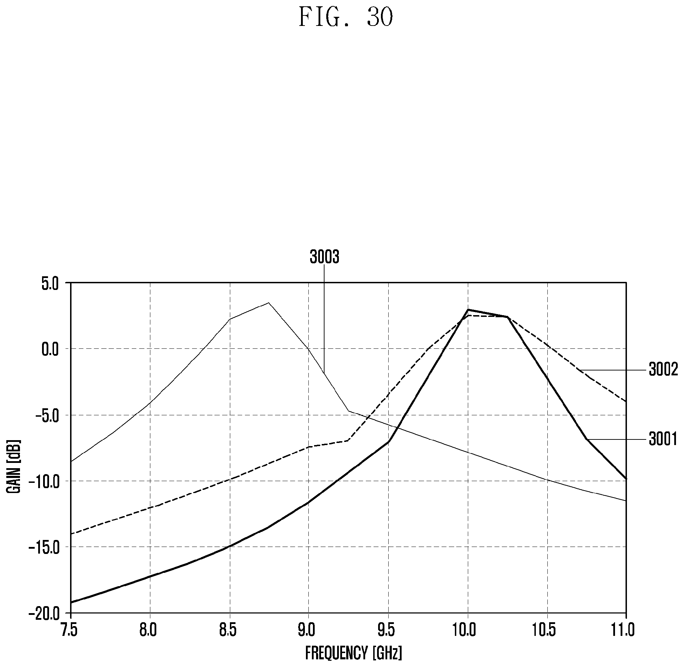

FIG. 29 shows graphs illustrating the reflection losses of the slot antenna 2800 of FIG. 28 when the switching circuit 2810 is controlled depending on whether the foldable electronic device 2 according to various embodiments of the disclosure is in the unfolded state or the folded state. FIG. 30 shows graphs illustrating gains of the slot antenna 2800 of FIG. 28 for a desired radio wave transmission/reception direction when the switching circuit 2810 is controlled depending on whether the foldable electronic device 2 according to various embodiments of the disclosure is in the unfolded state or the folded state.

Referring to FIG. 29, graph 2901 shows the reflection loss of the slot antenna 2800 in the first example where the switching circuit 2810 is configured to electrically interconnect the first contact 2811 and the second contact 2812 when the foldable electronic device 2 is in the unfolded state. Graph 2902 shows the reflection loss of the slot antenna 2800 in the second example where the switching circuit 2810 is configured to electrically disconnect the first contact 2811 and the second contact 2812 when the foldable electronic device 2 is in the folded state. Graph 2903 shows the reflection loss of the slot antenna 2800 in a comparative example where the switching circuit 2810 is configured to electrically interconnect the first contact 2811 and the second contact 2812 when the foldable electronic device 2 is in the folded state.

Referring to FIG. 30, graph 3001 shows the gain of the slot antenna 2800 in the first example where the switching circuit 2810 is configured to electrically interconnect the first contact 2811 and the second contact 2812 when the foldable electronic device 2 is in the unfolded state. Graph 3002 shows the gain of the slot antenna 2800 in the second example where the switching circuit 2810 is configured to electrically disconnect the first contact 2811 and the second contact 2812 when the foldable electronic device 2 is in the folded state. Graph 2903 shows the gain of the slot antenna 2800 in a comparative example where the switching circuit 2810 is configured to electrically interconnect the first contact 2811 and the second contact 2812 when the foldable electronic device 2 is in the folded state.

Comparing graphs 2901 and 2902, and graphs 3001 and 3002, through the switching circuit 2810, it is possible to reduce the difference between the antenna radiation performance for the operating frequency (or the usage frequency) (e.g., about 10 GHz) in the folded state of the foldable electronic device 2 and the antenna radiation performance for the operating frequency in the unfolded state of the foldable electronic device 2. In various embodiments, the antenna radiation performance obtained with the configuration in which the first contact 2811 and the second contact 2812 are disconnected when the foldable electronic device 2 is in the unfolded state can be improved by about 10 dB at the operating frequency (e.g., about 10 GHz) compared to the antenna radiation performance obtained with the configured in which the first contact 2811 and the second contact 2812 are electrically connected when the foldable electronic device 2 is in the unfolded state.

Comparing graphs 2901 and 2903, graphs 2902 and 2903, graphs 3001 and 3003, and graphs 3002 and 3003, it can be seen that, depending on whether the foldable electronic device 2 is in the unfolded state or the folded state, the switching circuit 2810 is turned on to electrically interconnect the first contact 2811 and the second contact 2812, or turned off to electrically disconnect the first contact 2811 and the second contact 2812. As a result, compared to the comparative example, the antenna radiation performance can be improved, and the difference in antenna radiation performance between the unfolded state and the folded state of the foldable electronic device 2 can be reduced.

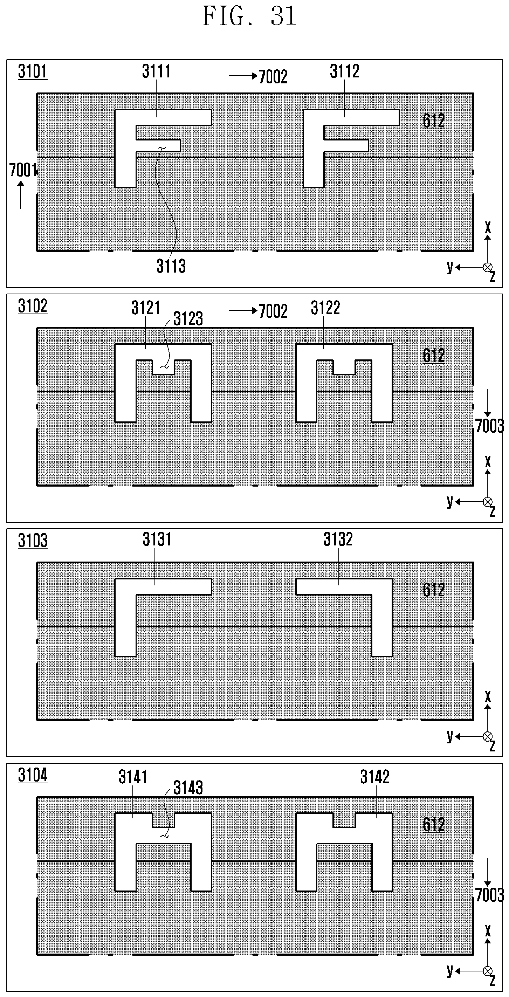

FIG. 31 shows views illustrating conductive areas 612 according to various embodiments of the disclosure.

Referring to FIG. 31, the openings included in the conductive areas 612 may be provided (or formed) in various ways, such as in first example 3101, second example 3102, third example 3103, or fourth example 3104.

According to the first example 3101, the conductive area 612 may include a first opening 3111 and a second opening 3112. When viewed from above the first cover 212 (see FIG. 8), the first opening 3111 is a modification of, for example, the first opening S1 in FIG. 1, and may further include a partial opening 3113 of a third pattern extending in a second direction 7002 (e.g., the -y-axis direction) from a first pattern (e.g., the first pattern OP1 in FIG. 7) extending in a first direction 7001 (e.g., the +x-axis direction). When viewed from above the first cover 212 (see FIG. 8), the second opening 3112 may be formed in a substantially identical form to the first opening 3111.

According to the second example 3102, the conductive area 612 may include a first opening 3121 and a second opening 3122. When viewed from above the first cover 212 (see FIG. 8), the first opening 3121 is a modification of, for example, the opening 1710 in FIG. 17, and may further include a third partial opening 3123 extending in a third direction 7003 (e.g., the -x-axis direction) from a second partial opening 1712 (see FIG. 17) extending in the second direction 7002. When viewed from above the first cover 212 (see FIG. 8), the second opening 3122 may be formed in a substantially identical form to the first opening 3121.

According to the third example 3103, the conductive area 612 may include the first opening 3131 and the second opening 3132. When viewed from above the first cover 212 (see FIG. 8), the first opening 3111 may be, for example, in the form in which the third partial opening 3113 is omitted from the first opening 3111 of the first example 3101. When viewed from above the first cover 212 (see FIG. 8), a first opening 3131 and a second opening 3132 may be provided (or formed) substantially symmetrically to each other.

According to the fourth example 3104, the conductive area 612 may include a first opening 3141 and a second opening 3142. When viewed from above the first cover 212 (see FIG. 8), the first opening 3141 may be a modification of, for example, the second partial opening 1712 of the opening 1710 in FIG. 17, and may include an area in which a portion of the conductive area 612 protrudes in a third direction 7003 (e.g., the -x-axis direction) to include a relatively narrow area 3143 of the first opening 3141 compared to other areas of the first opening 3141. When viewed from above the first cover 212 (see FIG. 8), the second opening 3142 may be formed in a substantially identical form to the first opening 3141.

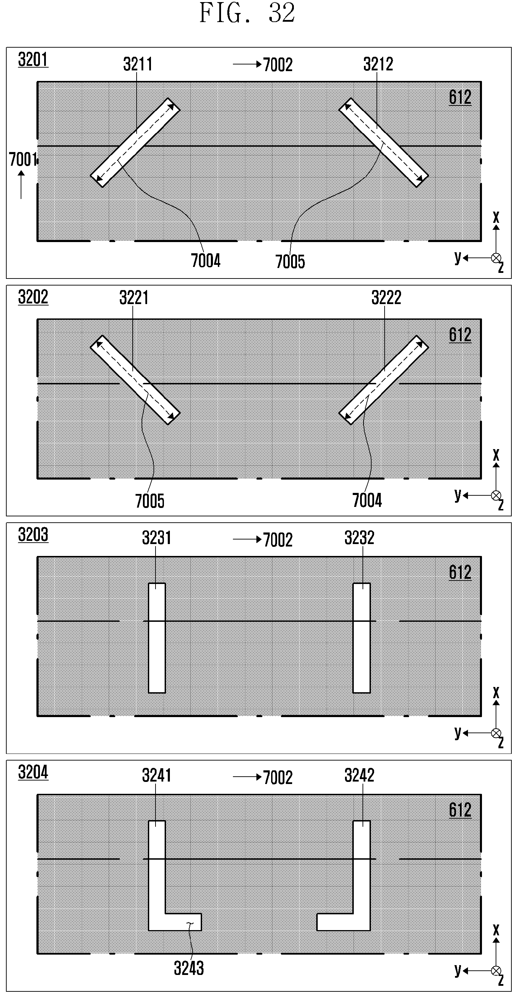

FIG. 32 shows views illustrating conductive areas 612 according to various embodiments of the disclosure.

Referring to FIG. 32, the openings included in the conductive areas 612 may be provided (or formed) in various ways, such as in fifth example 3201, sixth example 3202, seventh example 3203, or eighth example 3204.

According to the fifth example 3201, the conductive area 612 may include a first opening 3211 and a second opening 3212. When viewed from above the first cover 212 (see FIG. 8), the first opening 3211 may extend in a fourth direction 7004 that is not parallel to the first direction 7001 (e.g., the +x-axis direction) and the second direction 7002 (e.g., the -y-axis direction). When viewed from above the first cover 212 (see FIG. 8), the second opening 3212 may extend in a fifth direction 7005 that is not parallel to the first direction 7001 and the second direction 7002. The fourth direction 7004 and the fifth direction 7005 may not be parallel.

According to various embodiments, the fourth direction 7004 and the fifth direction 7005 may be substantially perpendicular to each other.

According to various embodiments, when viewed from above the first cover 212 (see FIG. 8), the first opening 3211 and the second opening 3212 may be provided (or formed) substantially symmetrically to each other.

According to various embodiments, the first slot radiator (e.g., the first slot radiator 2201 in FIG. 22) and the second slot radiator (e.g., the second slot radiator 2202 in FIG. 22), which are capable of resonating the first opening 3211 and the second opening 3212, respectively, at the time of feeding, may be provided (or formed). When fed, the first slot radiator may generate a first polarization, and the second slot radiator may generate a second polarization.

According to various embodiments, the first polarization radiated from the first slot radiator may substantially include a first linear polarization. The first linear polarization may be an electromagnetic wave that oscillates in the first polarization direction. The polarization direction may be defined or interpreted as the polarity direction of an electric field with respect to the propagation direction (or transmission direction) of an electromagnetic wave radiated (or transmitted) from the first slot radiator (e.g., the -z-axis direction where the first rear cover 212 in FIG. 8 is oriented). The polarization direction may be the direction in which an electric field oscillates (or a direction parallel to the vector of the electric field) and may be perpendicular to the propagation direction of an electromagnetic wave.

According to various embodiments, the first polarization direction of the first linear polarization radiated from the first slot radiator may be substantially perpendicular to the fourth direction 7004.

According to various embodiments, a second polarization radiated from the second slot radiator may substantially include a second linear polarization. The second linear polarization may be an electromagnetic wave that oscillates in a second polarization direction. The polarization direction may be defined or interpreted as the polarity direction of an electric field with respect to the propagation direction (or transmission direction) of an electromagnetic wave radiated (or transmitted) from the second slot radiator (e.g., the -z-axis direction where the first rear cover 212 in FIG. 8 is oriented).

According to various embodiments, the second polarization direction of the second linear polarization radiated from the second slot radiator may be substantially perpendicular to the fifth direction 7005.

According to various embodiments, at the time of feeding, the first slot radiator and the second slot radiator may be used for polarization diversity to reduce fading. At the time of feeding, the first slot radiator provides the first linear polarization having the first polarization direction, and the second slot radiator provides the second linear polarization having the second polarization direction. Therefore, compared to the comparative example configured to radiate a single-directional linear polarization, even if the polarization characteristics of a signal transmitted from a signal source or the orientation (or attitude) of the foldable electronic device 2 change, the radio transmission and reception performance (also referred to as communication performance) can be improved.

According to various embodiments, a combination of the first linear polarization provided from the first slot radiator using the first opening 3211 and the second linear polarization provided from the second slot radiator using the second opening 3212 (e.g., composite waves) may improve the performance of receiving external radio waves. According to various embodiments, a substantially circular polarization may be provided (or formed) through the synthesis of the first linear polarization and the second linear polarization. By radiating a circular polarization, the transmission and reception performance of radio waves (also referred to as communication performance) can be improved, even when the polarization characteristics of a signal transmitted from a signal source or the orientation (or attitude) of the foldable electronic device 2 change, compared to the comparative example configured to radiate a linear polarization.

According to the sixth example 3202, the conductive area 612 may include a first opening 3221 and a second opening 3222. When viewed from above the first cover 212 (see FIG. 8), the first opening 3221 may extend in a fifth direction 7005. When viewed from above the first cover 212 (see FIG. 8), the second opening 3222 may extend in a fourth direction 7004. When viewed from above the first cover 212 (see FIG. 8), the first opening 3221 and the second opening 3222 may be provided (or formed) substantially symmetrically to each other.

According to various embodiments, the first slot radiator (e.g., the first slot radiator 2201 in FIG. 22) and the second slot radiator (e.g., the second slot radiator 2202 in FIG. 22), which are capable of resonating the first opening 3221 and the second opening 3222, respectively, at the time of feeding, may be provided (or formed). When fed, the first slot radiator may generate a first polarization, and the second slot radiator may generate a second polarization.

According to various embodiments, a combination of the first polarization (e.g., the first linear polarization) provided from the first slot radiator using the first opening 3221 and the second polarization (the second linear polarization) provided from the second slot radiator using the second opening 3222 (e.g., composite waves) may improve the performance of receiving external radio waves. According to various embodiments, a substantially circular polarization may be provided (or formed) through the synthesis of the first polarization and the second polarization.

According to the seventh example 3203, the conductive area 612 may include a first opening 3231 and a second opening 3232. When viewed from above the first cover 212 (see FIG. 8), the first opening 3231 and the second opening 3232 may extend in a direction perpendicular to the second direction 7002 (e.g., the -y-axis direction). When viewed from above the first cover 212 (see FIG. 8), the first opening 3231 and the second opening 3232 may be provided (or formed) substantially symmetrically to each other.

According to various embodiments, the first slot radiator (e.g., the first slot radiator 2201 in FIG. 22) and the second slot radiator (e.g., the second slot radiator 2202 in FIG. 22), which are capable of resonating the first opening 3231 and the second opening 3232, respectively, at the time of feeding, may be provided (or formed). When fed, the first slot radiator may generate a first polarization, and the second slot radiator may generate a second polarization.

According to various embodiments, a combination of the first polarization (e.g., the first linear polarization) provided from the first slot radiator using the first opening 3231 and the second polarization (the second linear polarization) provided from the second slot radiator using the second opening 3232 (e.g., composite waves) may improve the performance of receiving external radio waves.

According to the eighth example 3204, the conductive area 612 may include a first opening 3241 and a second opening 3242. When viewed from above the first cover 212 (see FIG. 8), the first opening 3241 is, for example, a modification of the first opening 3231 of the seventh example 3203 and may further include a partial opening 3243 extending from one end in the second direction 7002. When viewed from above the first cover 212 (see FIG. 8), the first opening 3241 and the second opening 3242 may be provided (or formed) substantially symmetrically to each other.

According to various embodiments, the first slot radiator (e.g., the first slot radiator 2201 in FIG. 22) and the second slot radiator (e.g., the second slot radiator 2202 in FIG. 22), which are capable of resonating the first opening 3241 and the second opening 3242, respectively, at the time of feeding, may be provided (or formed). When fed, the first slot radiator may generate a first polarization, and the second slot radiator may generate a second polarization.

According to various embodiments, a combination of the first polarization (e.g., the first linear polarization) provided from the first slot radiator using the first opening 3241 and the second polarization (the second linear polarization) provided from the second slot radiator using the second opening 3242 (e.g., composite waves) may improve the performance of receiving external radio waves. According to various embodiments, a substantially circular polarization may be provided (or formed) through the synthesis of the first polarization and the second polarization.

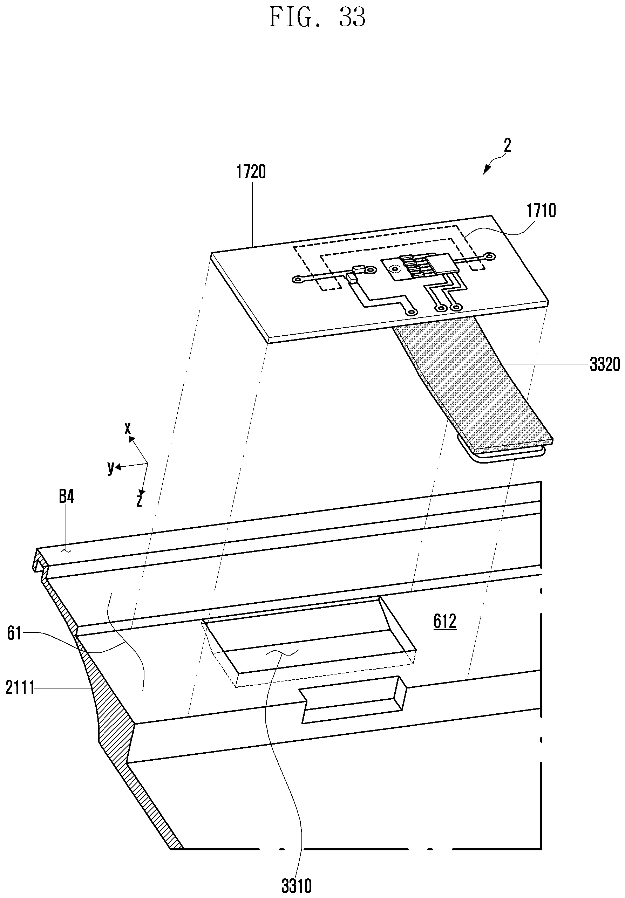

FIG. 33 shows an exploded perspective view of a portion of the foldable electronic device 2 according to various embodiments of the disclosure.

Referring to FIG. 33, the foldable electronic device 2 may include a side surface portion B4, a first bracket 2111, a third printed circuit board 1720, and a flexible printed circuit board 3320.

According to various embodiments, the third printed circuit board 1720 may be implemented to include a slot radiator (or a slot antenna) using an opening (e.g., a slot or a slit) 1710. The opening 1710 may be provided (or formed) by a conductive pattern layer included in the third printed circuit board 1720.

According to various embodiments, a conductive area 612 included in a first portion 61 of the first bracket 2111 may include a recess 3310. When viewed from above the first cover 212 (see FIG. 8), the recess 3310 of the conductive area 612 may be provided (or formed) to overlap the entire opening 1710 of the third printed circuit board 1720.

According to various embodiments, an opening replacing the recess 3310 may be provided (or formed).

According to various embodiments, the recess 3310 (or opening) of the conductive area 612 may increase the separation distance that the conductive area 612 from the slot radiator included in the third printed circuit board 1720, thereby reducing the electromagnetic influence of the conductive area 612 on the slot radiator.

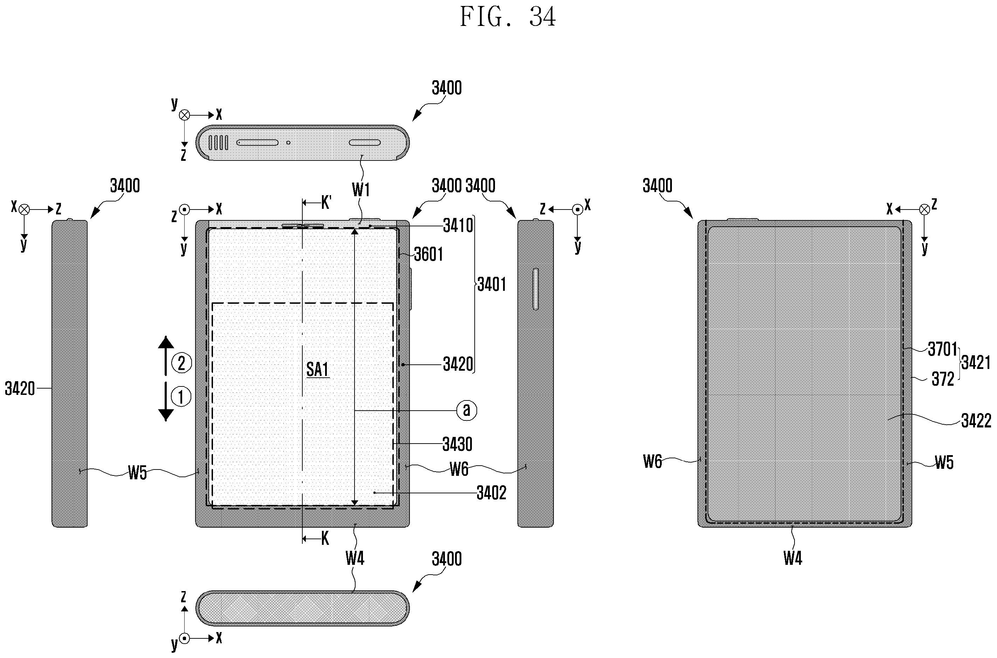

FIG. 34 shows views illustrating the appearances of a slidable electronic device 3400 according to various embodiments of the disclosure in a closed state.

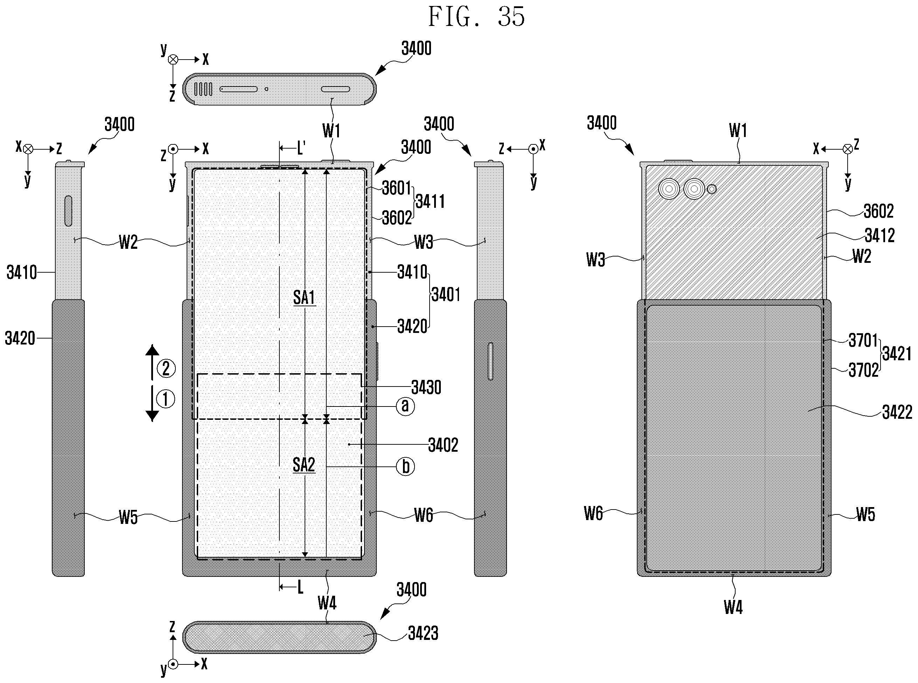

FIG. 35 shows views illustrating the appearances of the slidable electronic device 3400 according to various embodiments of the disclosure in an open state.

In various embodiments of the disclosure, for convenience of description, the direction in which a screen (e.g., an externally visible display area or active area of the flexible display module 3402) is visible (e.g., the +z-axis direction) is referred to as the front of the slidable electronic device 3400, and the opposite direction (e.g., the -z-axis direction) is referred to as the rear of the slidable electronic device 3400.

Referring to FIGS. 34 and 35, the slidable electronic device 3400 may include a slidable housing 3401 and a flexible display module 3402.

According to various embodiments, the slidable housing 3401 may include a first housing 3410 and a second housing 3420. The second housing 3420 may be connected to the first housing 3410 to be slidable relative to the first housing 3410. The sliding of the second housing 3420 relative to the first housing 3410 refers to a change in the relative position between the first housing 3410 and the second housing 3420, and may be interpreted as the sliding of the first housing 3410 relative to the second housing 3420 or as mutual sliding between the first housing 3410 and the second housing 3420.

According to various embodiments, the flexible display module 3402 may include a first area ⓐ and a second area ⓑ extending from the first area ⓐ. The first area ⓐ may be interpreted as a portion of the flexible display module 3402 that is located in the slidable electronic device 3400 to be visually visible from the outside. The second area ⓑ may be interpreted as a portion of the flexible display module 3402 that is located in the slidable electronic device 3400 to be retracted/pulled out (e.g., enter and exit) the inner space of the slidable electronic device 3400. For example, the first area ⓐ may be located in the slidable housing 3401 to be visually visible from the outside, and the second area ⓑ may be retracted or pulled out according to mutual sliding between the first housing 3410 and the second housing 3420. As a specific example to aid understanding of the visual exposure of the first area ⓐ and slide-in/out of the second area ⓑ, a combination of the flexible display module 3402 and a sliding-type structural element (e.g., the slidable housing 3401) is presented, but it is to be construed that combinations of flexible display modules and structural elements in modified or altered forms, in addition to the disclosed examples, are included in the scope of various embodiments of the disclosure.

According to various embodiments, the first area ⓐ of the flexible display module 3402 may be located corresponding to the first housing 3410, and the second area ⓑ of the flexible display module 3402 may be located corresponding to the second housing 3420. The first area ⓐ may be disposed in the first housing 3410 and supported by the first housing 3410. The area ⓐ may be exposed to the outside of the slidable electronic device 3400, and the slidable electronic device 3400 may provide a first screen area SA1 through the first area ⓐ. The second area ⓑ may be supported by the second housing 3420 that is slidable relative to the first housing 3410. When the second housing 3420 slides in the first direction ① (e.g., the +y axis direction) relative to the first housing 3410, at least a portion of the second area ⓑ may be pulled out from the space of the second housing 3420 to the outside (a position on the slidable electronic device 3400 visible from the outside) to be visible. When the second housing 3420 slides in the second direction ② (e.g., the -y-axis direction), which is opposite to the first direction ①, relative to the first housing 3410, at least a portion of the second area ⓑ may be retracted into the space of the second housing 3420 to be hidden. The slidable electronic device 3400 may provide a screen area in which a second screen area (or second display area) SA2 is added to the first screen area (or first display area) SA1 by at least a portion of the second area ⓑ pulled out to the outside. The ratio of the portion of the second area ⓑ that is pulled out to the outside and the size of the screen corresponding thereto may vary depending on the position or distance where the second housing 3420 is slid relative to the first housing 3410.

According to various embodiments, FIG. 34 illustrates the slidable electronic device 3400 in the state in which the screen is not expanded, and FIG. 35 illustrates the slidable electronic device 3400 in the state in which the screen is expanded. The state in which the screen is not expanded is the state in which the second housing 3420 is not moved in the first direction ① relative to the first housing 3410, and may be defined or interpreted as the "closed state" of the slidable electronic device 3400. The state in which the screen is expanded is the state in which the second housing 3420 is moved to its maximum in the first direction ① where it is no longer movable, and may be defined or interpreted as the "open state" of the slidable electronic device 3400.

According to various embodiments, the open state of the slidable electronic device 3400 may include a fully open state (see FIG. 35) or an intermediate state. The intermediate state may refer to a state between the closed state (see FIG. 34) and the fully open state.

According to various embodiments, when the second housing 3420 is moved at least partially in the first direction ① relative to the first housing 3410, this may be defined or interpreted as the "slide-out" of the second housing 3420 or the flexible display module 3402. When the second housing 3420 is moved at least partially in the second direction ②, which is opposite to the first direction ①, relative to the first housing 3410, this may be defined or interpreted as the "slide-in" of the second housing 3420 or the flexible display module 3402.

According to various embodiments, the slidable electronic device 3400, which provides the expandable screen according to mutual sliding between the first housing 3410 and the second housing 3420, may be referred to as "stretchable electronic device" or "rollable electronic device". The flexible display module 3102 (also referred to as a flexible display) may be referred to as other terms such as an "expandable display", a "slidable display", or a "slide-out display".

In the disclosure, "slide-out or slide-in of the second housing 3420" or "sliding of the second housing 3420 relative to the first housing 3410" is described, but without being limited thereto, slide-out or slide-in of the first housing 3410 relative to the second housing 3420, sliding of the first housing 3410 relative to the second housing 3420, mutual sliding between the first housing 3410 and the second housing 3420, or a change in relative position between the first housing 3410 and the second housing 3420 may also be described.

According to various embodiments, in the open state of the slidable electronic device 3400, the screen including the first screen area SA1 provided by the first area ⓐ of the flexible display module 3402 and the second area SA2 provided by the second area ⓑ of the flexible display module 3402 may be provided in a substantially planar form. The direction in which the front surface of the slidable electronic device 3400 is oriented may be the direction in which the planar screen is oriented. The first area ⓐ of the flexible display module 3402 may be disposed on the first housing 3410 to be substantially flat, and the first area ⓐ may provide the planar first screen area SA1 corresponding thereto.

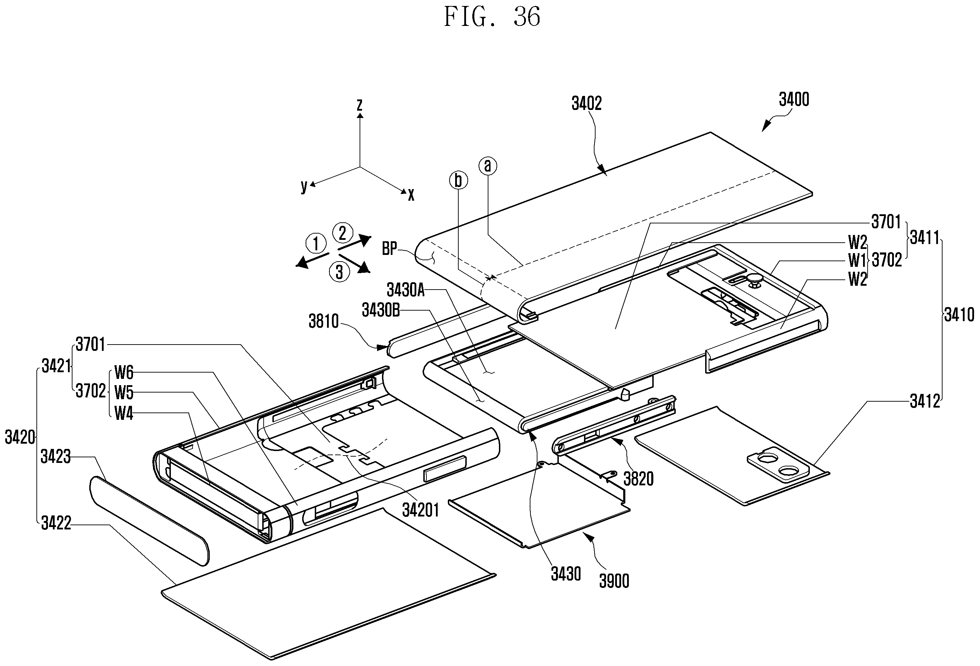

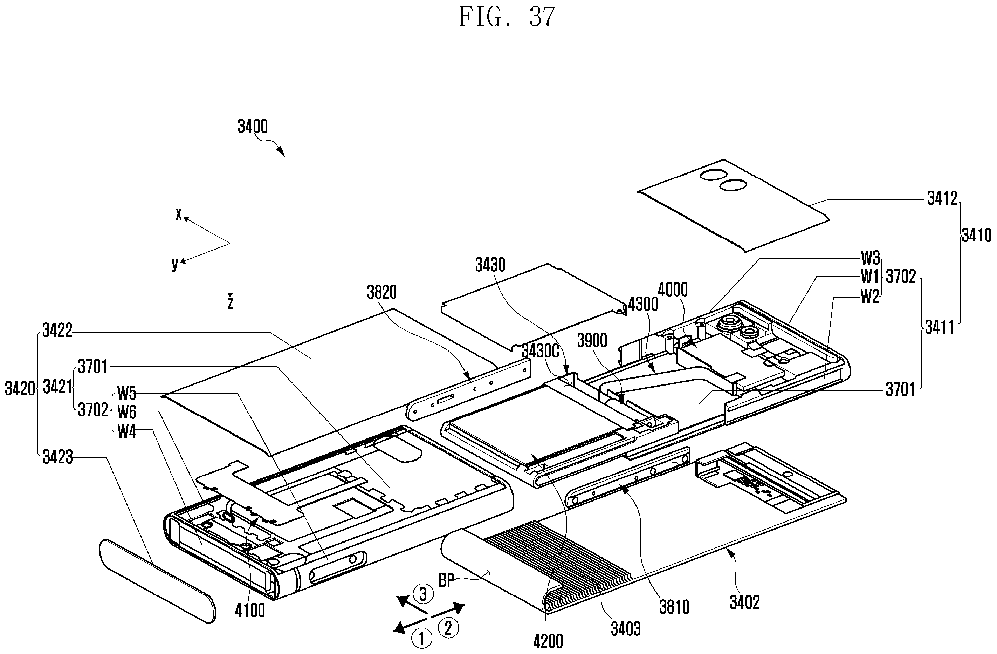

According to various embodiments, the second area ⓑ of the flexible display module 3402 may be disposed to have a bending portion (e.g., the bending portion BP in FIGS. 36 and 37). The bending portion may be a portion of the second area ⓑ that is disposed and maintained in a bent form such that the second area ⓑ changes direction and moves when the second housing 3420 is slid relative to the first housing 3410. The portion of the second area ⓑ that provides the bending portion may vary depending on the position or distance where the second housing 3420 is slid relative to the first housing 3410, but the shape of the bending portion may be provided substantially the same. The size of the portion between the bending portion of the second area ⓑ and the first area ⓐ may increase when the second housing 3420 is slid out, and may decrease when the second housing 3420 is slid in. In the open state of the slidable electronic device 3400, the second screen area SA2 may be provided by the portion between the bending portion of the second area ⓑ and the first area ⓐ. The portion between the bending portion of the second area ⓑ and the first area ⓐ may be disposed substantially flat and smoothly connected to the first area ⓐ without lifting.

According to various embodiments, the first housing 3410 may include a first frame (also referred to as a first frame structure, a first framework, or a first case) 3411, and/or a first cover 3412.

According to various embodiments, the first frame 3411 may be a structural component configured such that multiple electrical components (also referred to as functional components) and/or one or more members are disposed and/or supported thereon.

According to various embodiments, the first frame 3411 may include a first support plate (also referred to as a first support portion, a first support member, or a first bracket) 3601 and a first side member (a first side wall portion, a first bezel, a first side wall bezel, or a first side wall bezel structure) 3602 connected to the first support plate 3601.

According to various embodiments, the first area ⓐ of the flexible display module 3402 may be disposed on the first support plate 3601, and the first support plate 3601 may support the first area ⓐ.

According to various embodiments, the first side member 3602 may include a first side wall W1, a second side wall W2, and/or a third side wall W3. When viewed from above the front surface of the slidable electronic device 3400, the second side wall W2 may extend in the first direction ① from one end of the first side wall 201 (e.g., the slide-out direction), and the third side wall W3 may extend from the other end of the first side wall W1 in the first direction ①. When viewed from above the front surface of the slidable electronic device 3400, the second side wall W2 and the third side wall W3 may be substantially parallel to each other and substantially perpendicular to the first side wall W1.

According to various embodiments, a first cover (also referred to as a first back cover or a first rear surface plate) 3412 may be disposed on or coupled to the first frame 3411 and located on the rear side of the slidable electronic device 3400.

According to various embodiments, the second housing 3420 may include a second frame (also referred to as a second frame structure, a second framework, or a second case) 3421, a second cover 3422, and/or a third cover 3423.

According to various embodiments, the second frame 3421 may be a structural component configured such that multiple electrical components (also referred to as functional components) and/or one or more members are disposed and/or supported thereon.

According to various embodiments, the second frame 3421 may include a second support plate (also referred to as a second support portion, a second support member, or a second bracket) 3701 and a second side member (also referred to as a second side wall portion, a second bezel, a second side wall bezel, or a second side wall bezel structure) 3702 connected to the second support plate 3701. The combination of the second support plate 3701 and the second side member 3702 may provide (or form) a space capable of accommodating the first housing 3410.

According to various embodiments, when viewed from above the rear surface of the slidable electronic device 3400 (e.g., when viewed in the +z-axis direction), the overlapping area of the first support plate 3601 of the first frame 3411 and the second support plate 3701 of the second frame 3421 may increase when the second housing 3420 is slid in and decrease when the second housing 3420 is slid out.

According to various embodiments, the second side member 3702 may include, for example, a fourth side wall W4, a fifth side wall W5, and/or a sixth side wall W6. The fourth side wall W4 may be spaced apart from the first side wall W1 in the first direction ① (e.g., the slide-out direction), and may be substantially parallel to the first side wall W1. When viewed from above the front surface of the slidable electronic device 3400 (e.g., when viewed in the -z-axis direction), the fifth side wall W5 may be located corresponding to the second side wall W2, and may extend from one end of the fourth side wall W4 in the second direction ② (e.g., the slide-in direction). The sixth side wall W6 may be located corresponding to the third side wall W3, and may extend from the other end of the fourth side wall W4 in the second direction ②. When viewed from above the front surface of the slidable electronic device 3400, the fifth side wall W5 and the sixth side wall W6 may be substantially parallel to each other and substantially perpendicular to the fourth side wall W4. The separation distance of the fourth side wall W4 from the first side wall W1 in the first direction ①, the area where the fifth side wall W5 covers the second side wall W2, and the area where the sixth side wall W6 covers the third side wall W3 may increase when the second housing 3420 is slid in and decrease when the second housing 3420 is slid out.

According to various embodiments, the second cover (also referred to as a second rear back cover or a second rear surface plate) 3422 may be disposed on or coupled to the second support frame 3701 and located on the rear side of the slidable electronic device 3400.

According to various embodiments, when viewed from above the rear surface of the slidable electronic device 3400 (e.g., when viewed in the +z-axis direction), the overlapping area of the first cover 3412 (or the first support plate 3601) and the second cover 3422 (or the second support plate 3701) may increase when the second housing 3420 is slid in and decrease when the second housing 3420 is slid out.

According to various embodiments, the third cover (also referred to as a side cover) 3423 may be disposed on or coupled to the fourth side wall W4 of the second side member 3702 and located on a side surface of the slidable electronic device 3400.

According to various embodiments, the third cover 3423 may be omitted, and the second side member 3702 may be provided (or formed) in a form that further includes a portion corresponding to the third cover 3423.

According to various embodiments, in the closed state of the slidable electronic device 3400, a portion of the outer surface of the slidable electronic device 3400 configured with the slidable housing 3401 may be provided by the first side wall W1 and the second housing 3420. In the closed state of the slidable electronic device 3400, the remaining portion of the first housing 3400 may be covered by the second housing 3420 and not exposed to the outside. When the slidable electronic device 3400 is switched from the closed state to the open state, a portion of the outer surface of the slidable electronic device 3400 configured with the slidable housing 3401 may further include an outer surface area provided by the second side wall W2, the third side wall W3, and the first cover 3412.

According to various embodiments, the slidable electronic device 3400 may be implemented such that a portion of the first housing 3410 protrudes in a second direction ② with respect to the second housing 3420 in the closed state.

According to various embodiments, the combination of the first side member 3602 of the first housing 3410 and the second side member 3702 of the second housing 3420 may provide a bezel (or bezel structure, screen bezel, or screen bezel structure) surrounding the screen. For example, when the slidable electronic device 3400 in the closed state is viewed from above the front surface thereof, the combination of the first side wall W1, the fourth side wall W4, the fifth side wall W5, and the sixth bezel W6 may provide a bezel surrounding the screen. For example, when the slidable electronic device 3400 is in the open state is viewed from above the front surface thereof, the combination of the first side wall W1, the second side wall W2, the third side wall W3, the fourth side wall W4, the fifth side wall W5, and the sixth side wall W6 may provide a bezel surrounding the screen.

According to various embodiments, the slidable electronic device 3400 may include a third frame (also referred to as a third frame structure, a third framework, a third case, a third support, or a third support plate) 3430 accommodated in the second housing 3420. The third frame 3430 may be a structural component configured such that multiple electrical components (also referred to as functional components) and/or one or more members are disposed and/or supported thereon.

According to various embodiments, the third frame 3430 may be connected with the second frame 3420 of the second housing 3420. The third frame 3430 may be connected, for example, to the fifth side wall W5 and the sixth side wall W6 of the second side member 3702. The third frame 3430 may overlap the second support plate 3701 of the second frame 3421 when viewed from above the screen of the slidable electronic device 3400.

According to various embodiments, the combination of the second housing 3420 and the third frame 3430 may be slidably connected to the first housing 3410. A structure for mutually stable sliding between the combination of the second housing 3420 and the third frame 3430 and the first housing 3410 (e.g., a sliding structure including a guide rail) may be provided for the first housing 3410 and the second housing 3420, or may be provided for the first housing 3410 and the third frame 3430. The "mutual sliding between the first housing 3410 and the second housing 3420" mentioned herein may be understood as substantially mutual sliding between the combination of the second housing 3420 and the third frame 3430 and the first housing 3410.

According to various embodiments, the first housing 3410 and the third frame 3430 may be mutually slidably connected. In a movable assembly provided by the combination of the mutually slidably connected first frame 3411 and third frame 3430, and a flexible display module 3402 operatively arranged thereon, the second housing 3420 may provide the exterior of the slidable electronic device 3400 together with the first housing 3410. In various embodiments, the first housing 3410 and the second housing 3420 may be defined or interpreted as an "outer housing" that substantially provides the exterior of the slidable electronic device 3400, and the third frame 3430 may be defined or interpreted as an "inner housing" or "third housing" that is located and hidden inside the slidable electronic device 3400 to correspond to the second housing 3420.

According to various embodiments, the third frame 3430 may be defined or interpreted as a portion of the second housing 3420. A portion of the second housing 3420 including the second frame 3421, the second cover 3422, and the third cover 3423 may be referred to as a term, such as an "exterior portion", a "cover portion", or an "exterior housing portion", and the third frame 3430 may be referred to as another term such as a "support", an "inner support", a "support portion", an "inner support portion", a "support member", an "inner support member", a "support structure", or an "inner support structure" accommodated in the second housing 3420.

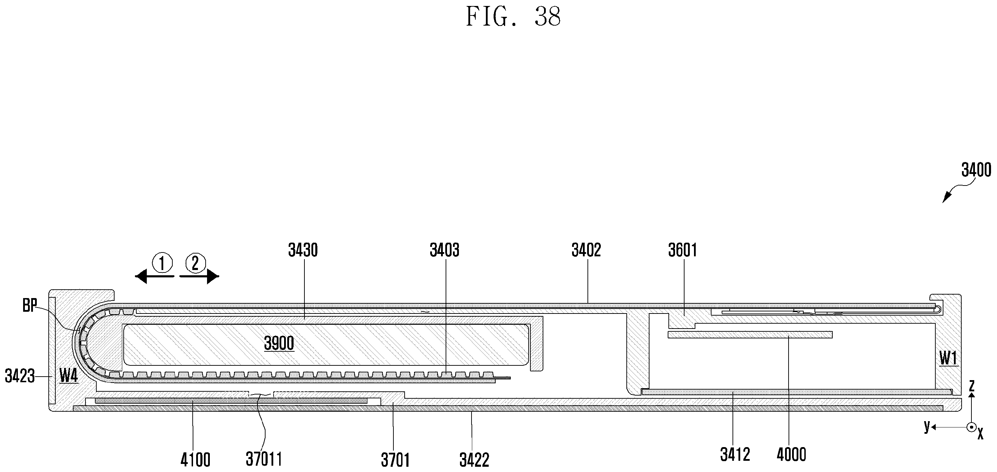

According to various embodiments, the third frame 3430 may include a first support surface (e.g., the first support surface 3430A in FIG. 37) facing the front surface of the slidable electronic device 3400, a second support surface corresponding to the bending portion (e.g., the bending portion (BP) in FIG. 37) of the second area ⓑ) included in the flexible display module 3402 (e.g., the second support surface 3430B in FIG. 37), and a third support surface facing the rear surface of the slidable electronic device 3400 (e.g., the third support surface 3430C in FIG. 38). The first support surface and the second support surface may support the second area ⓑ of the flexible display module 3402. In various embodiments, the third frame 3430 is an element that supports the second area ⓑ of the flexible display module 3402, and may be referred to as various other terms such as a "display support", a "display support member", a "display support structure", a "display support plate", or a "display support board".

According to various embodiments, the first support surface (e.g., the first support surface 3430A in FIG. 37) of the third frame 3430 may support a portion of the second area ⓑ of the flexible display module 3402 that provides the second screen area SA2.

According to various embodiments, the second support surface (e.g., the second support surface 3430B in FIG. 37) of the third frame 3430 may face the bending portion (e.g., the bending portion BP in FIG. 37) of the flexible display module 3402 and may include a curved surface corresponding to the bending portion. The second support surface may support the bending portion of the second area ⓑ.

According to various embodiments, the bending portion (e.g., the bending portion BP in FIG. 37) of the flexible display module 3402 may be located between the second support surface (e.g., the second support surface 3430B in FIG. 37) of the third frame 3430 and the fourth side wall W4 of the second frame 3421. One surface of the fourth side wall W4 facing the bending portion of the flexible display module 3402 may include a curved surface corresponding to the bending portion of the flexible display module 3402. When the second housing 3420 is slid out, at least a portion of the second area ⓑ included in the flexible display module 3402 may be pulled out (e.g., to a position visible from the outside in the slidable electronic device 3400) from the space between the second plate 3701 of the third frame 3430 and the second frame 3421 through the curved space between the second support surface of the third frame 3430 and the fourth side wall W4 of the second frame 3421. When the second housing 3420 is slid in, at least a portion of the second area ⓑ included in the flexible display module 3402 may be retracted into the space between the second support plate 3701 of the third frame 3430 and the second frame 3421 from the outside through the curved space between the second support surface of the third frame 3430 and the fourth side wall W4 of the second frame 3421.

According to various embodiments, at least a portion of the first housing 3410 or at least a portion of the second housing 3420 may contain a metallic material and/or a non-metallic material. The first housing 3410 or the second housing 3420 may include, for example, at least one conductor (or conductive structure) containing a metallic material, and at least one non-conductor (or non-conductive structure) containing a non-metallic material and connected to the at least one conductor. The metallic material contained in the first housing 3410 or the second housing 3420 may vary and include, for example, magnesium, magnesium alloy, aluminum, aluminum alloy, zinc alloy, copper alloy, titanium, amorphous alloy, metal-ceramic composite (e.g., cermet), or stainless steel. The non-metallic material contained in the first housing 3410 or the second housing 3420 may vary and include, for example, ceramic or polymer.

According to various embodiments, at least a portion of at least one conductor included in the first housing 3410 or the second housing 3420 may be electrically connected to a wireless communication circuit (e.g., the wireless communication module 192 in FIG. 1) included in the slidable electronic device 3400 and may be used as an antenna radiating element.

According to various embodiments, a sliding structure of the slidable electronic device 3400 that allows mutual sliding between the first housing 3410 and the second housing 3420 may include a sliding driver (e.g., the sliding driver 3900 in FIG. 37) capable of providing a driving force in response to an electrical signal. The sliding driver may include, for example, a motor and at least one gear operatively connected to the motor. When a signal is generated via an input module or a sensor module included in the slidable electronic device 3400, the sliding driver may provide a driving force that is capable of switching the slidable electronic device 3400 between the closed state and the open state.

According to various embodiments, the slidable electronic device 3400 may include one or more of the components included in the electronic device 101 in FIG. 1.

FIG. 36 shows an exploded perspective view of a slidable electronic device 3400 according to various embodiments of the disclosure. FIG. 37 shows an exploded perspective view of the slidable electronic device according to various embodiments of the disclosure.

Referring to FIGS. 36 and 37, the slidable electronic device 3400 may include a first housing 3410, a second housing 3420, a third frame 3430, a flexible display module 3402, a display support structure 3403, a first guide rail 3810, a second guide rail 3820, a sliding driver 3900, a first printed circuit board 4000, a second printed circuit board 4100, a battery 4200, and/or a flexible printed circuit board 4300.

According to various embodiments, the first housing 3410 may include a first frame 3411 and a first cover 3412. The first frame 3411 may include a first support plate 3601 and a first side member 3602. The first side member 3602 may include a first side wall W1, a second side wall W2, and/or a third side wall W3.

According to various embodiments, the second housing 3420 may include a second frame 3421, a second cover 3422, and/or a third cover 3423. The second frame 3421 may include a second support plate 3701 and a second side member 3702. The second side member 3702 may include a fourth side wall W4, a fifth side wall W5, and/or a sixth side wall W6.

According to various embodiments, the second housing 3420 may have a space 34201 provided by the combination of the second support plate 3701 and the second side member 3702 of the second frame 3421. At least a portion of the first housing 3410 may be inserted into the space 34201 of the second housing 3420.

According to various embodiments, the third frame 3430 may be located in the space 34201 of the second housing 3420 and coupled with the second frame 3421. For example, one side portion of the third frame 3430 may be connected to the fifth side wall W5 of the second housing 3420, and the other side portion of the third frame 3430 may be connected to the sixth side wall W6 of the second housing 3420. The third frame 3430 may be operatively connected to the first housing 3410 to be slidable relative to the first housing 3410.

According to various embodiments, the first area ⓐ of the flexible display module 3402 may be disposed on or coupled to the first support plate 3601 of the first frame 3411. The first area ⓐ may be coupled to the first support plate 3601 via, for example, an adhesive material (or a bonding material).

According to various embodiments, since the first area ⓐ of the flexible display module 3402 is disposed on the first frame 3411, when the second housing 3420 is slid out, the second area ⓑ of the flexible display module 3402 may be pulled out from the space between the first support plate 3601 of the first frame 3411 and the third frame 3430 to the outside (e.g., a location visible from the outside of the slidable electronic device 3400).

According to various embodiments, when viewed from above on the front surface of the slidable electronic device 3400, the area where the first support plate 3601 of the first frame 3411 and the third frame 3430 overlap may decrease when the second housing 3420 is slid out, and may increase when the second housing 3420 is slid in.

According to various embodiments, the third frame 3430 may include a first support surface 3430A and a second support surface 3430B that support the second area ⓑ of the flexible display module 3402.

According to various embodiments, the first support surface 3430A of the third frame 3430 may include a substantially planar area. When viewed from above the front surface of the slidable electronic device 3400, the area where the first support surface 3430A faces the first support plate 3601 of the first housing 3410 may decrease when the second housing 3420 is slid out, and may increase when the second housing 3420 is slid in. In the closed state (see FIG. 34) or the open state (see FIG. 35) of the slidable electronic device 3400, or during the sliding of the second housing 3420 relative to the first housing 3410, at least a portion of the first support surface 3430A that faces and overlaps the first support plate 3601 of the first housing 3410 may support the first support plate 3601 of the first housing 3410. In the open state of the slidable electronic device 3400 or during the sliding of the second housing 3420 relative to the first housing 3410, the first support surface 3430A may support a portion of the second area ⓑ of the flexible display module 3402 that provides the screen. When the second housing 3420 is slid out, the area of the first support surface 3430A, which is not covered by the first support plate 3601 of the first housing 3410 and supports the second area ⓑ of the flexible display module 3402, may increase.

According to various embodiments, the second support surface 3430B of the third frame 3430 may include a curved area (or a curved support area). The second support surface 3430B may be located corresponding to the fourth side wall W4 of the first housing 3410. The second support surface 3430B may support the bending portion BP of the second area ⓑ of the flexible display module 3402. The bending portion BP of the flexible display module 3402 may be a portion of the second area ⓑ that is disposed and maintained in a bent form so that the second area ⓑ changes direction and moves when the second housing 3420 slides relative to the first housing 3410. During the slide-out of the second housing 3420, due to the relative position between the first housing 3410 coupled with the first area ⓐ and the second housing 3420 corresponding to the second area ⓑ, at least a portion of the second area ⓑ may be pulled out from the inside to the outside of the slidable electronic device 3400 through the curved space between the fourth side wall W4 and the second support surface 3430B. During the slide-in of the second housing 3420, due to the relative position between the first housing 3410 coupled with the first area ⓐ and the second housing 3420 corresponding to the second area ⓑ, at least a portion of the second area ⓑ may be retracted to the inside of the slidable electronic device 3400 through the curved space between the fourth side wall W4 and the second support surface 3430B.

According to various embodiments, a rotation member such as a roller or pulley may be provided in place of the portion providing the second support surface 3430B of the third frame 3430. For example, one end and the other end of the rotation shaft associated with the rotation member may be rotatably coupled to either the second frame 3421 or the third frame 3430. In various embodiments, the rotation member may be interpreted as a curved member, a curved support member, or a curved support structure implemented to be rotatable based on friction with the display support structure 3403 (e.g., a multi-bar structure).

According to various embodiments, a display support structure (also referred to as a display support member) 3403 may be disposed on or coupled to the rear surface of the flexible display module 3402. The display support structure 3403 may be located between the second area ⓑ of the flexible display module 3402 and the first support surface 3430A of the third frame 3430 to support the second area ⓑ. When the second housing 3420 is slid out, the area of the first support surface 3430A of the third frame 3430 that is not covered by the first support plate 3601 of the first housing 3410 and supports the display support structure 3403 may increase. When the second housing 3420 is slid in, the area of the first support surface 3430A of the third frame 3430 that is not covered by the first support plate 3601 of the first housing 3410 and supports the display support structure 3403 may decrease. The display support structure 3403 may support the bending portion BP of the flexible display module 3402 between the bending portion BP of the flexible display module 3402 and the second support surface 3430B of the third frame 3430. During the slide-out or slide-in of the second housing 3420, the second housing 3420 and the display support structure 3403 may move while mutually rubbing against each other.

According to various embodiments, the display support structure 3403 may reduce the screen lifting phenomenon caused by the elasticity of the flexible display module 3402, thus contributing to providing a smooth screen. The display support structure 3403 may support the second area ⓑ of the flexible display module 3402 to prevent it from lifting due to the elasticity of the flexible display module 3402, thereby contributing to maintaining the second area ⓑ in a smoothly connected form to the first area ⓐ. The display support structure 3403 may support the second area ⓑ of the flexible display module 3402 to ensure that the second area ⓑ is maintained in a smoothly connected form to the first area ⓐ of the flexible display module 3402. The display support structure 3403 may contribute to smooth movement of the flexible display module 3403 when the second housing 3420 is slid relative to the first housing 3410. The display support structure 3403 may contribute to allowing the second area ⓑ of the flexible display module 3402 to move while maintaining the smoothly connected form the first area ⓐ of the flexible display module 3402 during the sliding of the second housing 3420 relative to the first housing 3410.

According to various embodiments, the display support structure 3403 may include a multi-bar structure (or multiple bars or a multi-bar assembly). The multi-bar structure may include, for example, multiple support bars extending in a third direction ③ (e.g., the +x-axis direction) orthogonal to the first direction ① (e.g., the slide-out direction) and the direction in which the front surface of the slidable electronic device 3400 is oriented. The multi-bar structure may include the form in which the multiple support bars are arranged on the other surface of the display support structure 3403, which is located opposite to the one surface facing the second area ⓑ of the flexible display module 3402. The multi-bar structure may have flexibility due to portions having a relatively small thickness among the multiple support bars. In some embodiments, the multi-bar structure may be provided without a connecting portion between two neighboring support bars. The multi-bar structure may also be referred to as another term, such as a "flexible track". The display support structure 3103 may contain a metallic material, such as stainless steel, and/or a non-metallic material, such as a polymer.

According to various embodiments, the first guide rail 3810 and the second guide rail 3820 may guide the movement of the display support structure 3403. The first guide rail 3810 may include a first rail part on which one side portion of the display support structure 3403 is located and guided. The second guide rail 3820 may include a second rail part on which the other side portion of the display support structure 3403 is located and guided. The first rail part and the second rail part may each include, for example, a recess that provides a pattern corresponding to the movement path of the flexible display module 3402 during the sliding of the second housing 3420 relative to the first housing 3410. The multiple support bars included in the display support structure 3403 may include multiple first pins inserted into the first rail part of the first guide rail 3810, and multiple second pins inserted into the second rail part of the second guide rail 3820.

According to various embodiments, the first guide rail 3810 may be located between the third frame 3430 and the fifth side wall W5 of the second housing 3420, and may be coupled with the third frame 3430 and the fifth side wall W5 using a method such as screw fastening. The second guide rail 3820 may be located between the third frame 3430 and the sixth side wall W6 of the second housing 3420, and may be coupled with the third frame 3430 and the sixth side wall W6 using a method such as screw fastening.

According to various embodiments, the sliding driver 3900 may provide power (or driving force) for sliding the second housing 3420 relative to the first housing 3410.

According to various embodiments, the sliding driver 3900 may include a motor assembly, a circular gear (or round gear) (also referred to as a pinion or a pinion gear), and/or a linear gear (or a linear gear structure) (also referred to as a rack or a rack gear). In various embodiments, the motor assembly may be disposed on the third frame 3430. The motor assembly may provide power for sliding the second housing 3420 relative to the first housing 3410. The circular gear may include a rotation body in the shape of a circular cylinder or a disk, and multiple gear teeth provided along the circumference of the rotation body. The circular gear may be operatively connected to the motor assembly. The linear gear may be a gear structure in which multiple gear teeth are arranged linearly in the first direction ① (e.g., the slide-out direction). The linear gear may be arranged on the first support plate 3601 of the first housing 3410. In various embodiments, the first support plate 3601 may be provided in an integral form that includes the linear gear. The circular gear and the linear gear may be in an engaged state. The circular gear may perform a rotational motion by driving the motor assembly, and the linear gear engaged with the circular gear may perform a linear motion. The rotational motion of the circular gear may be converted into the linear motion of the linear gear, so that mutual sliding between the first housing 3410 coupled with the linear gear and the second housing 3420 coupled with the motor assembly can be provided.

According to various embodiments, when the third frame 3430 is slid relative to the first housing 3410 due to the power provided by the sliding driver 3900, there may be a relative position change between the first guide rail 3810 and one side portion of the display support structure 3403 located on the first guide rail 3810, and a relative position change between the second guide rail 3820 and the other side of the display support structure 3403 located on the second guide rail 3820. Since the flexible display module 3402 is coupled to the first support plate 3601 of the first housing 3410, the relative position change between the first housing 3410 and the third frame 3430, the relative position change between the first guide rail 3810 and the one side portion of the display support structure 3403, and the relative position change between the second guide rail 3820 and the other side portion of the display support structure 3403 may act as a force to move the portion of the display support structure 3403 on which the second area ⓑ of the flexible display module 3402 is disposed.

According to various embodiments, the slidable electronic device 3400 may include a sliding structure for stable and smooth sliding between the first housing 3410 and the second housing 3420. The sliding structure may include, for example, a linear motion (LM) guide interconnecting the first housing 3410 and the second housing 3420. Through the LM guide, the second housing 3420 may be smoothly and seamlessly moved linearly in the first direction ① or the second direction ② relative to the first housing 3410. The LM guide may include, for example, a rail, a block, and/or a bearing. The rail may be in the form of a bar extending from a first end to a second end in the direction in which the second housing 3420 slides relative to the first housing 3410 (e.g., the third direction ③). The rail and the block may be slidably coupled to each other. The bearing may be located between the rail and the block to reduce friction between the rail and the block. The bearing may include, for example, multiple bearing balls and a retainer. In various embodiments, the block may be provided in a form that includes a bearing.

According to various embodiments, the slidable electronic device 2 may include a first LM guide and a second LM guide. A first end of the rail of the first LM guide may be coupled to the second side wall W2 of the first housing 3410, and the block of the first LM guide may be disposed on (or coupled to) one surface of the third frame 3430 corresponding to the first guide rail 3810. The first guide rail 3810 may include a first recess provided corresponding to the rail of the first LM guide. When the third frame 3430 coupled with the block of the first LM guide slides out or slides in relative to the first housing 3410 coupled with the rail, the first recess may ensure that the first guide rail and the rail of the first LM guide do not interfere with each other. A first end of the rail of the second LM guide may be coupled to the third side wall W3 of the first housing 3410, and the block of the second LM guide may be disposed on (or coupled to) one surface of the third frame 3430 corresponding to the second guide rail 3820. The second guide rail 3820 may include a second recess provided corresponding to the rail of the second LM guide. When the third frame 3430 coupled with the block of the second LM guide slides out or slides in relative to the first housing 3410 coupled with the rail, the second recess may ensure that the second guide rail and the rail of the second LM guide do not interfere with each other. Depending on the relative position between the first housing 3410 and the second housing 3420, the extent to which the rail of the first LM guide is located in the first recess of the first guide rail 3810, and the extent to which the rail of the second LM guide is positioned in the second recess of the second guide rail 3820, may vary.

The structure for smooth mutual sliding between the first housing 3410 and the second housing 3420 may be provided in various other ways.

According to various embodiments, the first printed circuit board 4000 may be disposed on the first support plate 3601 between the first support plate 3601 and the first cover 3412.

According to various embodiments, the second printed circuit board 4100 may be disposed on or coupled to the second support plate 3701 between the second support plate 3701 and the second cover 3422.

According to various embodiments, the battery 4200 may be disposed on the third frame 3430.

According to various embodiments, the flexible printed circuit board 4300 may electrically interconnect a first electrical component located in the first housing 3410 (e.g., the first printed circuit board 4000) and a second electrical component located in the second housing 3420 (or the third frame 3430). The flexible printed circuit board 4300 may be disposed to be bent depending on the relative position between the first housing 3410 and the second housing 3420.

According to various embodiments, the flexible printed circuit board 4300 may be utilized as a transmission line in an antenna device (or an antenna system) of the slidable electronic device 3400. The flexible printed circuit board 4300 may transmit an electromagnetic signal (or a wireless signal, an RF signal, or a radiation current).

According to various embodiments, the flexible printed circuit board 4300 may be a flexible RF cable (FRC) or a flexible PCB type RF cable).

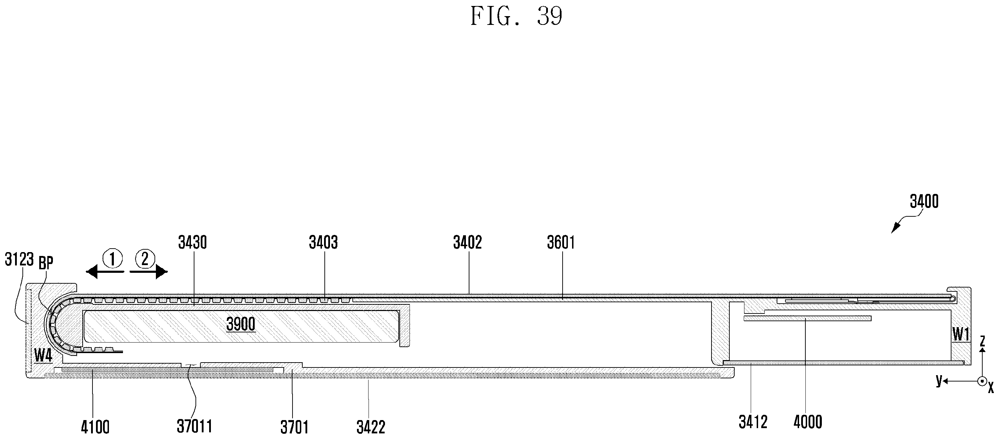

FIG. 38 shows a cross-sectional view of a portion of the slidable electronic device 3400 according to various embodiments of the disclosure taken along line K-K' in FIG. 34. FIG. 39 shows a cross-sectional view of the slidable electronic device 3400 according to various embodiments of the disclosure taken along line L-L' in FIG. 35.

Referring to FIGS. 38 and 39, the slidable electronic device 3400 may include a first side wall W1, a first support plate 3301, a first cover 3412, a fourth side wall W4, a second cover 3422, a third cover 3423, a first printed circuit board 4000, a second printed circuit board 4100, and/or a battery 4200. Descriptions of some components that have the same reference numerals as those illustrated in FIGS. 34, 35, 36, and 37 are omitted.

According to various embodiments, the second support plate 3701 may include an opening 37011 formed in the conductive region. In various embodiments, the slot antenna may be implemented through a combination of the second printed circuit board 4100 and the conductive region including the opening 37011 in a manner substantially identical or at least partially identical to the slot antenna according to the example of FIG. 12, the example of FIG. 13, the example of FIG. 20, the example of FIG. 22, the example of FIG. 23, the example of FIG. 24, or the example of FIG. 25.

According to various embodiments, a wireless communication circuit (e.g., the wireless communication module 192 in FIG. 1) disposed on the first printed circuit board 4000 may provide, via the flexible printed circuit board 4300 (see FIG. 37), an electromagnetic signal (or a wireless signal, an RF signal, or a radiation current) to a slot antenna implemented by the combination of the second printed circuit board 4100 and a conductive area including an opening 37011.

According to various embodiments, a matching circuit (e.g., a switching circuit and/or a frequency adjustment circuit) (e.g., the third matching circuit 1730 in FIG. 20) disposed on the second printed circuit board 4100 may be configured to reduce a difference between the antenna radiation performance of the slot antenna in the closed state of the slidable electronic device 3400 and the antenna radiation performance of the slot antenna in the open state of the slidable electronic device 3400. At least one element may take a different position relative to the slot antenna when the slidable electronic device 3400 is switched between the closed state and the open state. The at least one element may contain a conductive material and a non-conductive material (or a dielectric material). For example, the relative position of the at least one element, such as the flexible display module 3402 or the display support structure 3403, may change with respect to the slot antenna. The matching circuit may be configured to adjust the resonant frequency of the slot antenna when the slidable electronic device 300 is in the closed state or open state of the slidable electronic device 3400, under the control of a processor (e.g., the processor 120 in FIG. 1) or a wireless communication circuit (e.g., the wireless communication module 192 in FIG. 1) disposed on the first printed circuit board 4000.

According to various embodiments of the disclosure, a foldable electronic device 2 includes a first housing 21, a second housing 22, a hinge module (e.g., the hinge module 24), a hinge cover (e.g., the hinge housing 23), and a wireless communication circuit (e.g., the wireless communication module 192). The first housing 21 includes a first rear cover (e.g., the first cover 212) and a first bracket (e.g., the first support plate 2111). The second housing 22 includes a second rear cover (e.g., the second cover 222) and a second bracket (e.g., the second bracket 2211). The hinge module rotatably interconnects the first housing 21 and the second housing 22. The hinge cover is coupled to the hinge module. A first slot (e.g., the opening 1710) is formed in the conductive area 612 of the first bracket. In a direction orthogonal to the first rear cover, at least a portion of the first slot 1710 overlaps the hinge cover in the unfolded state of the foldable electronic device 2. The wireless communication circuit is configured to radiate electromagnetic waves through the first slot formed in the conductive area 612 of the first bracket.

According to various embodiments of the disclosure, the hinge module (e.g., the hinge module 24) includes a first hinge plate (e.g., the first plate 51) and a second hinge plate (e.g., the second plate 52). The first bracket (e.g., the first bracket 2111) may include a recessed portion (e.g., the first recessed portion 610) configured to receive a portion of the first hinge plate when the foldable electronic device 2 is in the unfolded state. The first slot (e.g., the opening 1710) may be formed in the recessed portion.

According to various embodiments of the disclosure, the foldable electronic device 2 may further include a printed circuit board (e.g., the third printed circuit board 1720) disposed in the first portion 61 of the first bracket (e.g., the first bracket 2111). The first portion 61 may be coupled with a hinge module (e.g., the hinge module 24) and may include a recessed portion (e.g., the first recessed portion 610). The printed circuit board may include a first electrical path EL1 crossing the first slot (e.g., the opening 1710). The printed circuit board may include a first terminal T1 electrically connected to the first electrical path EL1. The printed circuit board may include a second terminal T2 electrically connected to a ground area included in the printed circuit board. The first terminal T1 and the second terminal T2 may be located on opposite sides with the first slot interposed therebetween and may be electrically connected to the conductive area 612. The wireless communication circuit (e.g., the wireless communication module 192) may provide a radiation current to the first electrical path EL1.

According to various embodiments of the disclosure, the foldable electronic device 2 may include a first matching circuit 2030 disposed on the first electrical path EL1.

According to various embodiments of the disclosure, the printed circuit board (e.g., the third printed circuit board 1720) may include a third terminal T3, a fourth terminal T4, a second electrical path EL2, a third electrical path EL3, and/or a frequency adjustment circuit (e.g., the third matching circuit 1730). The third terminal T3 and the fourth terminal T4 may be located at opposite sides with the first slot (e.g., the opening 1710) interposed therebetween, and may be electrically connected to a ground area included in the printed circuit board. The frequency adjustment circuit may be disposed on the third electrical path EL3. A signal for controlling the frequency adjustment circuit may be provided to the second electrical path EL2.

According to various embodiments of the disclosure, when the foldable electronic device 2 is switched from the folded state to the unfolded state, the first control signal may be transmitted to the frequency adjustment circuit (e.g., the third matching circuit 1730) through the second electrical path EL2. When the foldable electronic device 2 is switched from the unfolded state to the folded state, the second control signal may be transmitted to the frequency adjustment circuit through the second electrical path.

According to various embodiments of the disclosure, the printed circuit board (e.g., the third printed circuit board 1720) may further include a fifth terminal T5 electrically connected to the conductive area 612, and a fourth electrical path EL4 electrically interconnecting the first electrical path EL1 and the fifth terminal T5. The foldable electronic device 2 may further include a second matching circuit 2040 disposed on the fourth electrical path EL4.

According to various embodiments of the disclosure, the printed circuit board (e.g., the third printed circuit board 1720) may be inserted into a through hole 2500 formed in the first portion 61.

According to various embodiments of the disclosure, the foldable electronic device 2 may further include a non-conductive portion 2010 at least partially disposed in the first slot (e.g., the opening 1710).

According to various embodiments of the disclosure, the foldable electronic device 2 may include a flexible display module (e.g., the first display module 25). The flexible display module may include a first display area 251 disposed on the first housing 21, a second display area 252 disposed on the second housing 22, and a third display area 253 between the first display area 251 and the second display area 252. The first slot (e.g., the opening 1710) may be located between the first back cover (e.g., the first cover 212) and the third display area 253. The second bracket (e.g., the second bracket 2211) may include a second recessed portion 620 configured to receive a portion of the second hinge plate (e.g., the second plate 52) when the foldable electronic device (2) is in the unfolded state. In the folded state of the foldable electronic device 2, the first display area 251 and the second display area 252 may face each other, and the third display area 253 may be bent. In the folded state of the foldable electronic device 2, the first hinge plate (e.g., the first plate 51) and the second hinge plate (e.g., the second plate 52) may face each other with the third display area 253 interposed therebetween. The hinge cover (e.g., the hinge housing 23) may be configured to be partially inserted between the first hinge plate 51 and the first slot when the foldable electronic device 2 is switched from the folded state to the unfolded state.

According to various embodiments of the disclosure, the second bracket (e.g., the second bracket 2211) may include a second portion 62 coupled with the hinge module (e.g., the hinge module 24) and including a second recessed portion 620. The hinge cover (e.g., the hinge housing 23) may be located in the recess formed by the first portion 61 and the second portion 62 in the unfolded state of the foldable electronic device 2.

According to various embodiments of the disclosure, the foldable electronic device 2 may further include a flexible printed circuit board electrically interconnecting a first electrical element accommodated in the first housing 21 and a second electrical element accommodated in the second housing 22. The first portion 61 may include a first hole 401 through which the flexible printed circuit board passes. The second portion 62 may include a second hole 402 through which the flexible printed circuit board passes.

According to various embodiments of the disclosure, a second slot may be formed in the conductive area 612 of the first bracket (e.g., the first bracket 2111). The wireless communication circuit 192 may be configured to transmit and/or receive a signal through the first slot and the second slot.

According to various embodiments of the disclosure, the first slot and the second slot may be formed in the same pattern extending from one end to the other end.

According to various embodiments of the disclosure, at the time of feeding from the wireless communication circuit (e.g., the wireless communication module 192), a first polarized wave is radiated through the first slot, and a second polarized wave different from the first polarized wave is radiated through the second slot.

Embodiments disclosed in the disclosure and drawings are merely presented as specific examples to easily describe technical content and aid understanding of the disclosure, and are not intended to limit the scope of the disclosure. Accordingly, the scope of the various embodiments of the disclosure should be construed as including changes or modifications of the embodiments in addition to the embodiments disclosed herein. In addition, it will be appreciated that any embodiment(s) described herein may be used with any other embodiment(s) described herein. In particular, it is emphasized that although the disclosure is presented in a form that provides a number of embodiments, some of the embodiments are linked only by reference to the same drawing or drawings. The disclosure is to be understood to include all of the combinations of two (or more) embodiments unless there is an obvious contradiction therebetween. That is, when features are presented as optional in the disclosure, all of the combinations of those optional features are included in the disclosure.

## Claims

1. A foldable electronic device (2) comprising:
a first housing (21) comprising a first rear cover (212) and a first bracket (2111);
a second housing (22) comprising a second rear cover (222) and a second bracket (2211);
a hinge module (24) rotatably interconnecting the first housing (21) and the second housing (22);
a hinge cover (23) coupled to the hinge module (24); and
a wireless communication circuit (192),
wherein a first slot (1710) is formed in a conductive area (612) of the first bracket (2111),
wherein, in a direction orthogonal to the first rear cover (212), at least a portion of the first slot (1710) overlaps the hinge cover (23) in an unfolded state of the foldable electronic device (2), and
wherein the wireless communication circuit (192) is configured to transmit, receive, or transmit and receive a signal of a predetermined frequency band through the first slot (1710) formed in the conductive area (612) of the first bracket (2111).

2. The foldable electronic device of claim 1, wherein the hinge module (24) comprises a first hinge plate (51) and a second hinge plate (52),
wherein the first bracket (2111) comprises a recessed portion (610) configured to receive a portion of the first hinge plate (51) in a state in which the foldable electronic device (2) is in the unfolded state, and
wherein the first slot (1710) is formed in the recessed portion (610).

3. The foldable electronic device of claim 2, further comprising:
a printed circuit board (1720) disposed on a first portion (61) of the first bracket (2111), wherein the first portion (61) of the first bracket (2111) is coupled to the hinge module (24) and comprises the recessed portion (610),
wherein the printed circuit board (1720) comprises:
a first electrical path (EL1) extending across the first slot (1710);
a first terminal (T1) electrically connected to the first electrical path (EL1); and
a second terminal (T2) electrically connected to a ground area of the printed circuit board (1720),
wherein the first terminal (T1) and the second terminal (T2) are located on opposite sides of the printed circuit board (1720) such that the first slot (1710) is interposed therebetween, and electrically connected to the conductive area (612), and
wherein the wireless communication circuit (192) is configured to provided a radiation current to the first electrical path (EL1).

4. The foldable electronic device of claim 3, further comprising:
a first matching circuit (2030) disposed on the first electrical path (EL1).

5. The foldable electronic device of claim 3 or 4, wherein the printed circuit board (1720) further comprises:
at least one processor;
a second electrical path (EL2) electrically connecting the at least one processor to a frequency adjustment circuit;
a third terminal (T3) and a fourth terminal (T4) located on opposite sides of the printed circuit board (1720) such that the first slot (1710) is interposed therebetween, and electrically connected to the ground area included in the printed circuit board (1720); and
a third electrical path (EL3) extending across the first slot (1710) and electrically connected to the third terminal (T3) and the fourth terminal (T4),
wherein the third terminal (T3) and the fourth terminal (T4) are electrically connected to the conductive area (612),
wherein the frequency adjustment circuit (1730) is on the third electrical path (EL3), and
wherein the at least one processor is configured to transmit a digital signal to the second electrical path to control the frequency adjustment circuit (1730).

6. The foldable electronic device of claim 5, wherein, in a state in which the foldable electronic device (2) is switched from the folded state to an unfolded state, the least one processor is configured to transmit a first control signal to the frequency adjustment circuit (1730) via the second electrical path (EL2), and
wherein, in a state in which the foldable electronic device (2) is switched from the unfolded state to the folded state, the at least one processor is configured to transmit a second control signal the frequency adjustment circuit (1730) via the second electrical path (EL2).

7. The foldable electronic device of one of claims 3 to 6, wherein the printed circuit board (1720) comprises a fifth terminal (T5) electrically connected to the conductive area (612), and a fourth electrical path (EL4) electrically interconnecting the first electrical path (EL1) and the fifth terminal (T5), and
wherein the foldable electronic device (2) further comprises a second matching circuit (2040) disposed on the fourth electrical path (EL4).

8. The foldable electronic device of one of claims 3 to 7, wherein the printed circuit board (1720) is inserted into a through hole (2500) of the first portion (61) of the first bracket (2111).

9. The foldable electronic device of one of claims 3 to 8, further comprising:
a non-conductive portion (2010) at least partially disposed in the first slot (1710).

10. The foldable electronic device of one of claims 2 to 9, further comprising:
a flexible display module (25) comprising a first display area (251) disposed on the first housing (21), a second display area (252) disposed on the second housing (22), and a third display area (253) between the first display area (251) and the second display area (252),
wherein the first slot (1710) is located between the first rear cover (212) and the third display area (253),
wherein the second bracket (2211) comprises a second recessed portion (620) configured to receive a portion of the second hinge plate (52) in a state in which the foldable electronic device (2) is in the unfolded state,
wherein, in a folded state of the foldable electronic device (2), the first display area (251) and the second display area (252) face each other, and the third display area (253) is bent, and the first hinge plate (51) and the second hinge plate (52) face each other with the third display area interposed therebetween, and
wherein, in a state in which the foldable electronic device (2) is switched from the folded state to the unfolded state, a portion of the hinge cover (23) is inserted between the first hinge plate (51) and the first slot (1710).

11. The foldable electronic device of claim 10, wherein the second bracket (2211) comprises a second portion (62) coupled to the hinge module (24) and comprising the second recessed portion (620), and
wherein the hinge cover (23) is located in a recess formed by the first portion (61) and the second portion (62) in the unfolded state of the foldable electronic device (2).

12. The foldable electronic device of claim 11, further comprising:
a flexible printed circuit board electrically interconnecting a first electrical element accommodated in the first housing (21) and a second electrical element accommodated in the second housing (22),
wherein the first portion (61) comprises a first hole (401) and the second portion (62) comprises a second hole (402), and
wherein the flexible printed circuit board passes through the first hole (401) and the second hole (402).

13. The foldable electronic device of one of claims 1 to 12, wherein a second slot is formed in the conductive area (612) of the first bracket (2111), and
wherein the wireless communication circuit (192) is configured to transmit, receive, or transmit and receive the signal through the first slot and the second slot.

14. The foldable electronic device of claim 13, wherein the first slot comprise a pattern extending from one end of the first slot to another end of the first slot, and
wherein the second slot comprises a same pattern as the first slot extending from one end of the second slot to another end of the second slot.

15. The foldable electronic device of claim 13, wherein in a state of which the signal is transmitted, received, or transmitted and received by the wireless communication circuit via a feed line, the wireless communication circuit is configured to:
radiate a first polarized wave through the first slot, and
radiate a second polarized wave different from the first polarized wave through the second slot.
